# EUROPEAN PATENT SPECIFICATION

(11) **EP 3 541 890 B1**
(45) Date of publication and mention of the grant of the patent: **28.10.2020**
(21) Application number: 17794992.2
(22) Date of filing: 14.11.2017
(51) Int. Cl.: C09K 11/06, C07F 9/6571, C07F 9/6584, C07D 401/04, C09B 57/00, C09B 57/10, H01L 51/00, H01L 51/50, C09B 1/00

(54) **MATERIALS FOR ORGANIC ELECTROLUMINESCENT DEVICES**
MATERIALIEN FÜR ORGANISCHE ELEKTROLUMINESZENTE VORRICHTUNGEN
MATÉRIAUX POUR DISPOSITIFS ÉLECTROLUMINESCENTS ORGANIQUES

(30) Priority: 17.11.2016 EP 16199298
(43) Date of publication of application: 25.09.2019
(73) Proprietor: Merck Patent GmbH, 64293 Darmstadt (DE)
(72) Inventor: PARHAM, Amir, 60486 Frankfurt am Main (DE); JOOSTEN, Dominik, 60487 Frankfurt am Main (DE); LUDEMANN, Aurélie, 60322 Frankfurt am Main (DE); GROSSMANN, Tobias, 64297 Darmstadt (DE); KROEBER, Jonas, 60311 Frankfurt am Main (DE); STOESSEL, Philipp, 60389 Frankfurt am Main (DE)
(86) International application number: PCT/EP2017/079129
(87) International publication number: WO 2018/091435

(56) References cited:
- WO-A1-2010/054730
- WO-A1-2012/013271
- US-A1- 2012 326 141

## Description

The present invention relates to a compound of the formula (1), to the use of the compound in an electronic device, and to an electronic device comprising a compound of the formula (1).

The structure of organic electroluminescent devices (OLEDs) in which organic semiconductors are employed as functional materials is described, for example in US 4539507. The emitting materials employed here are increasingly organometallic complexes which exhibit phosphorescence instead of fluorescence. For quantum-mechanical reasons, an up to fourfold increase in efficiency is possible using organometallic compounds as phosphorescence emitters. In general, however, there is still a need for improvement in the case of OLEDs, in particular also in the case of OLEDs which exhibit triplet emission (phosphorescence), for example with respect to efficiency, operating voltage and lifetime.

The properties of phosphorescent OLEDs are not only determined by the triplet emitters employed, but also by the other materials used together with triplet emitters in OLEDs, such as matrix materials. Improvements in these materials and their charge-transport properties can thus also result in significant improvements in the OLED properties.

In accordance with the prior art, phosphine oxides (for example in accordance with WO 05/003253) or diazaphosphole derivatives (for example in accordance with WO 2010/054730), inter alia, are used as matrix materials for phosphorescent emitters.

Further improvements are desirable here, in particular with respect to the efficiency, the lifetime and the film formation of the materials.

The object of the present invention is the provision of compounds, which are suitable for use in an OLED, in particular as matrix material for phosphorescent emitters. A further object of the present invention is to provide further organic semiconductors for organic electroluminescent devices to provide the person skilled in the art with a greater possible choice of materials for the production of OLEDs.

Surprisingly, it has been found that certain compounds described in greater detail below achieve this object, are highly suitable for use in OLEDs and result in improvements in the organic electroluminescent device. The improvements here relate, in particular, to the lifetime and/or the efficiency. In addition, these compounds have improved film-formation properties in the case of processing from solution, since they simultaneously have a high glass transition temperature and high solubilities, which enables processing from solution and subsequent drying by heating.The present invention therefore relates to these compounds and to electronic devices, in particular organic electroluminescent devices, which comprise compounds of this type.

The present invention relates to a compound of the formula (1): 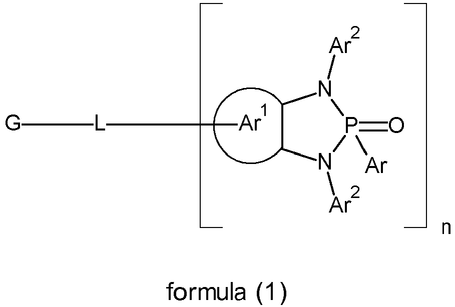 where:
L is a single bond or an aromatic or heteroaromatic ring system having 5 to 30 aromatic ring atoms, which may be substituted by one or more radicals R;
G is an aromatic or heteroaromatic ring system having 5 to 60 aromatic ring atoms, which may be substituted by one or more radicals R; or G is a group -N(Ar³)₂;
Ar, Ar² are, on each occurrence, identically or differently, an aromatic or heteroaromatic ring system having 5 to 60 aromatic ring atoms, which may be substituted by one or more radicals R;
Ar¹ is an aryl or heteroaryl group having 6 to 10 aromatic ring atoms, which may be substituted by one or more radicals R;
Ar³ is, on each occurrence, identically or differently, an aromatic or heteroaromatic ring system having 5 to 60 aromatic ring atoms, which may be substituted by one or more radicals R; where two groups Ar³ present in a group -N(Ar³)₂ are allowed to be connected via a single bond or a divalent bridge;
R is on each occurrence, identically or differently, H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R¹, where one or more, preferably non-adjacent CH₂ groups may be replaced by (R¹)C=C(R¹), C≡C, Si(R¹)₂, Ge(R¹)₂, Sn(R¹)₂, C=O, C=S, C=Se, P(=O)(R¹), SO, SO₂, N(R¹), O, S or CON(R¹) and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, where optionally two adjacent substituents R can form a mono- or polycyclic, aliphatic, aromatic or heteroaromatic ring system with one another;
Ar⁴ is an aromatic or heteroaromatic ring system having 5 to 60 aromatic ring atoms, which may be substituted by one or more radicals R¹;
R¹ is on each occurrence, identically or differently, H, D, F, Cl, Br, I, CHO, N(R²)₂, C(=O)R², P(=O)(R²)₂, S(=O)R², S(=O)₂R², (R²)C=C(R²)₂, CN, NO₂, Si(R²)₃, B(OR²)₂, B(R²)₂, B(N(R²)₂)₂, OSO₂R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R², where one or more, preferably non-adjacent CH₂ groups may be replaced by (R²)C=C(R²), C≡C, Si(R²)₂, Ge(R²)₂, Sn(R²)₂, C=O, C=S, C=Se, P(=O)(R²), SO, SO₂, N(R²), O, S or CON(R²) and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², where optionally two adjacent substituents R¹ can form a mono- or polycyclic, aliphatic, aromatic or heteroaromatic ring system with one another;
R² is on each occurrence, identically or differently, H, D, F, Cl, Br, I, CHO, CN, NO₂, a straight-chain alkyl, alkoxy or thioalkoxy group having 1 to 20 C atoms or a straight-chain alkenyl or alkynyl group having 2 to 20 C atoms or a branched or cyclic alkyl, alkenyl, alkynyl, alkoxy or thioalkoxy group having 3 to 20 C atoms, or an aromatic or heteroaromatic ring system having 5 to 30 aromatic ring atoms or an aryloxy or heteroaryloxy group having 5 to 30 aromatic ring atoms; where optionally two adjacent substituents R² can form a mono- or polycyclic, aliphatic, aromatic or heteroaromatic ring system with one another;
n is 1, 2 or 3;
with the proviso that, if L is a single bond, then G does not stand for benzene.

Adjacent substituents in the sense of the present invention are substituents which are bonded to carbon atoms which are linked directly to one another or which are bonded to the same carbon atom.

Furthermore, the following definitions of chemical groups apply for the purposes of the present application:
An aryl group in the sense of this invention contains 6 to 60 aromatic ring atoms; a heteroaryl group in the sense of this invention contains 5 to 60 aromatic ring atoms, at least one of which is a heteroatom. The hetero atoms are preferably selected from N, O and S. This represents the basic definition. If other preferences are indicated in the description of the present invention, for example with respect to the number of aromatic ring atoms or the heteroatoms present, these apply.

An aryl group or heteroaryl group here is taken to mean either a simple aromatic ring, i.e. benzene, or a simple heteroaromatic ring, for example pyridine, pyrimidine or thiophene, or a condensed (annellated) aromatic or heteroaromatic polycycle, for example naphthalene, phenanthrene, quino line or carbazole. A condensed (annellated) aromatic or heteroaromatic polycycle in the sense of the present application consists of two or more simple aromatic or heteroaromatic rings condensed with one another.

An aryl or heteroaryl group, which may in each case be substituted by the above-mentioned radicals and which may be linked to the aromatic or heteroaromatic ring system via any desired positions, is taken to mean, in particular, groups derived from benzene, naphthalene, anthracene, phenanthrene, pyrene, dihydropyrene, chrysene, perylene, fluoranthene, benzanthracene, benzophenanthrene, tetracene, pentacene, benzopyrene, furan, benzofuran, isobenzofuran, dibenzofuran, thiophene, benzothiophene, isobenzothiophene, dibenzothiophene, pyrrole, indole, isoindole, carbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, pyrazine, phenazine, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole.

An aryloxy group in accordance with the definition of the present invention is taken to mean an aryl group, as defined above, which is bonded via an oxygen atom. An analogous definition applies to heteroaryloxy groups.
An aromatic ring system in the sense of this invention contains 6 to 60 C atoms in the ring system. A heteroaromatic ring system in the sense of this invention contains 5 to 60 aromatic ring atoms, at least one of which is a heteroatom. The heteroatoms are preferably selected from N, O and/or S. An aromatic or heteroaromatic ring system in the sense of this invention is intended to be taken to mean a system which does not necessarily contain only aryl or heteroaryl groups, but instead in which, in addition, a plurality of aryl or heteroaryl groups may be connected by a non-aromatic unit (preferably less than 10% of the atoms other than H), such as, for example, an sp³-hybridised C, Si, N or O atom, an sp²-hybridised C or N atom or an sp-hybridised C atom. Thus, for example, systems such as 9,9'-spirobifluorene, 9,9'-diarylfluorene, triarylamine, diaryl ether, stilbene, etc., are also intended to be taken to be aromatic ring systems in the sense of this invention, as are systems in which two or more aryl groups are connected, for example, by a linear or cyclic alkyl, alkenyl or alkynyl group or by a silyl group. Furthermore, systems in which two or more aryl or heteroaryl groups are linked to one another via single bonds are also taken to be aromatic or heteroaromatic ring systems in the sense of this invention, such as, for example, systems such as biphenyl, terphenyl or diphenyltriazine.

An aromatic or heteroaromatic ring system having 5 - 60 aromatic ring atoms, which may in each case also be substituted by radicals as defined above and which may be linked to the aromatic or heteroaromatic group via any desired positions, is taken to mean, in particular, groups derived from benzene, naphthalene, anthracene, benzanthracene, phenanthrene, benzophenanthrene, pyrene, chrysene, perylene, fluoranthene, naphthacene, pentacene, benzopyrene, biphenyl, biphenylene, terphenyl, terphenylene, quaterphenyl, fluorene, spirobifluorene, dihydrophenanthrene, dihydropyrene, tetrahydropyrene, cis- or trans-indenofluorene, truxene, isotruxene, spirotruxene, spiroisotruxene, furan, benzofuran, isobenzofuran, dibenzofuran, thiophene, benzothiophene, isobenzothiophene, dibenzothiophene, pyrrole, indole, isoindole, carbazole, indolocarbazole, indenocarbazole, pyridine, quinoline, isoquinoline, acridine, phenanthridine, benzo-5,6-quinoline, benzo-6,7-quinoline, benzo-7,8-quinoline, phenothiazine, phenoxazine, pyrazole, indazole, imidazole, benzimidazole, naphthimidazole, phenanthrimidazole, pyridimidazole, pyrazinimidazole, quinoxalinimidazole, oxazole, benzoxazole, naphthoxazole, anthroxazole, phenanthroxazole, isoxazole, 1,2-thiazole, 1,3-thiazole, benzothiazole, pyridazine, benzopyridazine, pyrimidine, benzopyrimidine, quinoxaline, 1,5-diazaanthracene, 2,7-diazapyrene, 2,3-diazapyrene, 1,6-diazapyrene, 1,8-diazapyrene, 4,5-diazapyrene, 4,5,9,10-tetraazaperylene, pyrazine, phenazine, phenoxazine, phenothiazine, fluorubin, naphthyridine, azacarbazole, benzocarboline, phenanthroline, 1,2,3-triazole, 1,2,4-triazole, benzotriazole, 1,2,3-oxadiazole, 1,2,4-oxadiazole, 1,2,5-oxadiazole, 1,3,4-oxadiazole, 1,2,3-thiadiazole, 1,2,4-thiadiazole, 1,2,5-thiadiazole, 1,3,4-thiadiazole, 1,3,5-triazine, 1,2,4-triazine, 1,2,3-triazine, tetrazole, 1,2,4,5-tetrazine, 1,2,3,4-tetrazine, 1,2,3,5-tetrazine, purine, pteridine, indolizine and benzothiadiazole, or combinations of these groups.

For the purposes of the present invention, a straight-chain alkyl group having 1 to 40 C atoms or a branched or cyclic alkyl group having 3 to 40 C atoms or an alkenyl or alkynyl group having 2 to 40 C atoms, in which, in addition, individual H atoms or CH₂ groups may be substituted by the groups mentioned above under the definition of the radicals, is preferably taken to mean the radicals methyl, ethyl, n-propyl, i-propyl, n-butyl, i-butyl, s-butyl, t-butyl, 2-methylbutyl, n-pentyl, s-pentyl, cyclopentyl, neopentyl, n-hexyl, cyclohexyl, neohexyl, n-heptyl, cycloheptyl, n-octyl, cyclooctyl, 2-ethylhexyl, trifluoromethyl, pentafluoroethyl, 2,2,2-trifluoroethyl, ethenyl, propenyl, butenyl, pentenyl, cyclopentenyl, hexenyl, cyclohexenyl, heptenyl, cycloheptenyl, octenyl, cyclooctenyl, ethynyl, propynyl, butynyl, pentynyl, hexynyl or octynyl. An alkoxy or thioalkyl group having 1 to 40 C atoms is preferably taken to mean methoxy, trifluoromethoxy, ethoxy, n-propoxy, i-propoxy, n-butoxy, i-butoxy, s-butoxy, t-butoxy, n-pentoxy, s-pentoxy, 2-methylbutoxy, n-hexoxy, cyclohexyloxy, n-heptoxy, cycloheptyloxy, n-octyloxy, cyclooctyloxy, 2-ethylhexyloxy, pentafluoroethoxy, 2,2,2-trifluoroethoxy, methylthio, ethylthio, n-propylthio, i-propylthio, n-butylthio, i-butylthio, s-butylthio, t-butylthio, n-pentylthio, s-pentylthio, n-hexylthio, cyclohexylthio, n-heptylthio, cycloheptylthio, n-octylthio, cyclooctylthio, 2-ethylhexylthio, trifluoromethylthio, pentafluoroethylthio, 2,2,2-trifluoroethylthio, ethenylthio, propenylthio, butenylthio, pentenylthio, cyclopentenylthio, hexenylthio, cyclohexenylthio, heptenylthio, cycloheptenylthio, octenylthio, cyclooctenylthio, ethynylthio, propynylthio, butynylthio, pentynylthio, hexynylthio, heptynylthio or octynylthio.

The formulation that two radicals may form a ring with one another is, for the purposes of the present application, intended to be taken to mean, inter alia, that the two radicals are linked to one another by a chemical bond. This is illustrated by the following schemes:

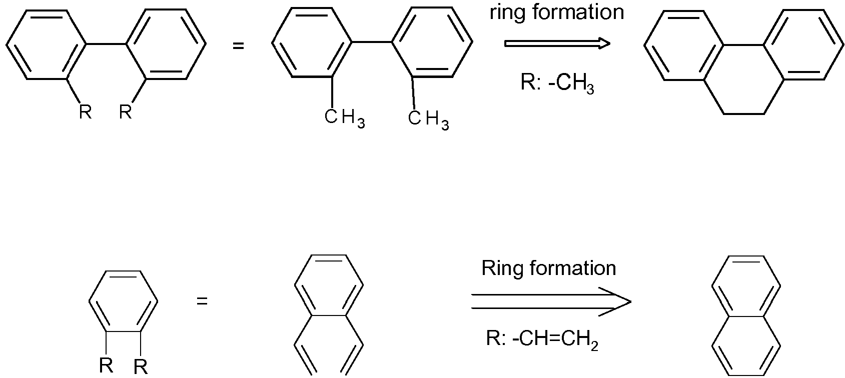

Furthermore, the above-mentioned formulation is also intended to be taken to mean that, in the case where one of the two radicals represents hydrogen, the second radical is bonded at the position to which the hydrogen atom was bonded, with formation of a ring. This is illustrated by the following scheme:

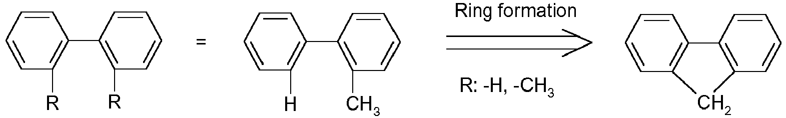

In accordance with a preferred embodiment of the invention, the group Ar¹ is a benzene and the compounds of formula (1) are selected from the compounds of the formula (1-1), 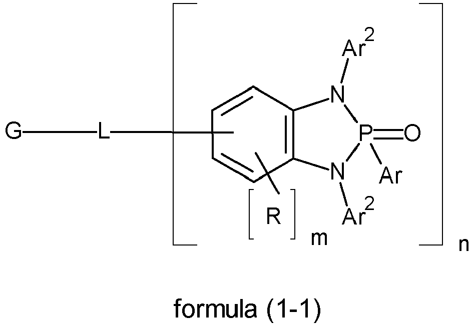 where m is 0, 1, 2 or 3 and where the other symbols and indices used have the same meanings as above.

In accordance with a preferred embodiment, n is 1 or 2. More preferably, n is 1.

The group L is preferably a single bond or an aromatic or heteroaromatic ring system having 6 to 24 aromatic ring atoms, preferably 6 to 18 aromatic ring atoms, very preferably 6 to 13 aromatic ring atoms. The group L is very preferably a single bond or an aromatic or heteroaromatic ring system selected from benzene, naphthalene, biphenyl, terphenyl, fluorene, spirobifluorene, dibenzofuran, dibenzothiophene, carbazole or benzocarbazole, each of which may be substituted by one or more radicals R. The group L particularly preferably a single bond, a benzene, a fluorene, a dibenzofuran, a dibenzothiophene or a carbazole, each of which may be substituted by one or more radicals R. The group L is very particularly preferably a single bond, a benzene or a carbazole, each of which may be substituted by one or more radicals R.

Examples of suitable groups L are the groups of formulae (L-1) to (L-16) below: 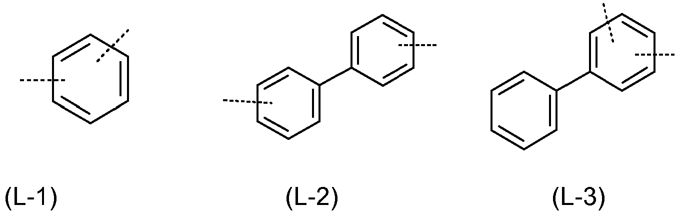 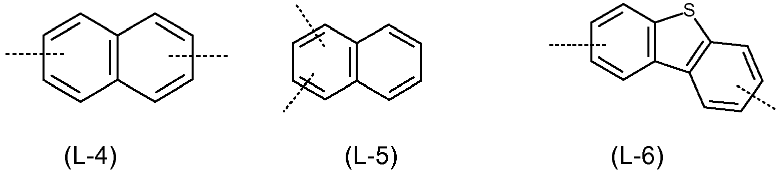 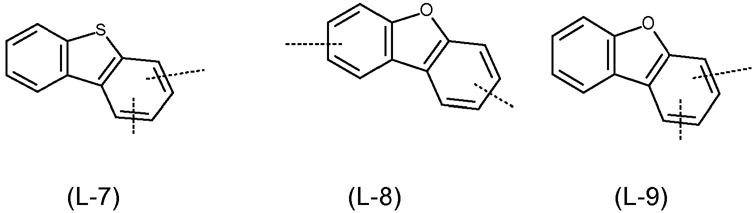 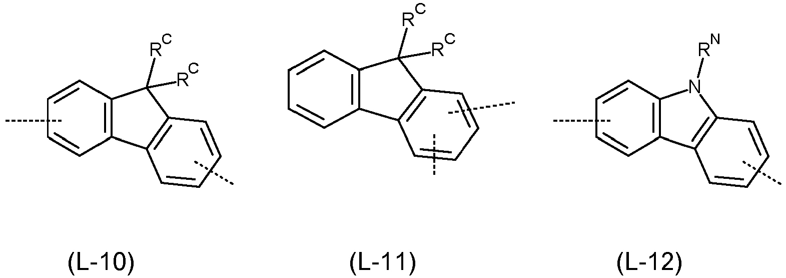 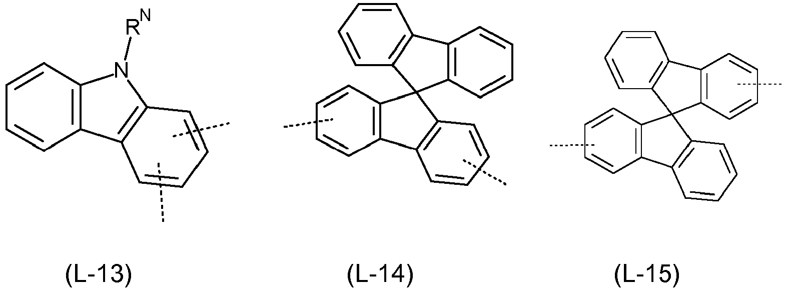 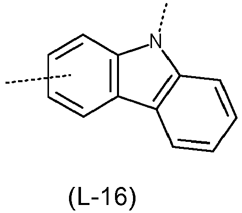 where the dashed bonds indicate the bonds to the group G and to Ar¹, where the groups (L-1) to (L-16) may be substituted at each free position by a group R as defined above and where:
R^{N}, R^{C} are on each occurrence, identically or differently, H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R¹, where one or more, preferably non-adjacent CH₂ groups may be replaced by (R¹)C=C(R¹), C≡C, Si(R¹)₂, Ge(R¹)₂, Sn(R¹)₂, C=O, C=S, C=Se, P(=O)(R¹), SO, SO₂, N(R¹), O, S or CON(R¹) and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, where optionally two adjacent substituents R^{C} can form a mono- or polycyclic, aliphatic, aromatic or heteroaromatic ring system with one another.

Examples of very suitable groups L are the groups of formulae (L-17) to (L-61) below: 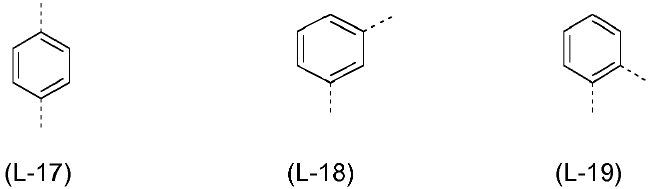 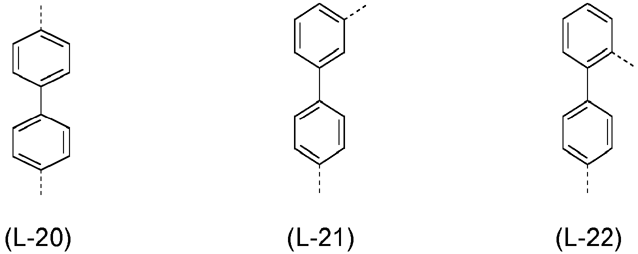 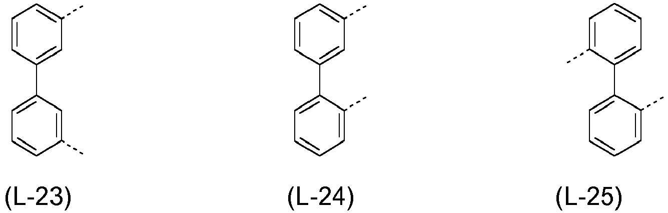 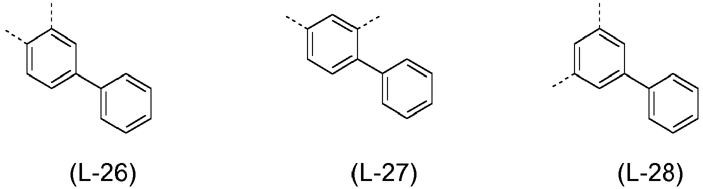 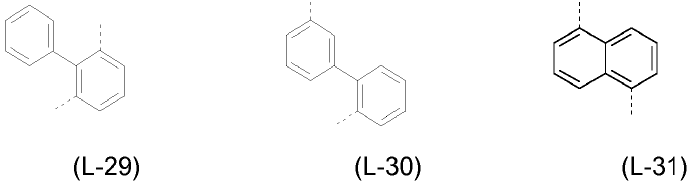 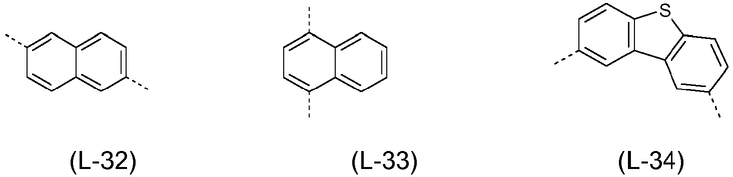 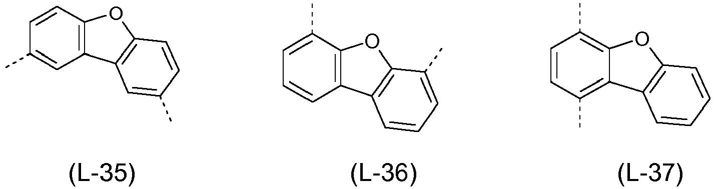 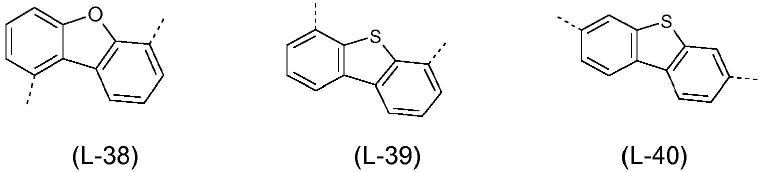 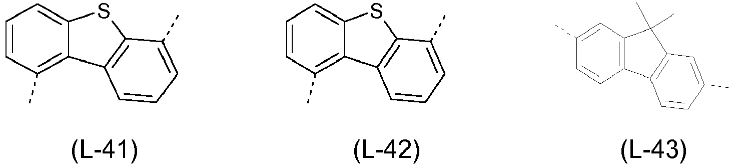 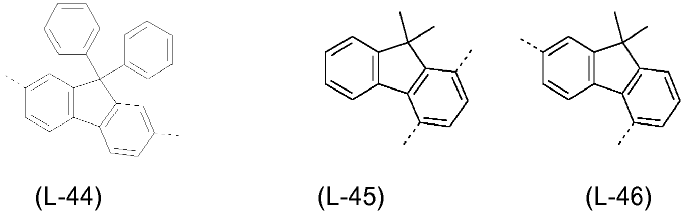 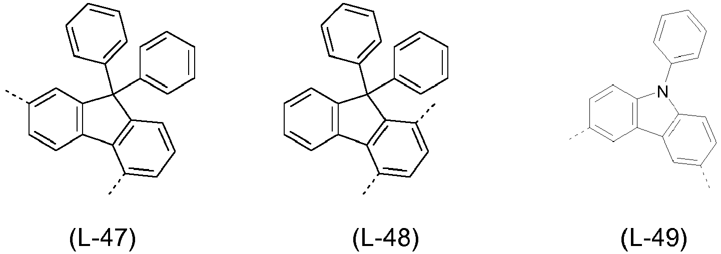 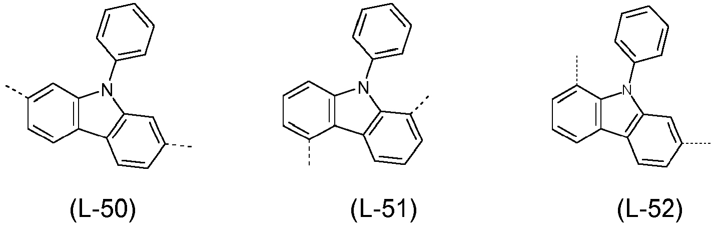 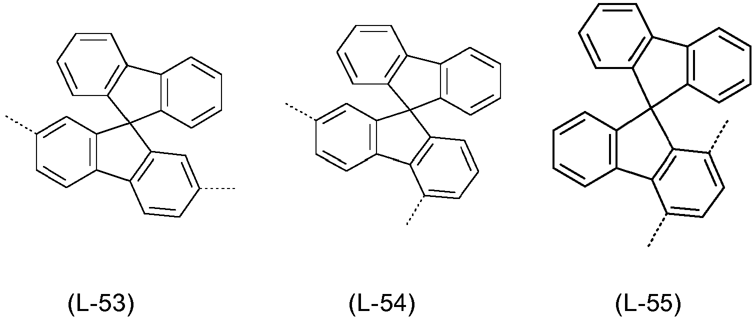 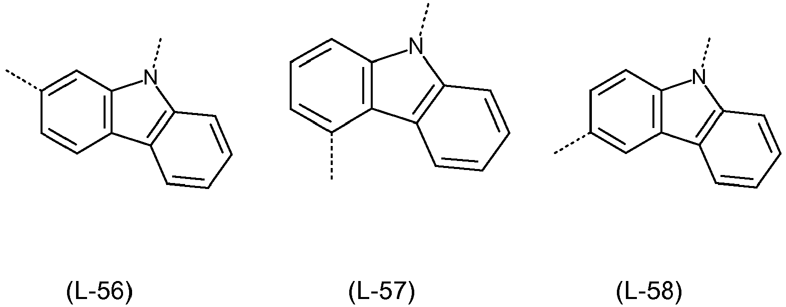 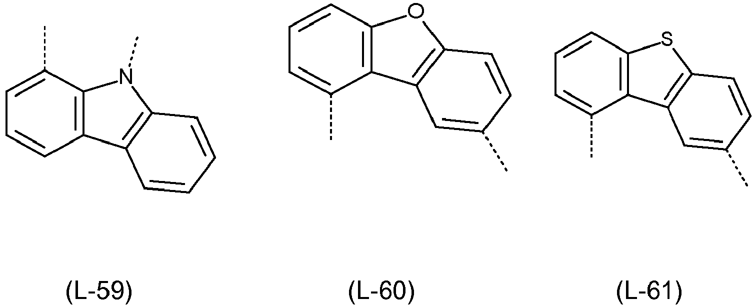 where the dashed bonds indicate the bonds to the group G and to Ar¹, and where the groups (L-17) to (L-61) may be substituted at each free position by a group R.

Among the groups of formulae (L-1) to (L-16), the groups (L-1), (L-2), (L-6), (L-8), (L-10), (L-12) and (L-16) are preferred. Very preferred are the groups (L-1), (L-12) and (L-16).

Among the groups if formulae (L-17) to (L-61), the groups (L-17) to (L-25), (L-30), (L-34) to (L-36), (L-38) to (L-44), (L-46), (L-47), (L-49) to (L-54), (L-56) to (L-58), (L-60) and (L-61) are preferred.

In accordance with another preferred embodiment, L is a single bond.

The group G is preferably an aromatic or heteroaromatic ring system having 6 to 24 aromatic ring atoms, preferably 6 to 18 aromatic ring atoms, very preferably 6 to 13 aromatic ring atoms. The group G is very preferably an aromatic or heteroaromatic ring system selected from naphthalene, anthracene, fluoranthene, biphenyl, terphenyl, fluorene, furan, benzofuran, dibenzofuran, thiophene, benzothiophene, dibenzothiophene, carbazole, benzocarbazole, indolocarbazole, indenocarbazole, pyridine, quinoline, isoquinoline, pyridazine, benzopyridazine, pyrimidine, benzopyrimidine, benzimidazole, quinoxaline, pyrazine, azacarbazole, benzocarboline, phenanthroline, 1,3,5-triazine, 1,2,4-triazine or 1,2,3-triazine, each of which may be substituted by one or more radicals R. The group G is particularly preferably selected from fluorene, dibenzofuran, dibenzothiophene, carbazole, benzocarbazole, indolocarbazole or indenocarbazole, each of which may be substituted by one or more radicals R.

Examples of suitable groups G are aromatic or heteroaromatic ring systems selected from the groups of formulae (G-1) to (G-10), 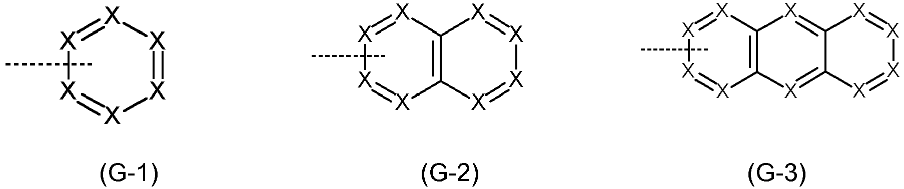 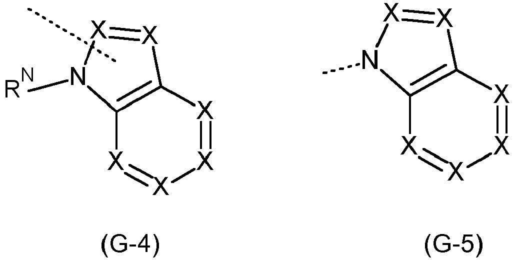 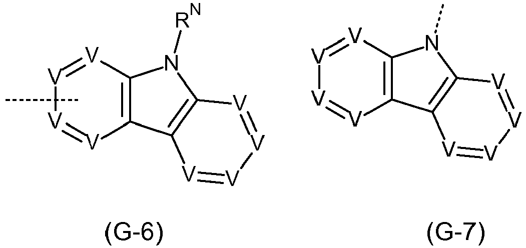 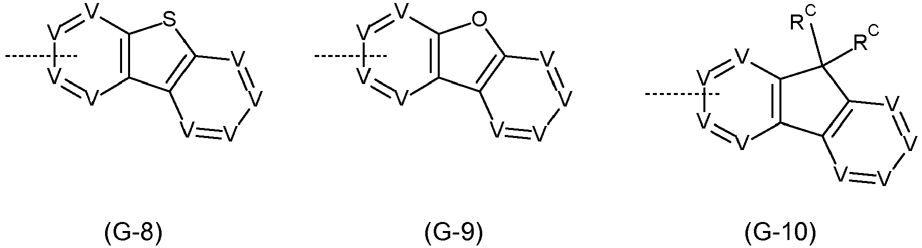 where, in formula (G-1) to (G-10):
the dashed bond indicates the bonding to the group L or, if L is a single bond, to Ar¹ as depicted in formula (1);
R^{N} and R^{C} have the same meaning as above; and
X is on each occurrence, identically or differently, CR or N; where X is a C atom when a group L or Ar¹ is bonded to X, where there are maximum three X groups per 6-membered ring, which stand for N, and two X groups per 5-membered ring, which stand for N; with the proviso that, in formula (G-1), at least one X stands for N;
V is on each occurrence, identically or differently, CR or N, with the proviso that V is a C atom when a group L or Ar¹ is bonded to V; or two adjacent groups V form together a group of formula (V-1) or (V-2), 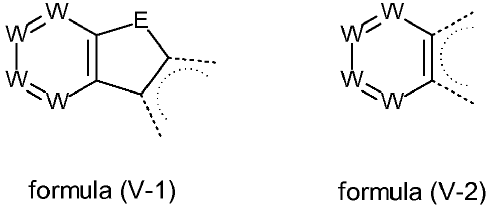 where the dashed bonds in formula (V-1) and (V-2) indicate the bonding to the structures depicted in formulae (G-5) to (G-10);
W is on each occurrence, identically or differently, CR or N; wherein there are maximum three X groups per 6-membered ring, which stand for N; and
E is O, S, N(R^{N}), C(R^{C})₂.

Examples of very suitable groups G are aromatic or heteroaromatic ring systems selected from the groups of formulae (G-11) to (G-64), 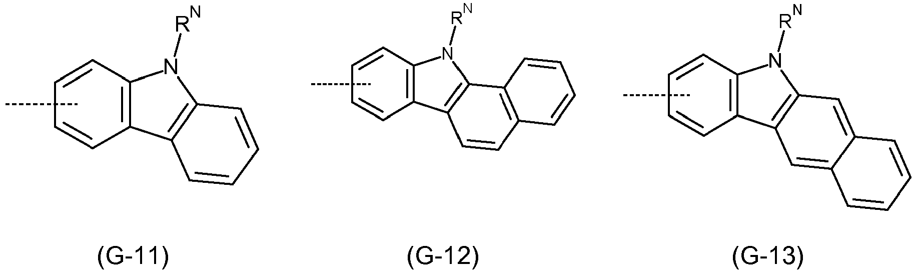 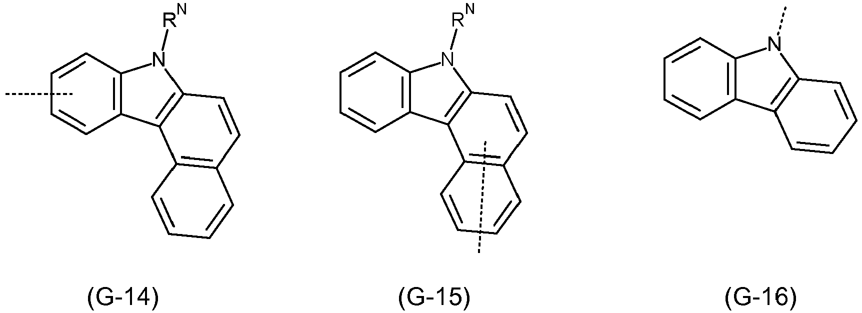 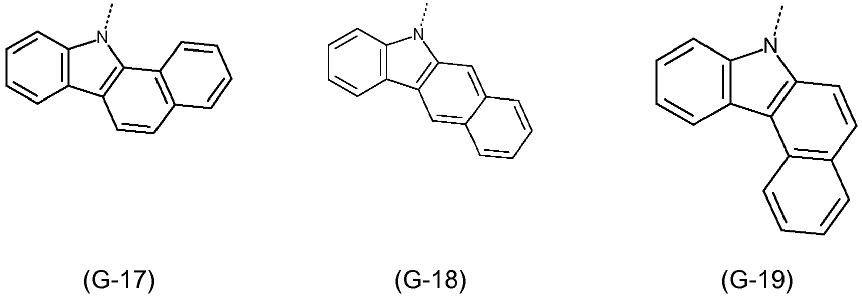 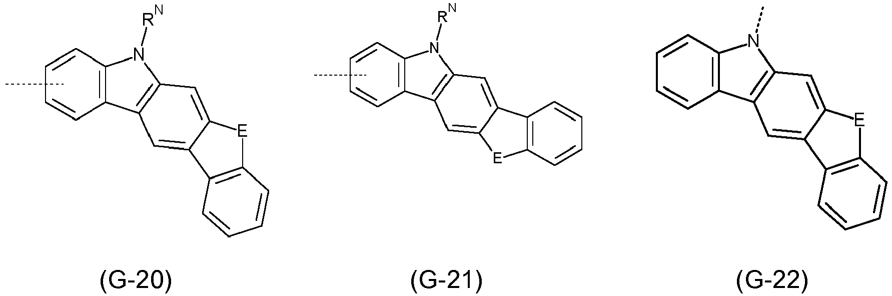 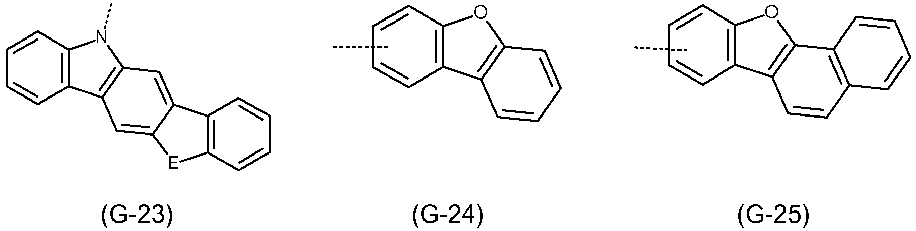 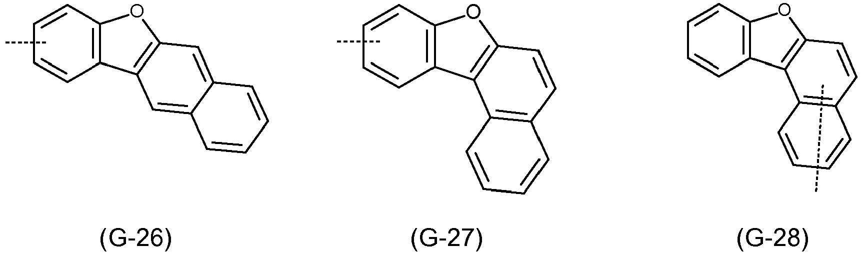 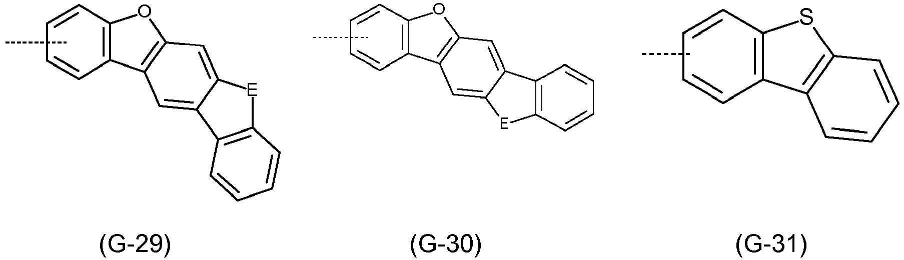 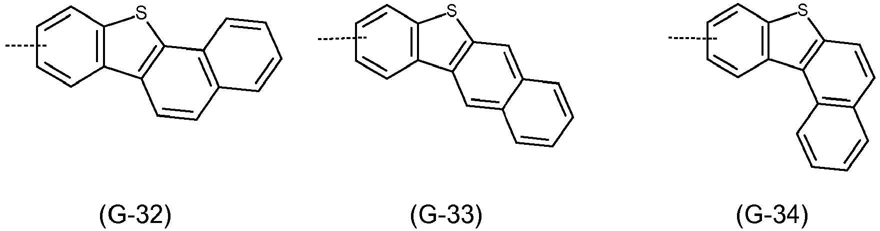 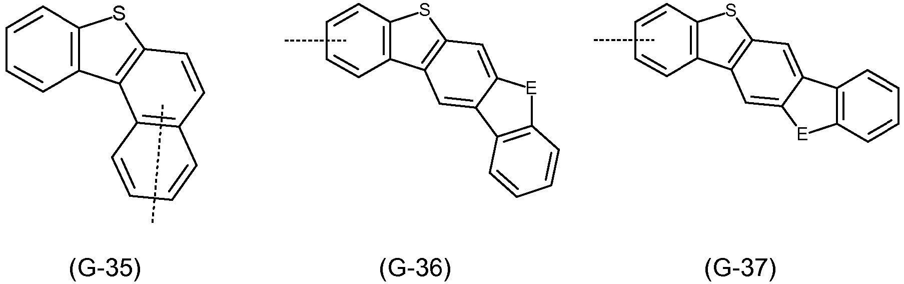 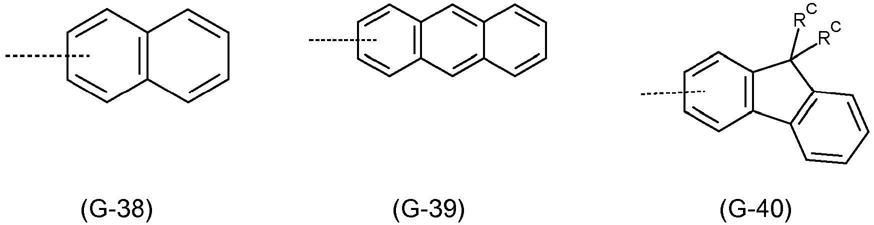 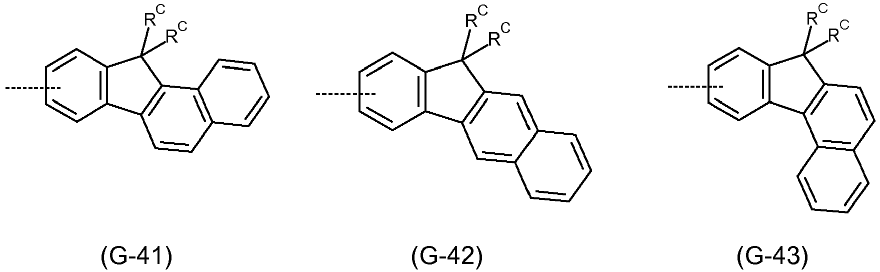 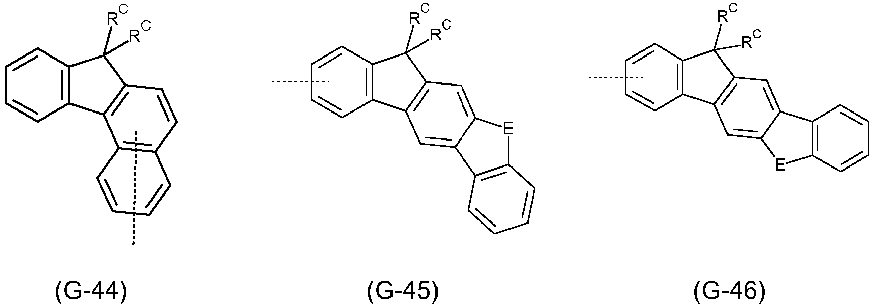 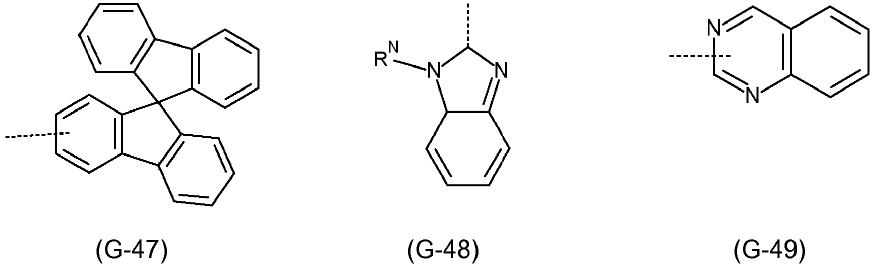 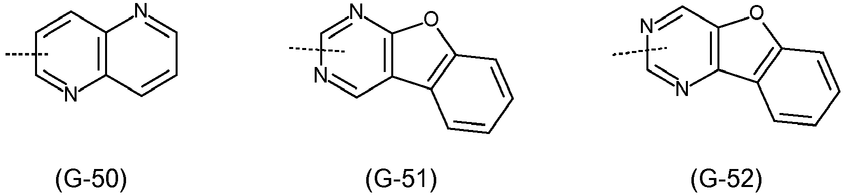 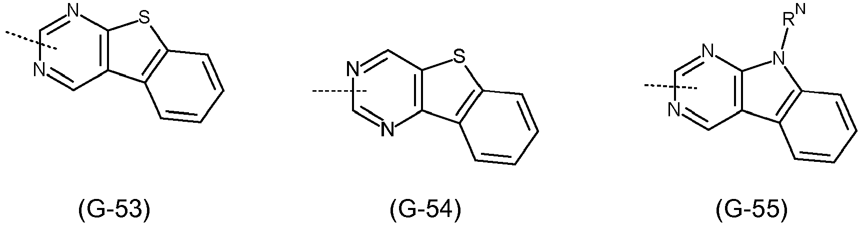 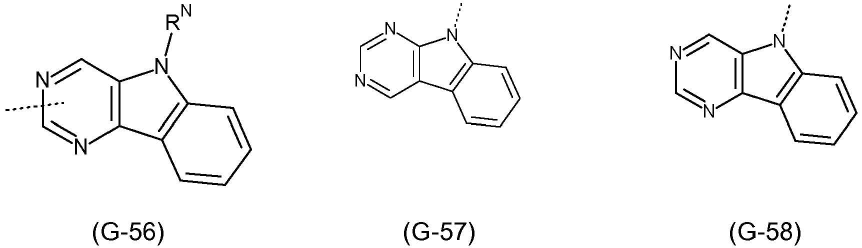 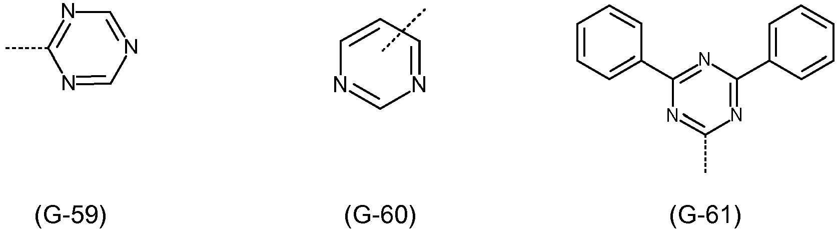 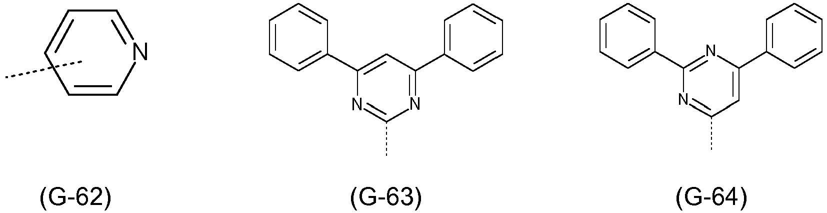 where
the dashed bond indicates the bonding to the group L or, if L is a single bond, to Ar¹ as depicted in formula (1);
the symbols R^{C}, R^{N} and E have the same meaning as above; and the groups of formulae (G-11) to (G-64) are optionally substituted by one or more radicals R at any free positions.

Among formulae (G-1) to (G-10), formulae (G-1), (G-6) and (G-7) are preferred, formulae (G-6) and (G-7) are very preferred.

Among formulae (G-11) to (G-64), formulae (G-11) to (G-23), and (G-53) to (G-64) are preferred, formulae (G-11) to (G-23) are very preferred.

In accordance with another preferred embodiment, G stands for a group - N(Ar³)₂, where Ar³ is selected from an aromatic or heteroaromatic ring system having 6 to 24 aromatic ring atoms, preferably 6 to 18 aromatic ring atoms, more preferably 6 to 13 aromatic ring atoms. It is particularly preferred that Ar³ is selected on each occurrence, identically or differently, from benzene, naphthalene, fluoranthene, biphenyl, terphenyl, fluorene, spirobifluorene, cis- or trans-indenofluorene, furan, benzofuran, isobenzofuran, dibenzofuran, thiophene, benzothiophene, isobenzothiophene, dibenzothiophene, carbazole, benzocarbazole, indolocarbazole and indenocarbazole, which may be substituted by one or more radicals R, and where two groups Ar³ present in a group -N(Ar³)₂ are allowed to be connected via a single bond or a divalent bridge.

In accordance with a preferred embodiment, two groups Ar³ present in a group -N(Ar³)₂ are connected via a single bond or a divalent bridge and form a group selected from formulae (E-1) to (E-24), 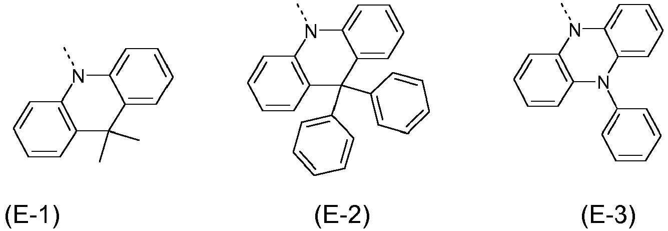 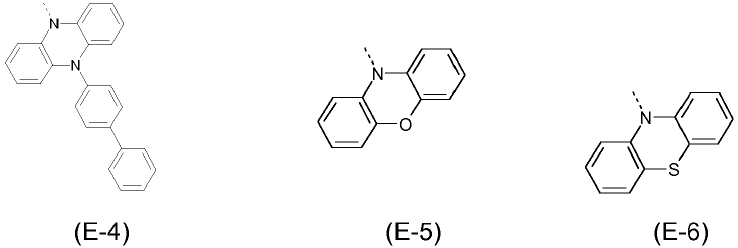 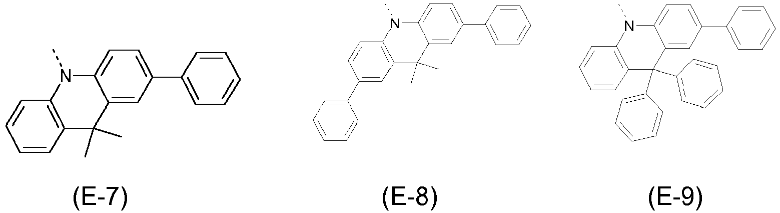 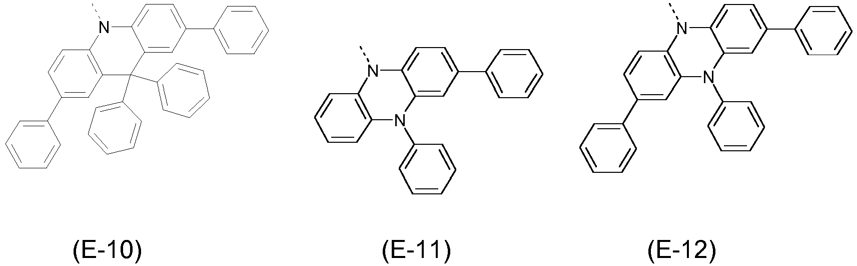 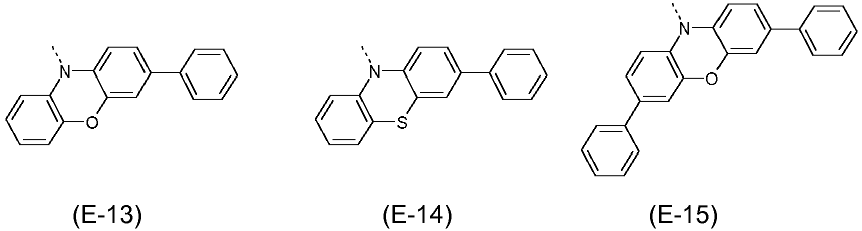 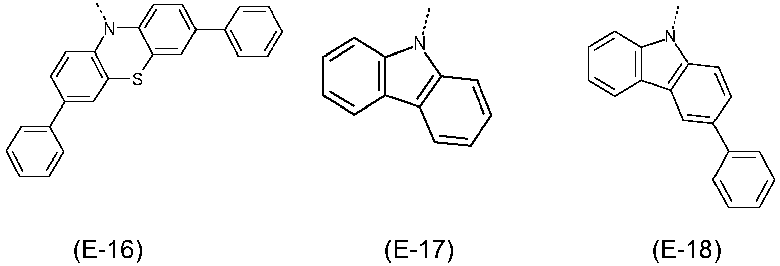 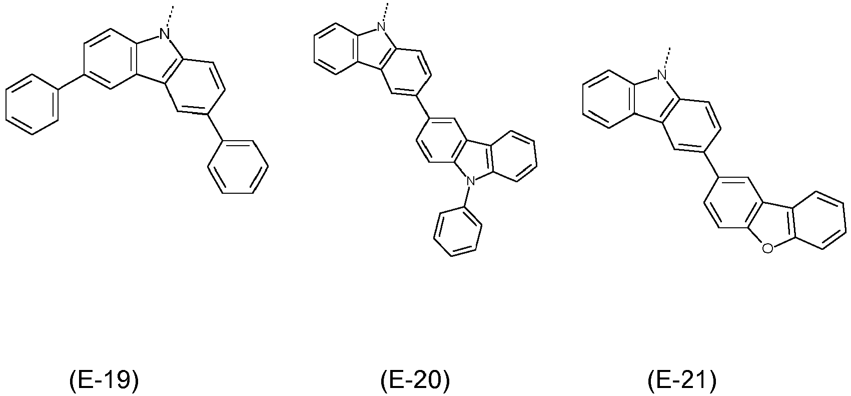 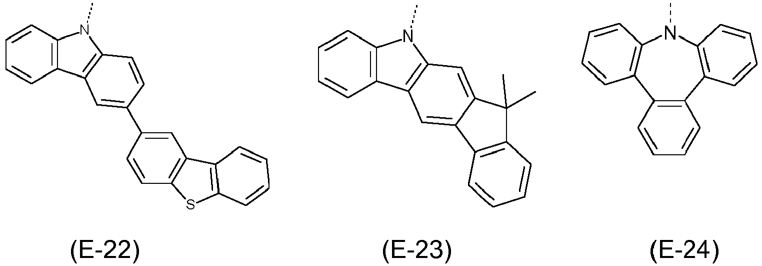
where the dashed bond indicates the bonding to the group L or, if L is a single bond, to Ar¹ as depicted in formula (1);
and where the groups (E-1) to (E-24) may be substituted at each free position by a group R as defined above, but are preferably unsubstituted.

From the groups (E-1) to (E-24), the following unsubstituted groups are preferred: (E-8), (E-10), (E-12), (E-15), (E-16), (E-18), (E-19), (E-20) and (E-23).

In accordance with another preferred embodiment, two groups Ar³ present in a group -N(Ar³)₂ are selected, on each occurrence, identically or differently from the groups of the following formulae (A-1) to (A-48), 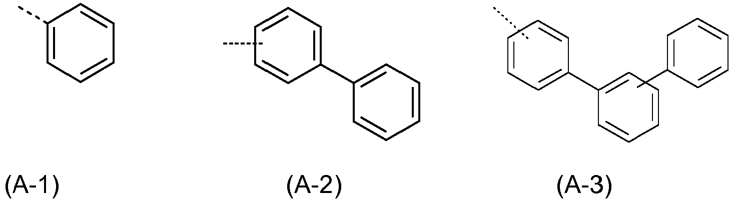 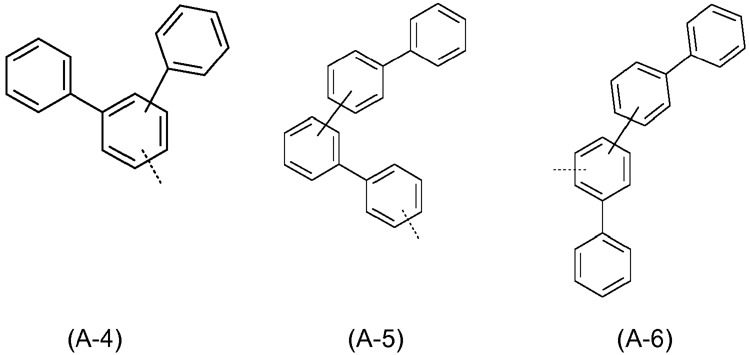 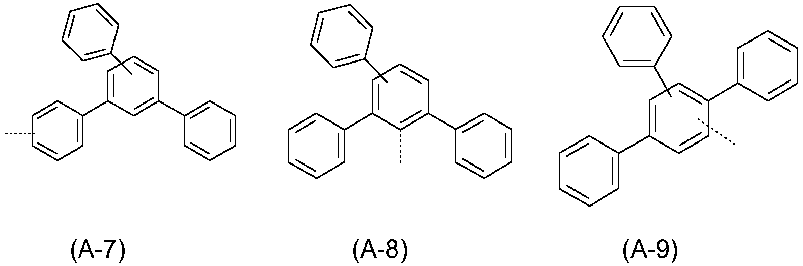 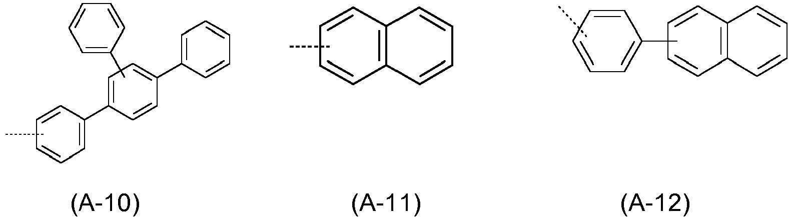 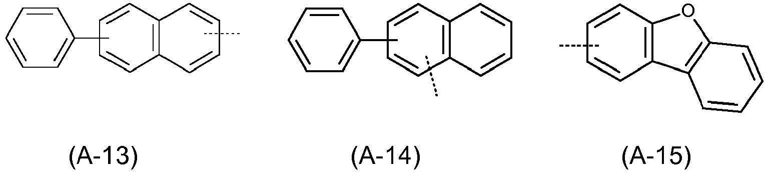 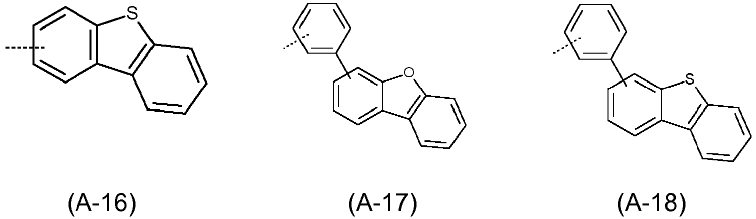 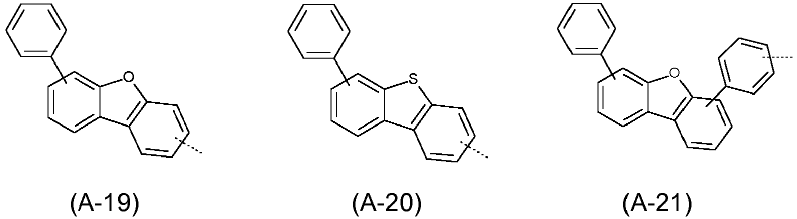 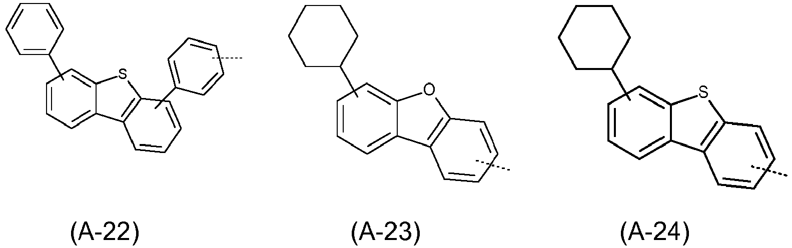 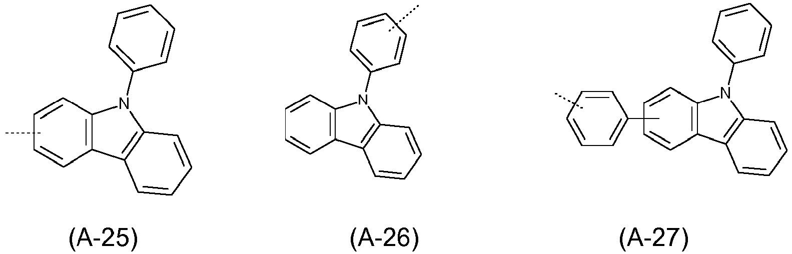 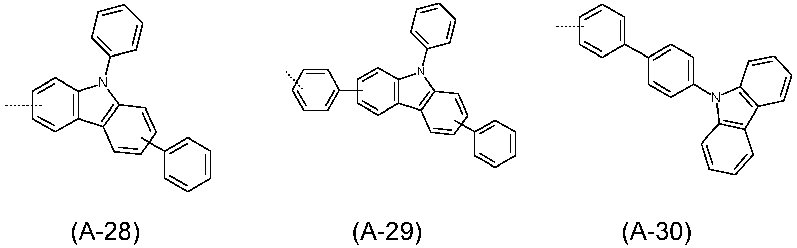 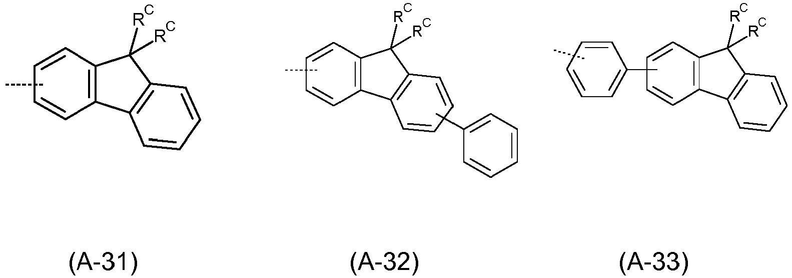 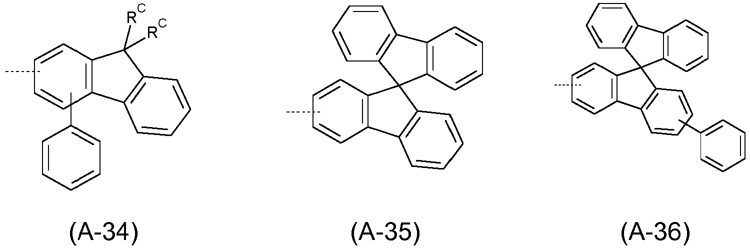 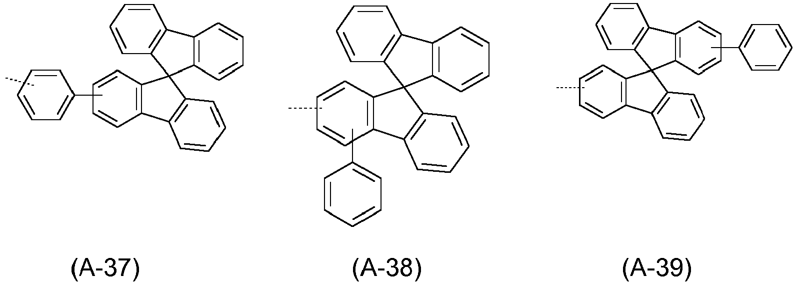 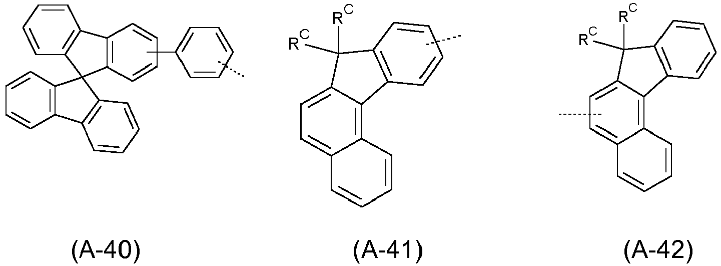 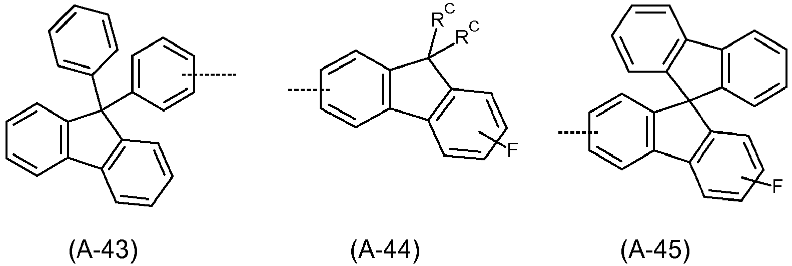 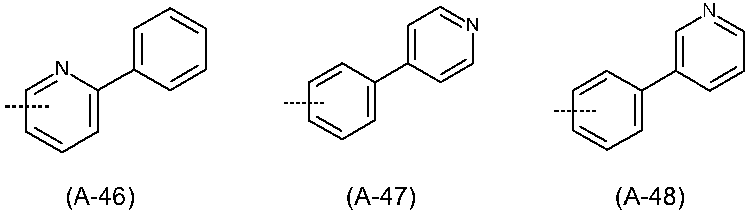
where the dashed bond indicates the bond to the nitrogen atom,
where the groups of formulae (A-1) to (A-48) may further be substituted at each free position by a group R as defined above but are preferably unsubstituted and
where the group R^{C}, in formulae (A-31) to (A-34), (A-41), (A-42) and (A-44) has the same meaning as above.

More preferably, the group Ar³ is selected on each occurrence, identically or differently, from the groups (A-1), (A-2), (A-3), (A-15), (A-16), (A-17), (A-18), (A-31), (A-32), (A-33), (A-35) and (A-43), which may be substituted at each free position by a group R as defined above.

Preferably, L is a single bond when G is a group -N(Ar³)₂.

The group R^{C} according to the present invention is preferably selected on each occurrence, identically or differently, from the group consisting of H, D, F, CN, Si(R¹)₃, a straight-chain alkyl group having 1 to 10 C atoms or a branched or cyclic alkyl group having 3 to 10 C atoms, each of which may be substituted by one or more radicals R¹, an aromatic or heteroaromatic group having 5 to 25 aromatic ring atoms, each of which may be substituted by one or more radicals R¹, where two adjacent substituents R^{C} may optionally form a mono- or polycyclic, aliphatic ring system or aromatic ring system, each of which may be substituted by one or more radicals R¹. More preferably, R^{C} is selected on each occurrence, identically or differently, from the group consisting of H, a straight-chain alkyl group having 1 to 5 C atoms or a branched or cyclic alkyl group having 3 to 5 C atoms, each of which may be substituted by one or more radicals R¹, an aryl or heteroaryl group having 5 to 18 aromatic ring atoms, each of which may be substituted by one or more radicals R¹.

The group R^{N} according to the invention is preferably selected on each occurrence, identically or differently, from the group consisting of a straight-chain alkyl group having 1 to 10 C atoms or a branched or cyclic alkyl group having 3 to 10 C atoms, each of which may be substituted by one or more radicals R¹, an aromatic or heteroaromatic ring system having 5 to 25 aromatic ring atoms, each of which may be substituted by one or more radicals R¹. More preferably, R^{N} is an aromatic or heteroaromatic ring system having 5 to 25 aromatic ring atoms, preferably 6 to 18 aromatic ring atoms, more preferably 6 to 13 aromatic ring atoms. The group R^{N} is particularly preferably selected from the group consisting of phenyl, biphenyl, terphenyl, pyridine, quinoline, isoquinoline, pyridazine, benzopyridazine, pyrimidine, benzopyrimidine, benzimidazole, quinoxaline, pyrazine, 1,3,5-triazine, 1,2,4-triazine or 1,2,3-triazine, each of which may be substituted by one or more radicals R¹.

Examples of very suitable groups R^{N} are aromatic or heteroaromatic ring systems selected from the groups of formulae (RN-1) to (RN-10), 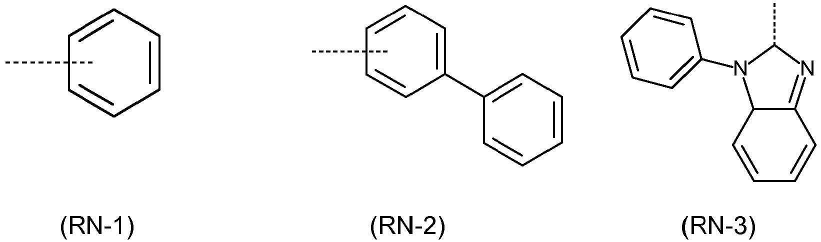 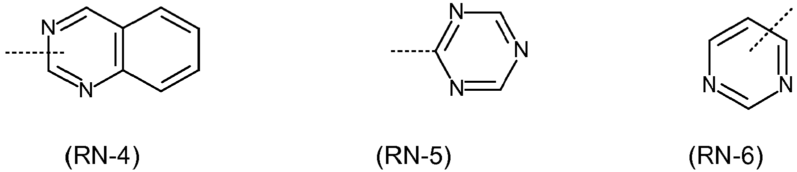 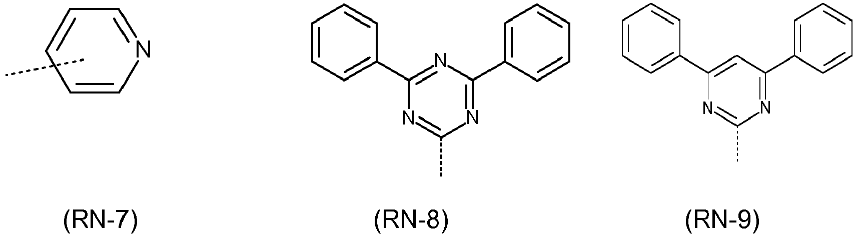 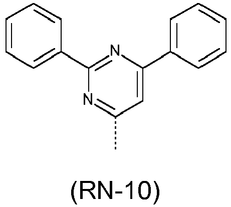 where the dashed bonds indicate the bonds to the nitrogen atom, and
where the groups of formulae (RN-1) to (RN-10) may further be substituted at each free position by a group R¹ as defined above, but are preferably unsubstituted.

In accordance with a preferred embodiment, R is on each occurrence, identically or differently, H, D, F, N(Ar⁴)₂, CN, a straight-chain alkyl, alkoxy or thioalkoxy group having 1 to 10 C atoms or a straight-chain alkenyl or alkynyl group having 2 to 10 C atoms or a branched or cyclic alkyl, alkenyl, alkynyl, alkoxy or thioalkoxy group having 3 to 10 C atoms, each of which may be substituted by one or more radicals R¹, where one or more, preferably non-adjacent CH₂ groups may be replaced by O or S and where one or more H atoms may be replaced by D or F, or an aromatic or heteroaromatic ring system having 5 to 25 aromatic ring atoms, which may in each case be substituted by one or more radicals R¹. More preferably, R is on each occurrence, identically or differently, H, D, F, a straight-chain alkyl group having 1 to 10 C atoms, preferably 1 to 4 C atoms, or a branched or cyclic alkyl group having 3 to 10 C atoms, preferably 3 to 4 C atoms, each of which may be substituted by one or more radicals R¹, or an aryl or heteroaryl group having 6 to 18 aromatic ring atoms, preferably 6 to 13 C atoms, which may in each case be substituted by one or more radicals R¹.

In accordance with a preferred embodiment, R¹ is on each occurrence, identically or differently, H, D, F, N(Ar⁴)₂, CN, a straight-chain alkyl, alkoxy or thioalkoxy group having 1 to 10 C atoms or a straight-chain alkenyl or alkynyl group having 2 to 10 C atoms or a branched or cyclic alkyl, alkenyl, alkynyl, alkoxy or thioalkoxy group having 3 to 10 C atoms, each of which may be substituted by one or more radicals R², where one or more, preferably non-adjacent CH₂ groups may be replaced by O or S and where one or more H atoms may be replaced by D or F, or an aromatic or heteroaromatic ring system having 5 to 25 aromatic ring atoms, which may in each case be substituted by one or more radicals R². More preferably, R¹ is on each occurrence, identically or differently, H, D, F, a straight-chain alkyl group having 1 to 10 C atoms, preferably 1 to 4 C atoms, or a branched or cyclic alkyl group having 3 to 10 C atoms, preferably 3 to 4 C atoms, each of which may be substituted by one or more radicals R², or an aryl or heteroaryl group having 6 to 18 aromatic ring atoms, preferably 6 to 13 C atoms, which may in each case be substituted by one or more radicals R².

Preferably, Ar⁴ is an aromatic or heteroaromatic ring system having 5 to 18 aromatic ring atoms, which may be substituted by one or more radicals R¹;
Preferably, R² is on each occurrence, identically or differently, H, D, F, a straight-chain alkyl group having 1 to 10 C atoms or a branched or cyclic alkyl group having 3 to 10 C atoms, or an aryl or heteroaryl group having 5 to 18 aromatic ring atoms.

In accordance with a preferred embodiment, the compounds of formula (1) comprise at least one group Ar, Ar², R or R^{N}, which is selected from the group consisting of substituted or non-substituted triazine, pyrimidine, pyrazine, pyridazine, pyridine, imidazole, pyrazole, oxazole, oxadiazole, triazole, thiazole, thiadiazole, benzimidazole, quinolone, isoquinoline and quinoxaline.

In accordance with another preferred embodiment, the compounds of formula (1) comprise at least one group Ar, Ar², R or R^{N}, which is selected from the group consisting of substituted or non-substituted pyrrole, furan, thiophene, benzothiophene, benzofuran, indole, carbazole, dibenzothiophene, dibenzofuran and azacarbazole.

Examples of suitable compounds according to the invention are the structures shown below.

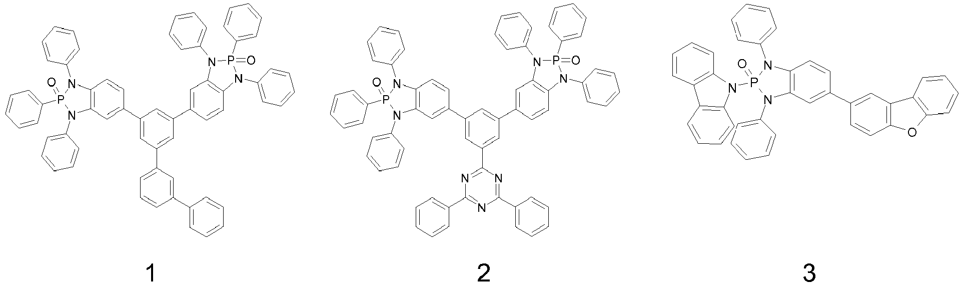

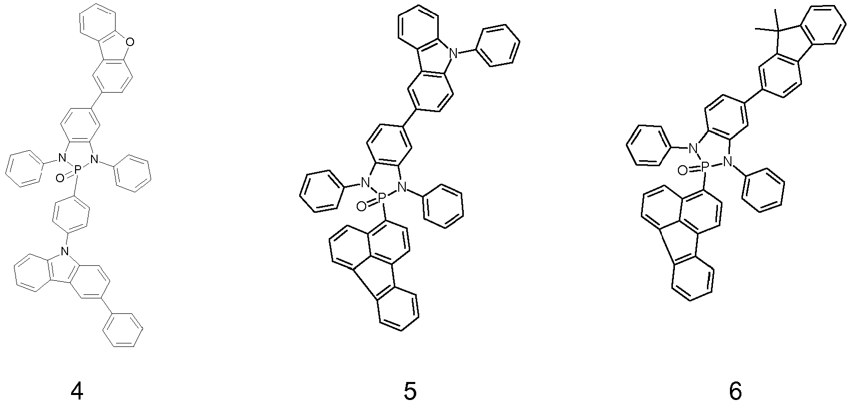

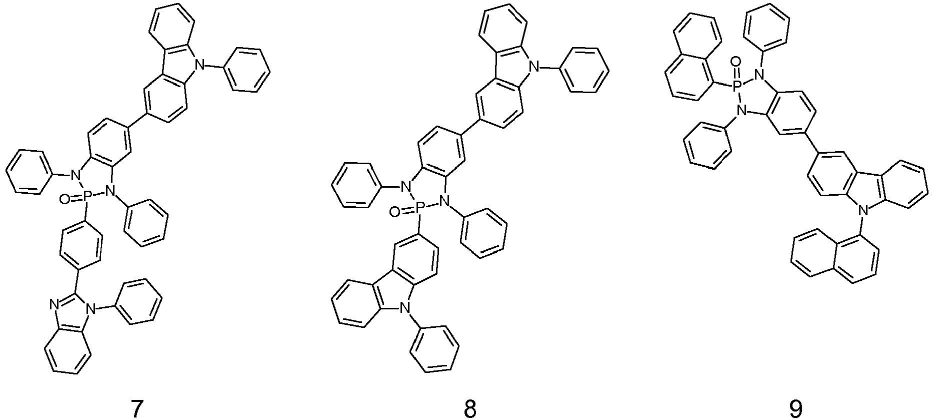

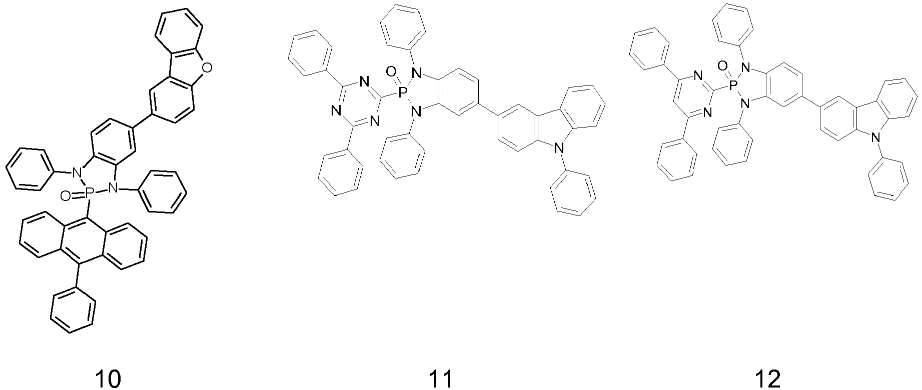

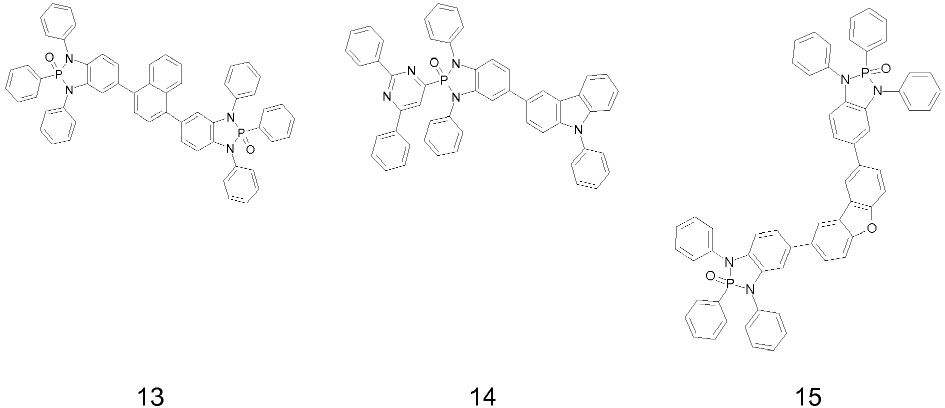

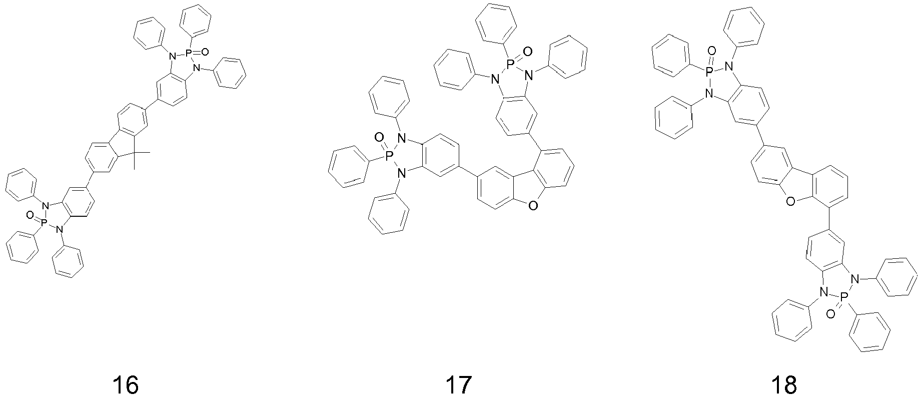

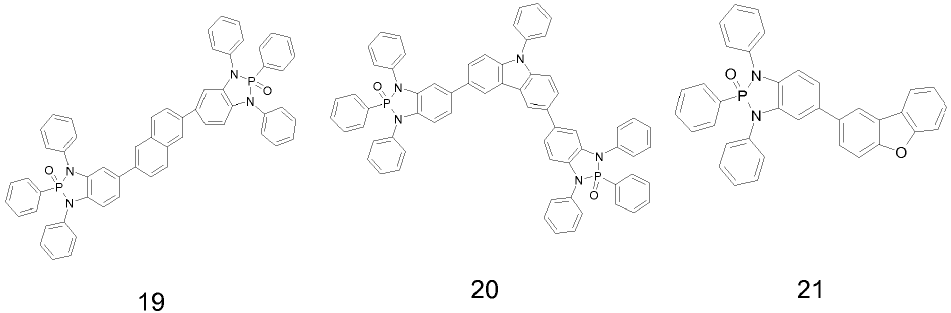

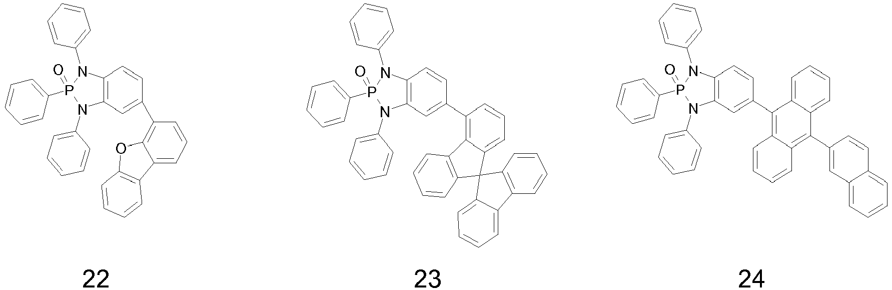

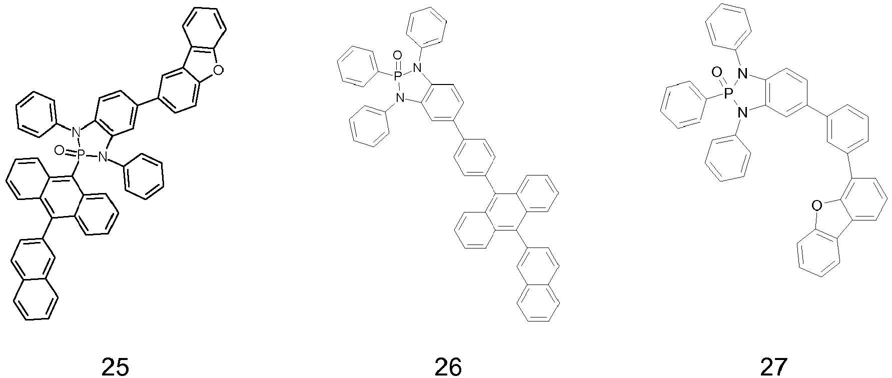

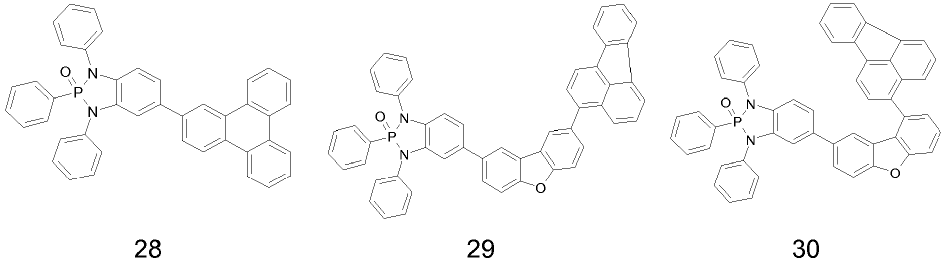

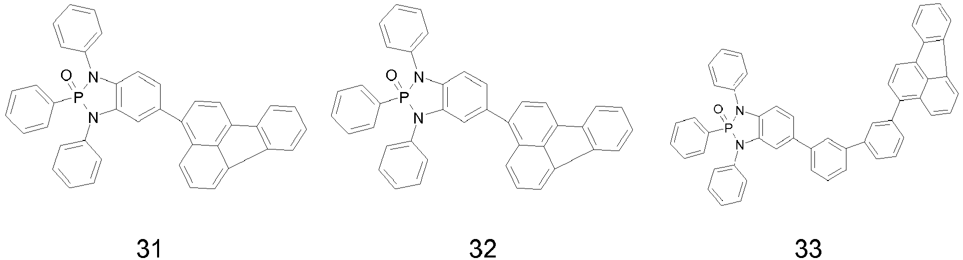

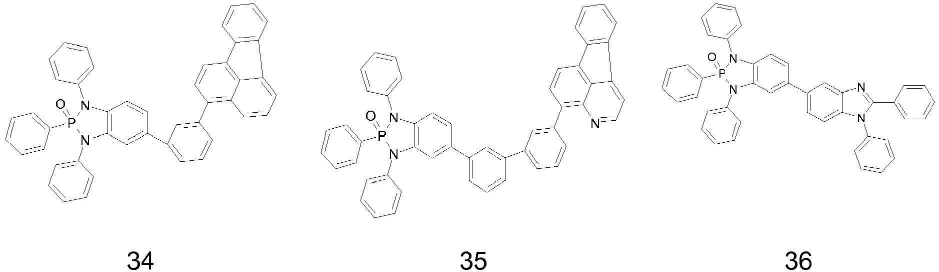

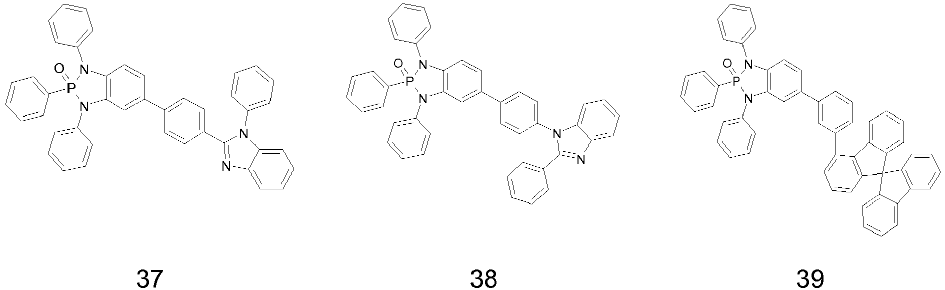

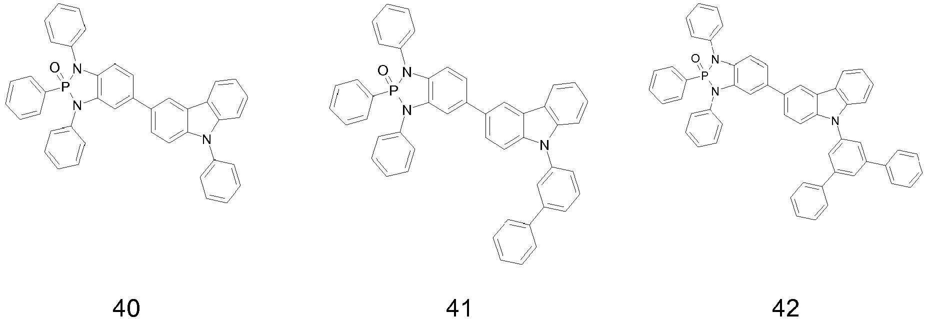

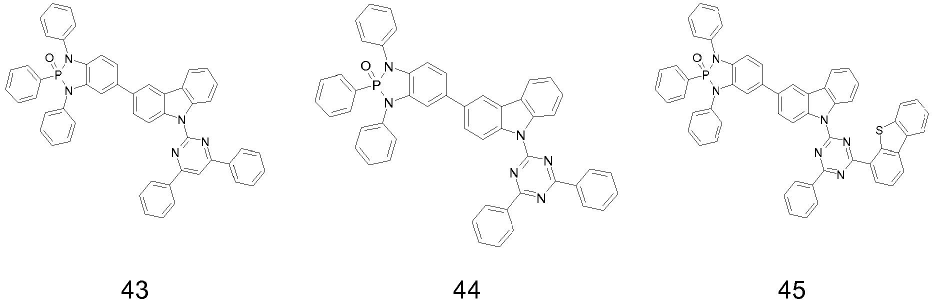

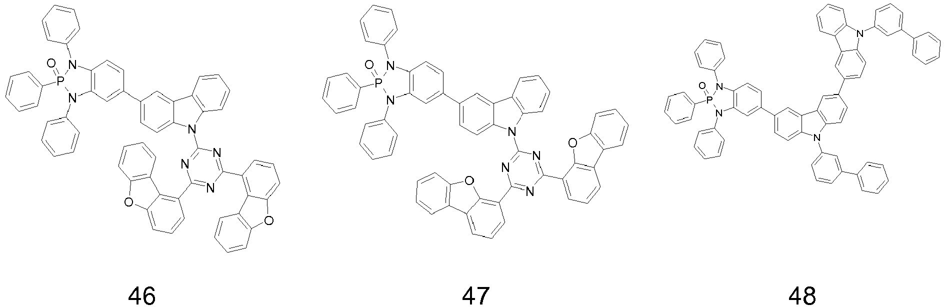

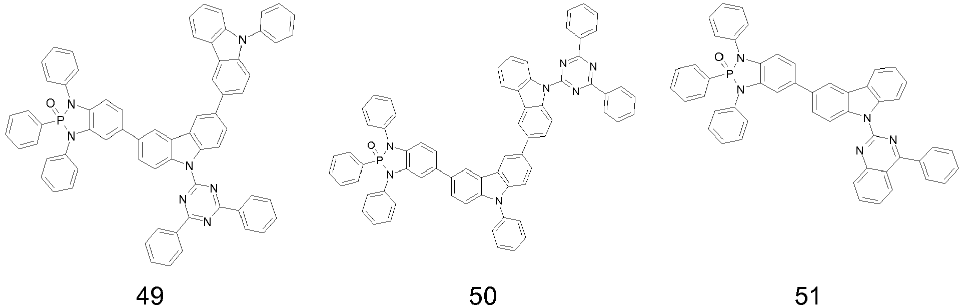

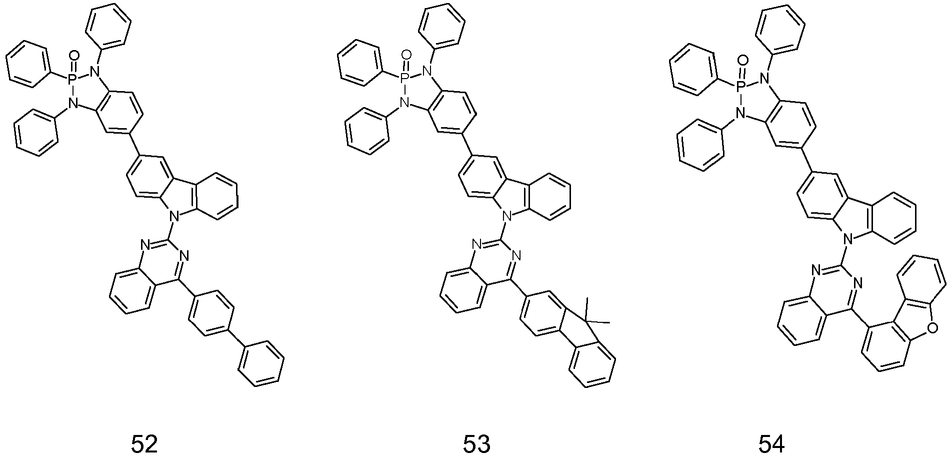

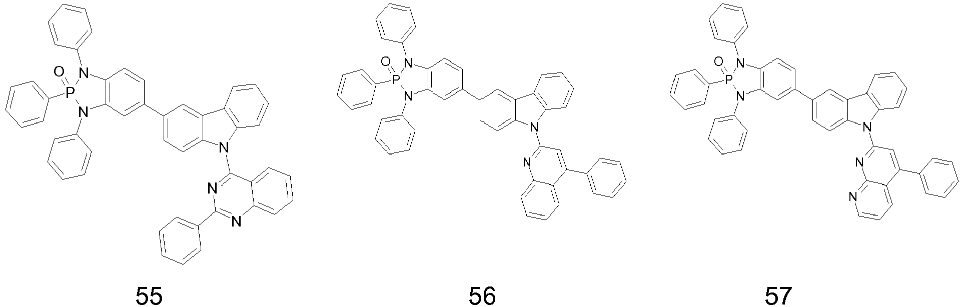

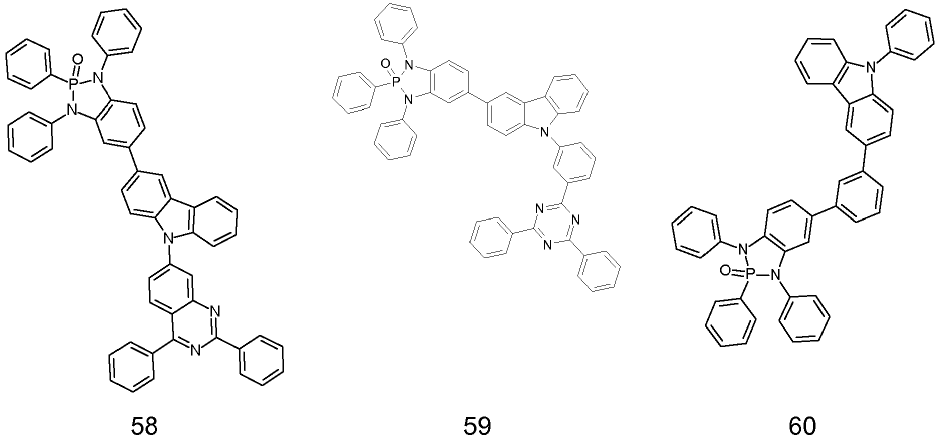

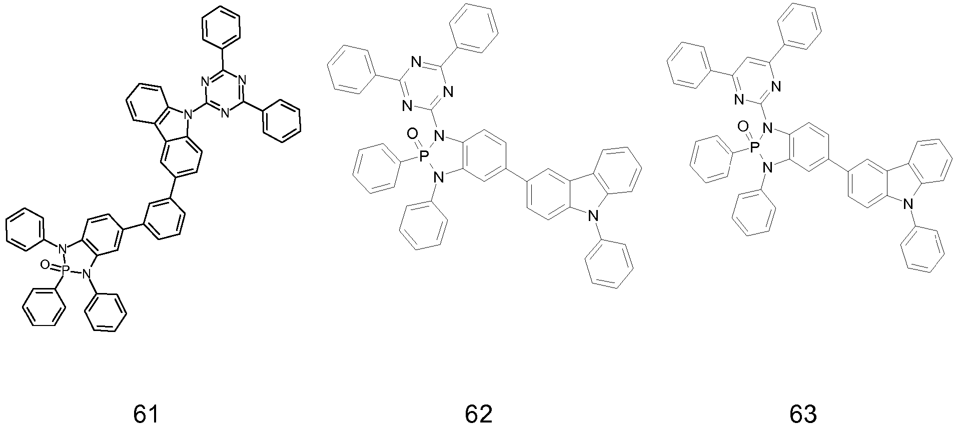

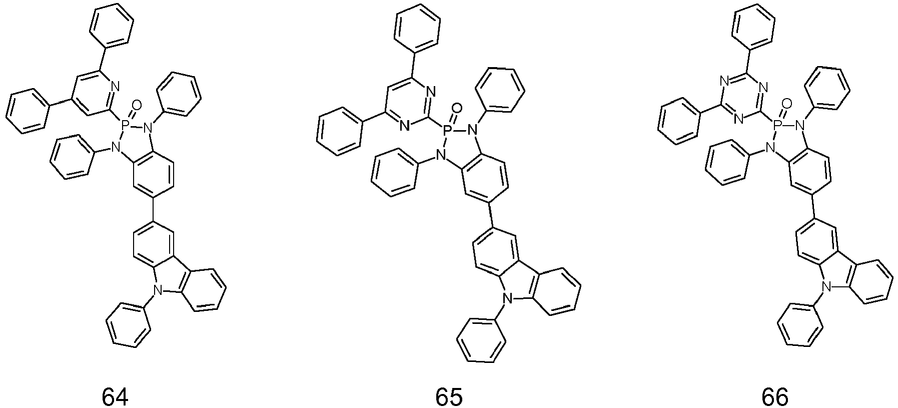

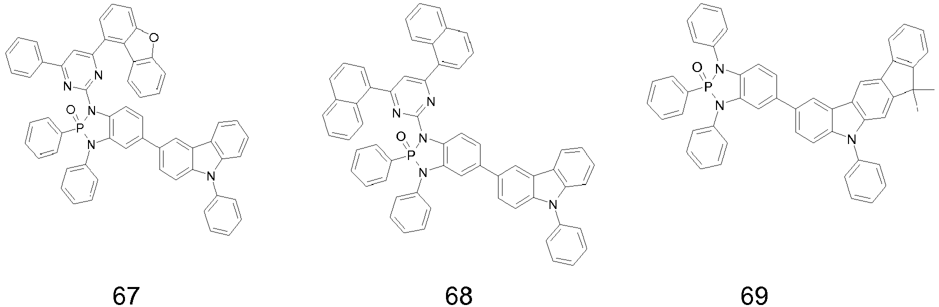

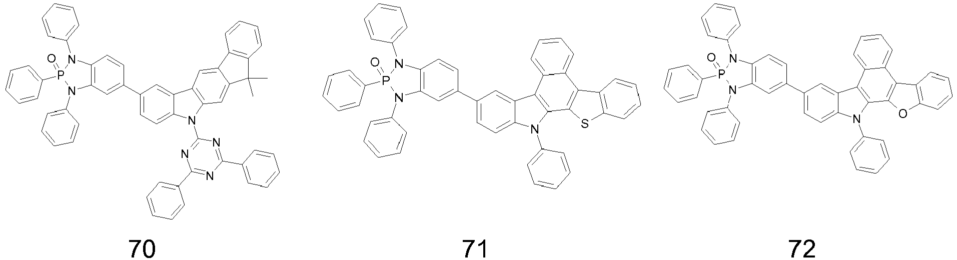

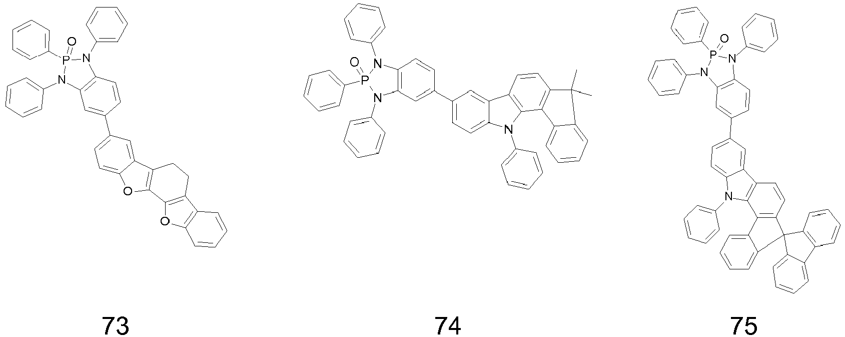

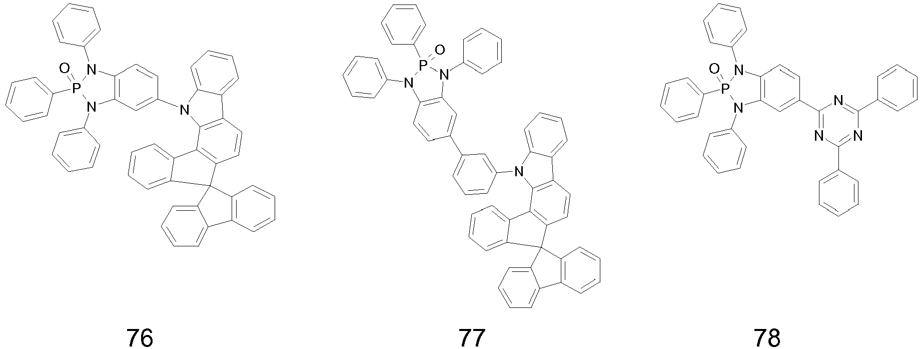

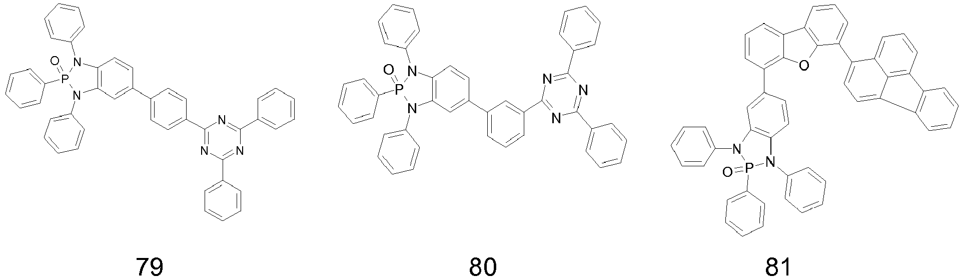

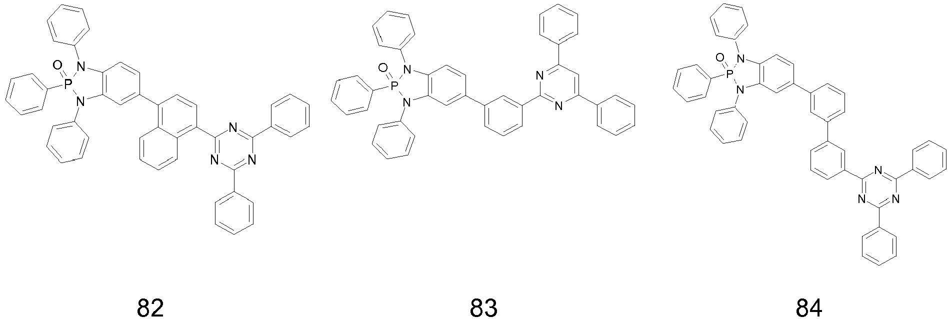

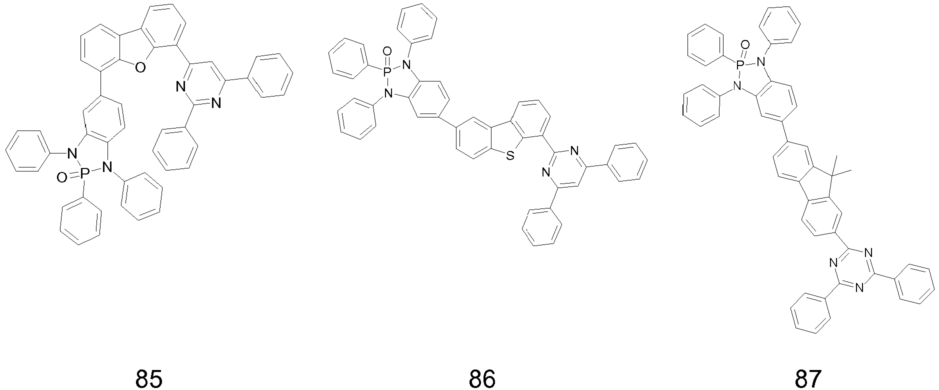

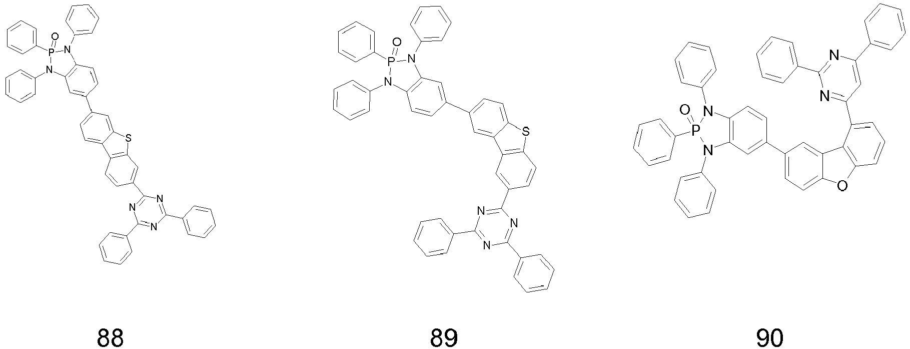

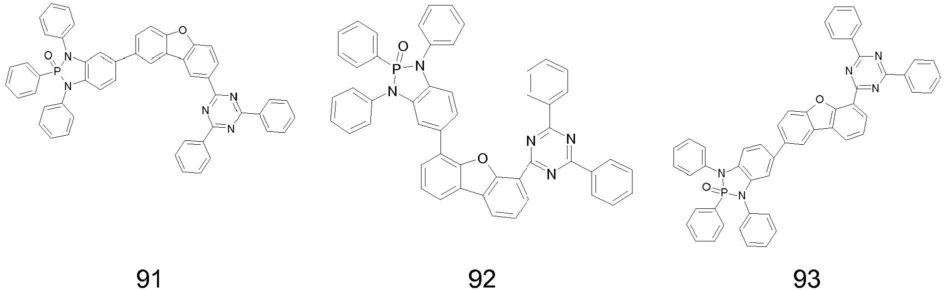

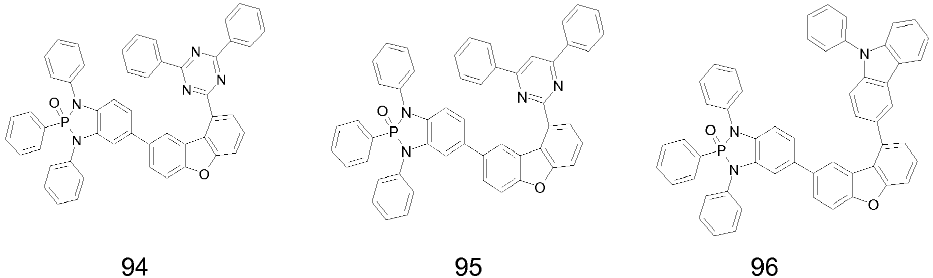

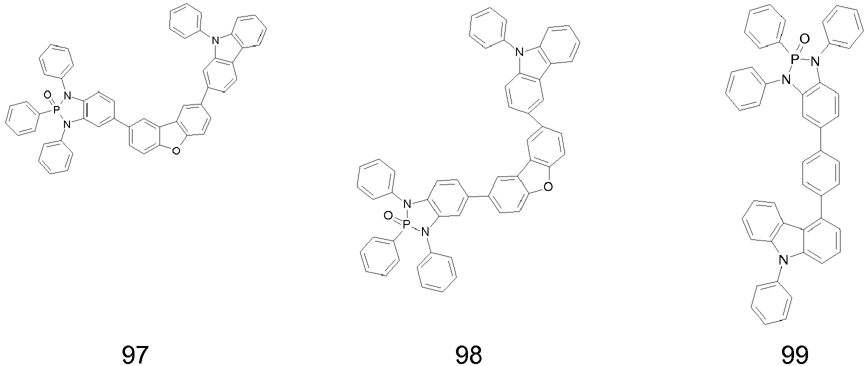

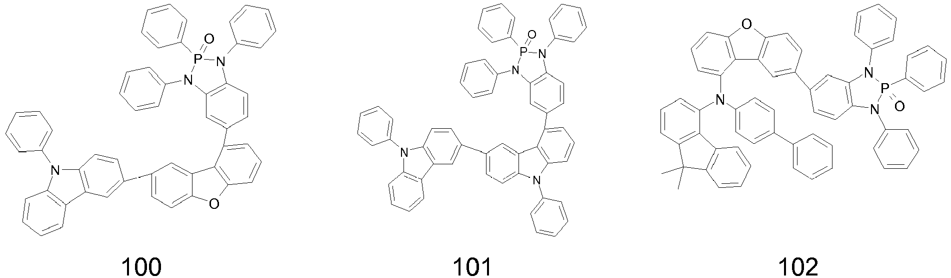

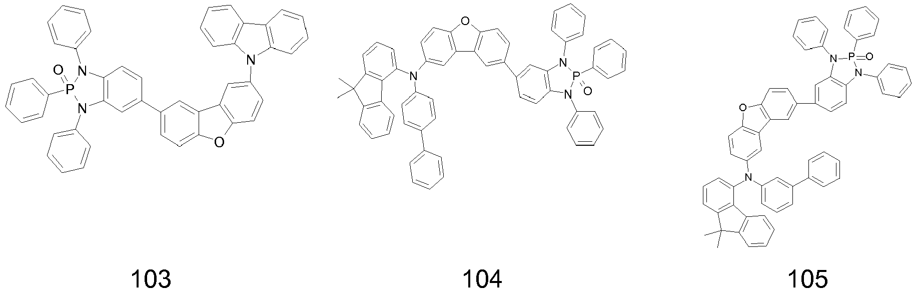

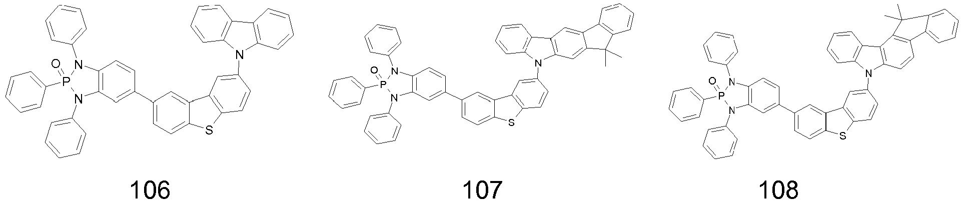

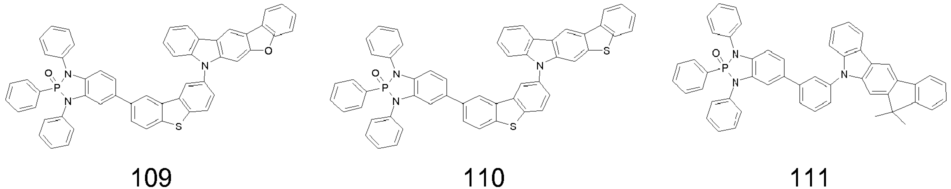

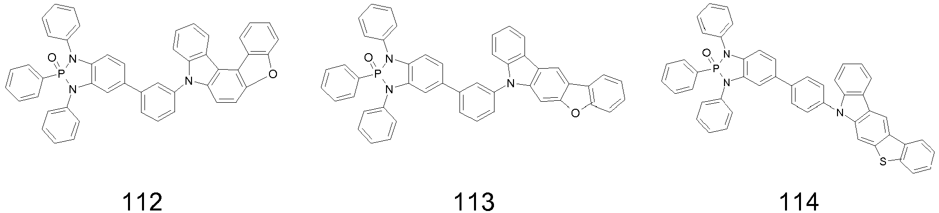

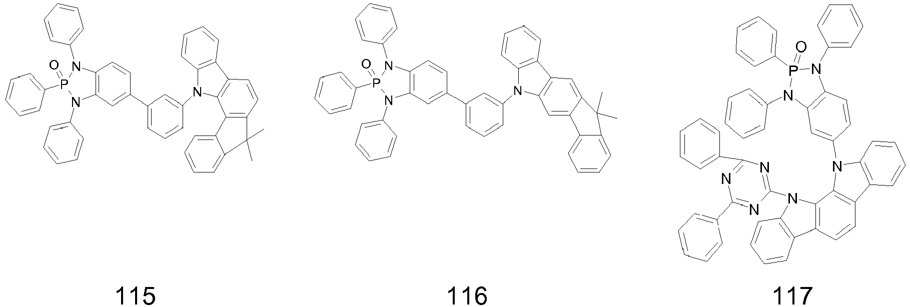

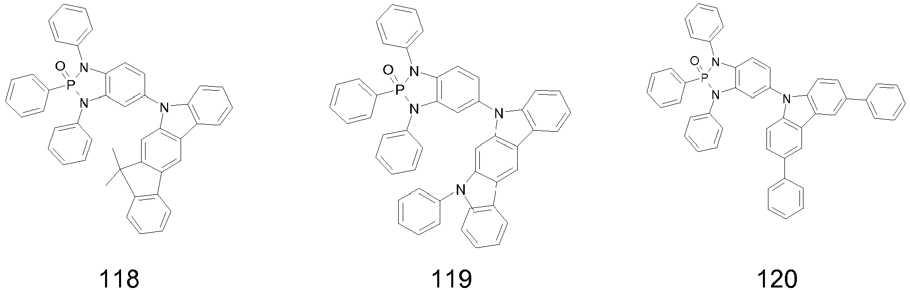

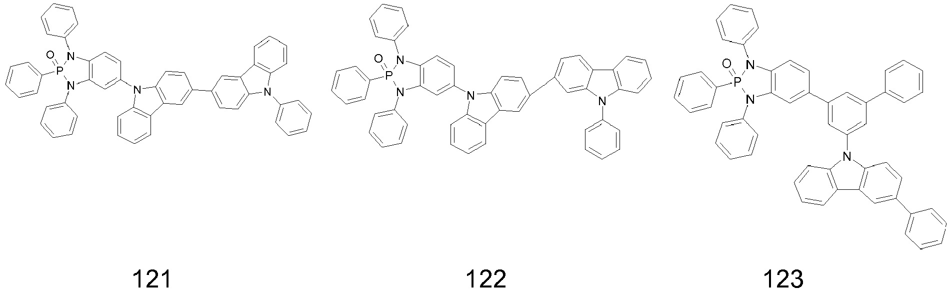

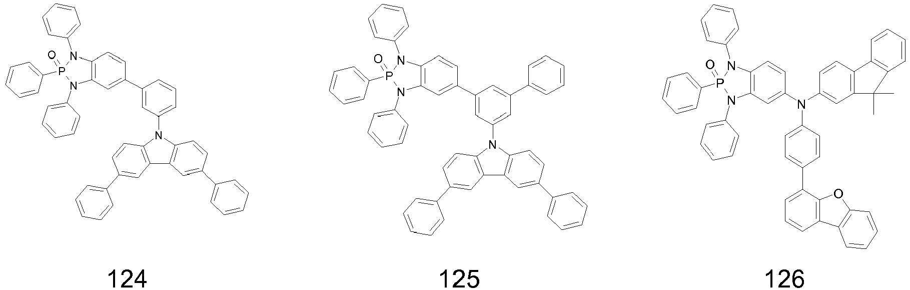

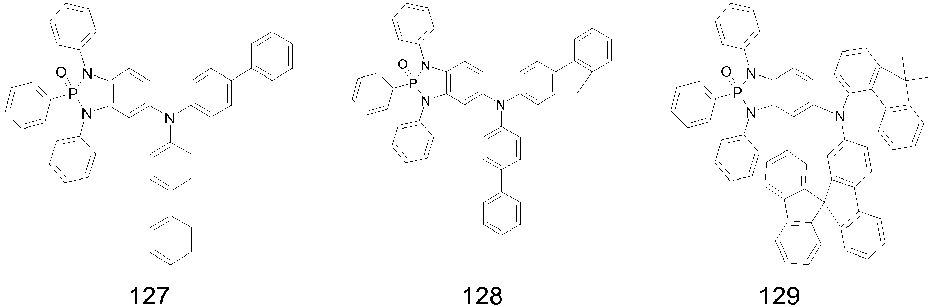

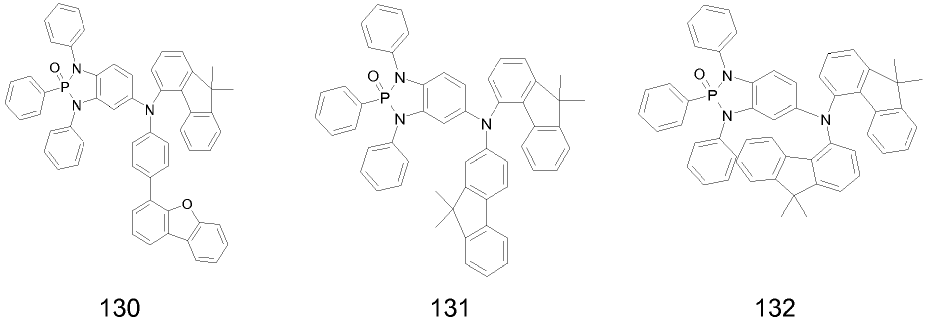

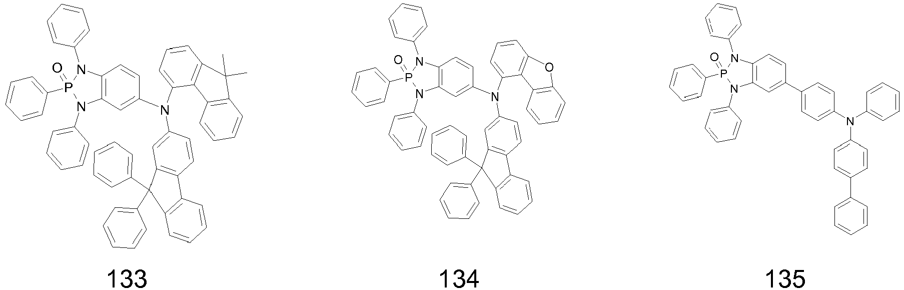

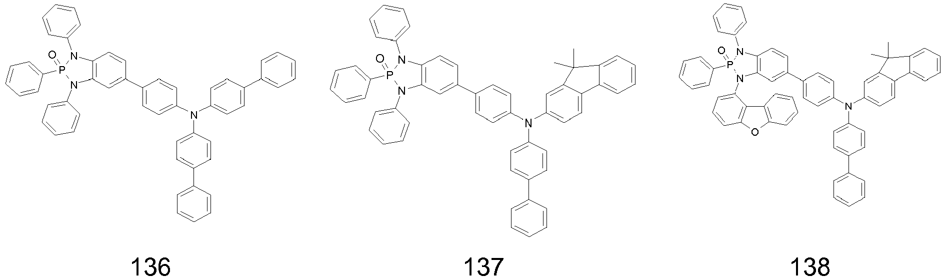

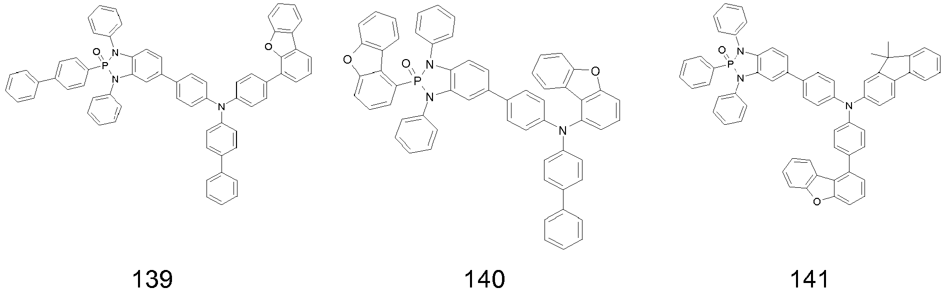

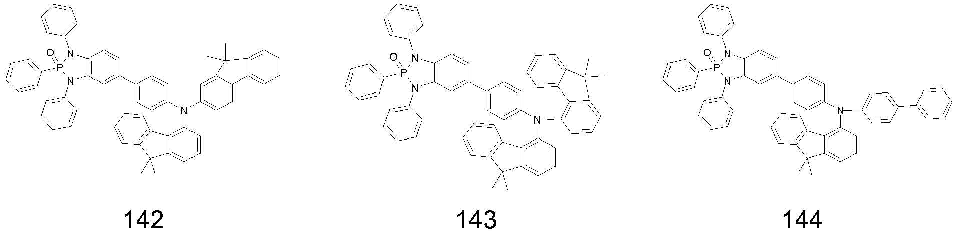

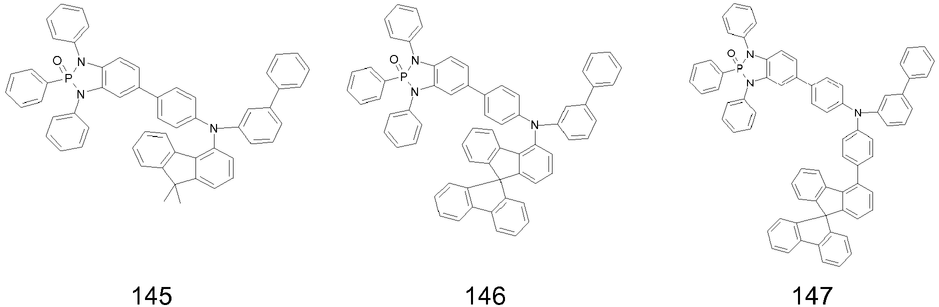

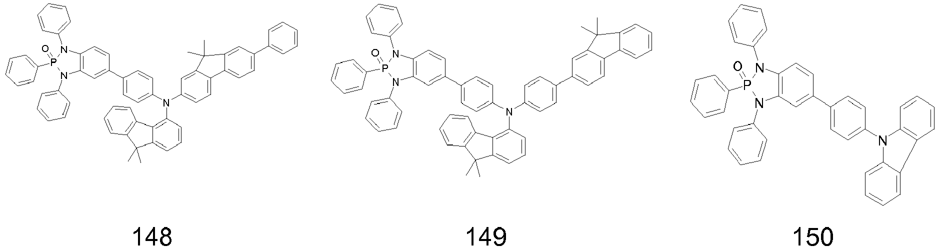

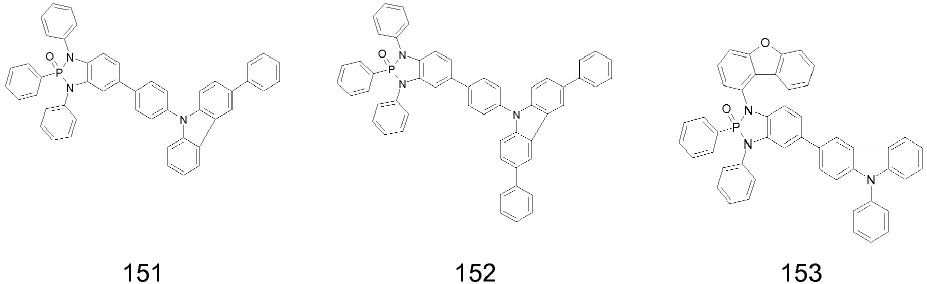

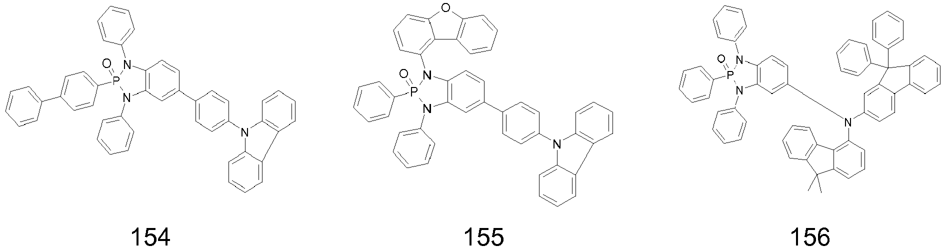

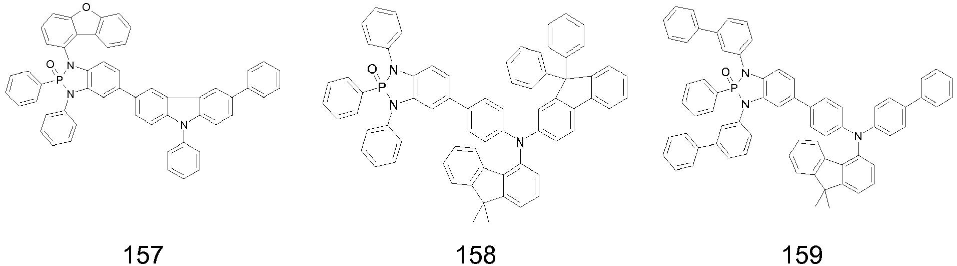

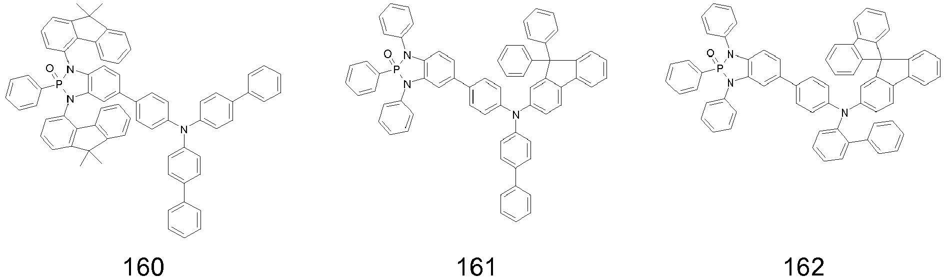

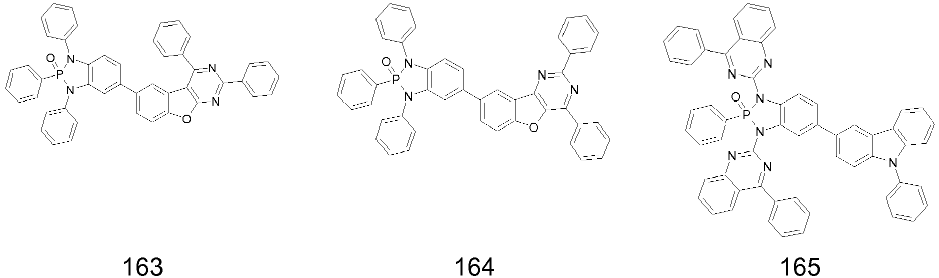

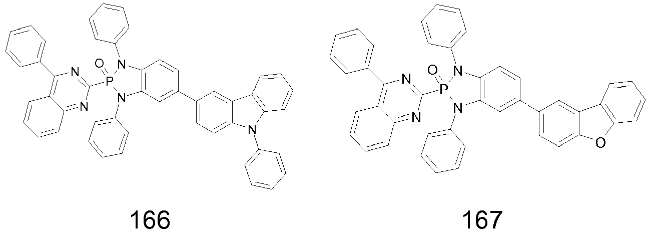

The compounds according to the invention can be prepared by synthesis steps known to the person skilled in the art, such as, for example, bromination, Suzuki coupling, Ullmann coupling, Hartwig-Buchwald coupling, etc. Suitable synthesis processes are depicted in general terms in Scheme 1 below.

### Scheme 1

### Step 1 - Synthesis of intermediate compound

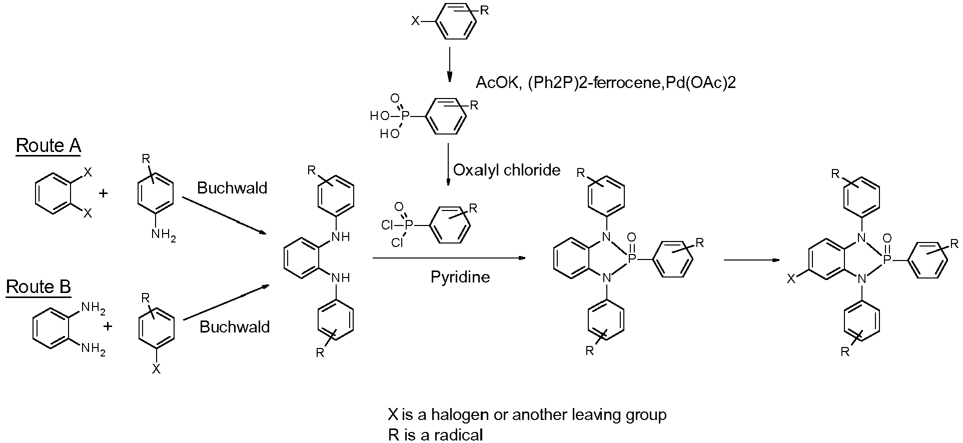

### Step 2 - Synthesis of final compound

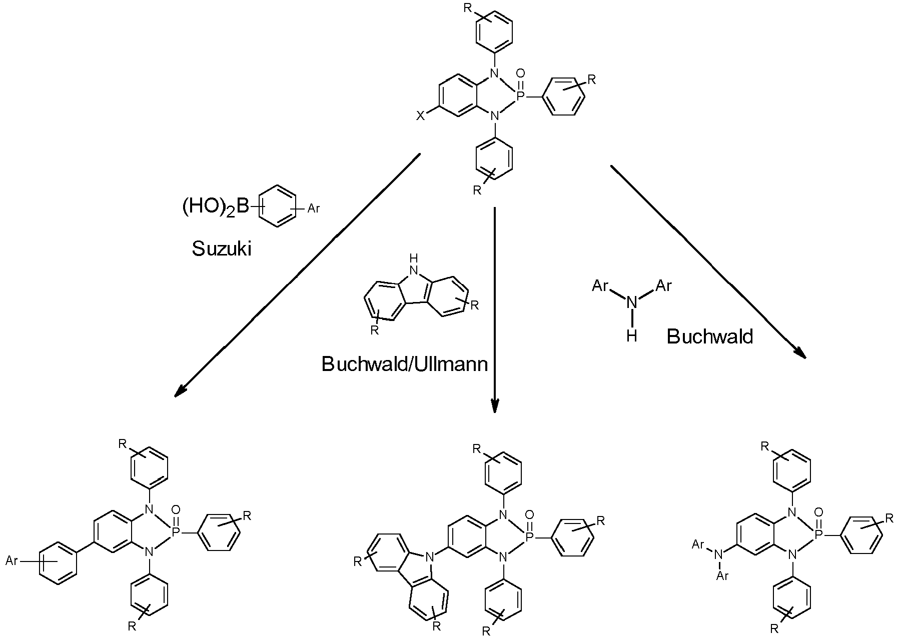

The compounds of formula (1) may be synthesized as described above. In a first step, a diazaphosphole intermediate compound comprising a leaving group (such as chlorine, bromine, iodine, tosylate, triflate, boronic acid or boronic acid ester) is synthesized. In a second step, the intermediate compound is functionalized by connecting an aromatic or heteroaromatic ring system to the phenyl ring condensed on the diazaphosphole moiety of the intermediate compound via a C-C coupling (for example a Suzuki coupling). Alternatively, the intermediate compounds are functionalized by connecting an arylamino group to the phenyl ring condensed on the diazaphosphole moiety of the intermediate compound via a C-N coupling (for example a Buchwald coupling).
Alternatively, the intermediate compounds are functionalized by connecting a carbazole derivative via the nitrogen atom to the phenyl ring condensed on the diazaphosphole moiety of the intermediate compound via a C-N coupling (for example a Buchwald or Ullmann coupling).

The present invention therefore furthermore relates to a process for the synthesis of the compounds according to the invention, starting from a diazaphosphole derivative, in which a group selected from an aromatic or heteroaromatic ring system, an arylamino group or a carbazole derivative is connected to the phenyl ring condensed on the diazaphosphole moiety of diazaphosphole derivative via a C-N or a C-C coupling.

The C-N coupling reaction is preferably a Ullmann or Buchwald reaction and the C-C coupling reaction is preferably a Suzuki coupling reaction.

For the processing of the compounds according to the invention from the liquid phase, for example by spin coating or by printing processes, formulations of the compounds according to the invention are necessary. These formulations can be, for example, solutions, dispersions or emulsions. It may be preferred to use mixtures of two or more solvents for this purpose. Suitable and preferred solvents are, for example, toluene, anisole, o-, m- or p-xylene, methyl benzoate, mesitylene, tetralin, veratrol, THF, methyl-THF, THP, chlorobenzene, dioxane, phenoxytoluene, in particular 3-phenoxytoluene, (-)-fenchone, 1,2,3,5-tetramethylbenzene, 1,2,4,5-tetramethylbenzene, 1-methylnaphthalene, 2-methylbenzothiazole, 2-phenoxyethanol, 2-pyrrolidinone, 3-methylanisole, 4-methylanisole, 3,4-dimethylanisole, 3,5-dimethylanisole, acetophenone, α-terpineol, benzothiazole, butyl benzoate, cumene, cyclohexanol, cyclohexanone, cyclohexylbenzene, decalin, dodecylbenzene, ethyl benzoate, indane, methyl benzoate, NMP, p-cymene, phenetole, 1,4-diisopropylbenzene, dibenzyl ether, diethylene glycol butyl methyl ether, triethylene glycol butyl methyl ether, diethylene glycol dibutyl ether, triethylene glycol dimethyl ether, diethylene glycol - monobutyl ether, tripropylene glycol dimethyl ether, tetraethylene glycol dimethyl ether, 2-isopropylnaphthalene, pentylbenzene, hexylbenzene, heptylbenzene, octylbenzene, 1,1-bis(3,4-dimethylphenyl)ethane or mixtures of these solvents.

The present invention therefore furthermore relates to a formulation comprising a compound according to the invention and at least one further compound. The further compound may be, for example, a solvent, in particular one of the above-mentioned solvents or a mixture of these solvents. However, the further compound may also be at least one further organic or inorganic compound which is likewise employed in the electronic device, for example an emitting compound, in particular a phosphorescent dopant, and/or a further matrix material. Suitable emitting compounds and further matrix materials are indicated below in connection with the organic electroluminescent device. This further compound may also be polymeric.

The compounds and mixtures according to the invention are suitable for use in an electronic device. An electronic device here is taken to mean a device which comprises at least one layer which comprises at least one organic compound. However, the component here may also comprise inorganic materials or also layers built up entirely from inorganic materials.

The present invention therefore furthermore relates to the use of the compounds or mixtures according to the invention in an electronic device, in particular in an organic electroluminescent device.

The present invention again furthermore relates to an electronic device comprising at least one of the compounds or mixtures according to the invention mentioned above. The preferences stated above for the compound also apply to the electronic devices.

The electronic device is preferably selected from the group consisting of organic electroluminescent devices (OLEDs, PLEDs), organic integrated circuits (O-ICs), organic field-effect transistors (O-FETs), organic thin-film transistors (O-TFTs), organic light-emitting transistors (O-LETs), organic solar cells (O-SCs), organic dye-sensitised solar cells, organic optical detectors, organic photoreceptors, organic field-quench devices (O-FQDs), light-emitting electrochemical cells (LECs), organic laser diodes (O-lasers) and "organic plasmon emitting devices" (D. M. Koller et al., Nature Photonics 2008, 1-4), preferably organic electroluminescent devices (OLEDs, PLEDs), in particular phosphorescent OLEDs.

The organic electroluminescent device comprises a cathode, an anode and at least one emitting layer. Apart from these layers, it may also comprise further layers, for example in each case one or more hole-injection layers, hole-transport layers, hole-blocking layers, electron-transport layers, electron-injection layers, exciton-blocking layers, electron-blocking layers and/or charge-generation layers. It is likewise possible for interlayers, which have, for example, an exciton-blocking function, to be introduced between two emitting layers. However, it should be pointed out that each of these layers does not necessarily have to be present. The organic electroluminescent device here may comprise one emitting layer or a plurality of emitting layers. If a plurality of emission layers are present, these preferably have in total a plurality of emission maxima between 380 nm and 750 nm, resulting overall in white emission, i.e. various emitting compounds which are able to fluoresce or phosphoresce are used in the emitting layers. Particular preference is given to systems having three emitting layers, where the three layers exhibit blue, green and orange or red emission (for the basic structure see, for example, WO 2005/011013). These can be fluorescent or phosphorescent emission layers or hybrid systems, in which fluorescent and phosphorescent emission layers are combined with one another.

The compound according to the invention in accordance with the embodiments indicated above can be employed in various layers, depending on the precise structure. Preference is given to an organic electroluminescent device comprising a compound of the formula (1) or in accordance with the preferred embodiments as matrix material for fluorescent emitters, phosphorescent emitters or emitters showing TADF (Thermally Activated Delayed Fluorescence), in particular for phosphorescent emitters, and/or in an electron-transport layer and/or in an electron-blocking or exciton-blocking layer and/or in a hole-transport layer, depending on the precise substitution. The preferred embodiments indicated above also apply to the use of the materials in organic electronic devices.

In a preferred embodiment of the invention, the compound of the formula (1) or in accordance with the preferred embodiments is employed as matrix material for a fluorescent or phosphorescent compound, in particular for a phosphorescent compound, in an emitting layer. The organic electroluminescent device here may comprise one emitting layer or a plurality of emitting layers, where at least one emitting layer comprises at least one compound according to the invention as matrix material.

If the compound of the formula (1) or in accordance with the preferred embodiments is employed as matrix material for an emitting compound in an emitting layer, it is preferably employed in combination with one or more phosphorescent materials (triplet emitters). Phosphorescence in the sense of this invention is taken to mean the luminescence from an excited state having spin multiplicity > 1, in particular from an excited triplet state. For the purposes of this application, all luminescent transition-metal complexes and luminescent lanthanide complexes, in particular all iridium, platinum and copper complexes, are to be regarded as phosphorescent compounds.

The mixture comprising the compound of the formula (1) or in accordance with the preferred embodiments and the emitting compound comprises between 99 and 1% by vol., preferably between 98 and 10% by vol., particularly preferably between 97 and 60% by vol., in particular between 95 and 80% by vol., of the compound of the formula (1) or in accordance with the preferred embodiments, based on the entire mixture comprising emitter and matrix material. Correspondingly, the mixture comprises between 1 and 99% by vol., preferably between 2 and 90% by vol., particularly preferably between 3 and 40% by vol., in particular between 5 and 20% by vol., of the emitter, based on the entire mixture comprising emitter and matrix material.

A further preferred embodiment of the present invention is the use of the compound of the formula (1) or in accordance with the preferred embodiments as matrix material for a phosphorescent emitter in combination with a further matrix material. Particularly suitable matrix materials which can be employed in combination with the compounds of the formula (1) or in accordance with the preferred embodiments are aromatic ketones, aromatic phosphine oxides or aromatic sulfoxides or sulfones, for example in accordance with WO 2004/013080, WO 2004/093207, WO 2006/005627 or WO 2010/006680, triarylamines, carbazole derivatives, for example CBP (N,N-biscarbazolylbiphenyl) or the carbazole derivatives disclosed in WO 2005/039246, US 2005/0069729, JP 2004/288381, EP 1205527 or WO 2008/086851, indolocarbazole derivatives, for example in accordance with WO 2007/063754 or WO 2008/056746, indenocarbazole derivatives, for example in accordance with WO 2010/136109 and WO 2011/000455, azacarbazole derivatives, for example in accordance with EP 1617710, EP 1617711, EP 1731584, JP 2005/347160, bipolar matrix materials, for example in accordance with WO 2007/137725, silanes, for example in accordance with WO 005/111172, azaboroles or boronic esters, for example in accordance with WO 2006/117052, triazine derivatives, for example in accordance with WO 2010/015306, WO 2007/063754 or WO 2008/056746, zinc complexes, for example in accordance with EP 652273 or WO 2009/062578, diazasilole or tetraazasilole derivatives, for example in accordance with WO 2010/054729, diazaphosphole derivatives, for example in accordance with WO 2010/054730, bridged carbazole derivatives, for example in accordance with US 2009/0136779, WO 2010/050778, WO 2011/042107, WO 2011/088877 or in accordance with EP 11003232.3, triphenylene derivatives, for example in accordance with WO 2012/048781, or lactams, for example in accordance with WO 2011/116865 or WO 2011/137951. A further phosphorescent emitter which emits at shorter wavelength than the actual emitter may likewise be present in the mixture as co-host.

Preferred co-host materials are triarylamine derivatives, in particular monoamines, lactams, carbazole derivatives and indenocarbazole derivatives.

Suitable phosphorescent compounds (= triplet emitters) are, in particular, compounds which emit light, preferably in the visible region, on suitable excitation and in addition contain at least one atom having an atomic number greater than 20, preferably greater than 38 and less than 84, particularly preferably greater than 56 and less than 80, in particular a metal having this atomic number. The phosphorescent emitters used are preferably compounds which contain copper, molybdenum, tungsten, rhenium, ruthenium, osmium, rhodium, iridium, palladium, platinum, silver, gold or europium, in particular compounds which contain iridium or platinum. For the purposes of the present invention, all luminescent compounds which contain the above-mentioned metals are regarded as phosphorescent compounds.

Examples of the emitters described above are revealed by the applications WO 00/70655, WO 2001/41512, WO 2002/02714, WO 2002/15645, EP 1191613, EP 1191612, EP 1191614, WO 05/033244, WO 05/019373, US 2005/0258742, WO 2009/146770, WO 2010/015307, WO 2010/031485, WO 2010/054731, WO 2010/054728, WO 2010/086089, WO 2010/099852, WO 2010/102709, WO 2011/032626, WO 2011/066898, WO 2011/157339, WO 2012/007086, WO 2014/008982, WO 2014/023377, WO 2014/094962, WO 2014/094961, WO 2014/094960 or WO 2016/124304. In general, all phosphorescent complexes as used in accordance with the prior art for phosphorescent OLEDs and as are known to the person skilled in the art in the area of organic electroluminescence are suitable, and the person skilled in the art will be able to use further phosphorescent complexes without inventive step.

In a further embodiment of the invention, the organic electroluminescent device according to the invention does not comprise a separate hole-injection layer and/or hole-transport layer and/or hole-blocking layer and/or electron-transport layer, i.e. the emitting layer is directly adjacent to the hole-injection layer or the anode, and/or the emitting layer is directly adjacent to the electron-transport layer or the electron-injection layer or the cathode, as described, for example, in WO 2005/053051. It is furthermore possible to use a metal complex which is identical or similar to the metal complex in the emitting layer as hole-transport or hole-injection material directly adjacent to the emitting layer, as described, for example, in WO 2009/030981.

It is furthermore possible to employ the compounds according to the invention in a hole-blocking or electron-transport layer. This applies, in particular, to compounds according to the invention which do not have a carbazole structure. These may preferably also be substituted by one or more further electron-transporting groups, for example benzimidazole groups.

In the further layers of the organic electroluminescent device according to the invention, it is possible to use all materials as usually employed in accordance with the prior art. The person skilled in the art will therefore be able, without inventive step, to employ all materials known for organic electroluminescent devices in combination with the compounds of the formula (1) or in accordance with the preferred embodiments.

Preference is furthermore given to an organic electroluminescent device, characterised in that one or more layers are applied by means of a sublimation process, in which the materials are vapour-deposited in vacuum sublimation units at an initial pressure of less than 10⁻⁵ mbar, preferably less than 10⁻⁶ mbar. However, it is also possible for the initial pressure to be even lower or higher, for example less than 10⁻⁷ mbar.

Preference is likewise given to an organic electroluminescent device, characterised in that one or more layers are applied by means of the OVPD (organic vapour phase deposition) process or with the aid of carrier-gas sublimation, in which the materials are applied at a pressure between 10⁻⁵ mbar and 1 bar. A special case of this process is the OVJP (organic vapour jet printing) process, in which the materials are applied directly through a nozzle and thus structured (for example M. S. Arnold et al., Appl. Phys. Lett. 2008, 92, 053301).

Preference is furthermore given to an organic electroluminescent device, characterised in that one or more layers are produced from solution, such as, for example, by spin coating, or by means of any desired printing process, such as, for example, ink-jet printing, LITI (light induced thermal imaging, thermal transfer printing), screen printing, flexographic printing, offset printing or nozzle printing. Soluble compounds, which are obtained, for example, by suitable substitution, are necessary for this purpose.

Also possible are hybrid processes, in which, for example, one or more layers are applied from solution and one or more further layers are applied by vapour deposition. Thus, it is possible, for example, to apply the emitting layer from solution and to apply the electron-transport layer by vapour deposition.

These processes are generally known to the person skilled in the art and can be applied by him without inventive step to organic electroluminescent devices comprising the compounds according to the invention.

The compounds according to the invention generally have very good properties on use in organic electroluminescent devices. In particular, the lifetime on use of the compounds according to the invention in organic electroluminescent devices is significantly better compared with similar compounds in accordance with the prior art. The other properties of the organic electroluminescent device, in particular the efficiency and the voltage, are likewise better or at least comparable. Furthermore, the compounds have a high glass transition temperature and high thermal stability.

The invention will now be explained in greater detail by the following examples, without wishing to restrict it thereby.

### A) Syntheses Examples

The following syntheses are carried out, unless indicated otherwise, under a protective-gas atmosphere in dried solvents. The solvents and reagents can be purchased, for example, from Sigma-ALDRICH or ABCR. The corresponding CAS numbers are also indicated in each case from the compounds known from the literature.

### Example A: Synthesis of phenylphosphoric acid

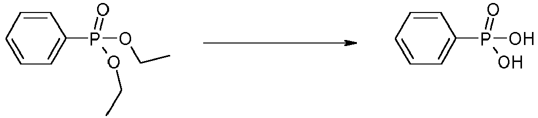

47.7 g (223 mmol) of benzophosphoric acid are dissolved in 250 ml of concentrated HCI. The mixture is heated during 12h at 100 ° C. After cooling, the solid is filtered and washed with some HCI and toluene and then dried. The product is then recrystallized from ethyl acetate/heptane 1: 4. Yield: 21 g (136 mmol), 62%.

The following compounds are prepared analogously:

| | ***Reactant 1*** | ***Product*** | ***Yield*** |
|---|---|---|---|
| A1 | 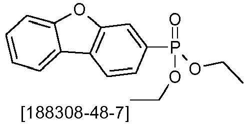 | 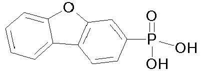 | 67% |
| A2 | 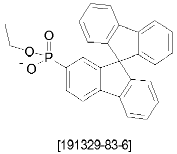 | 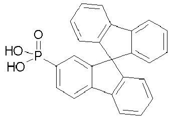 | 70% |
| A3 | 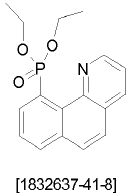 | 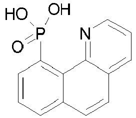 | 65% |
| A4 | 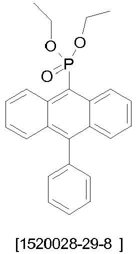 | 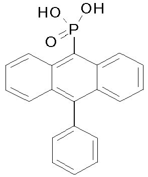 | 60% |
| A5 | 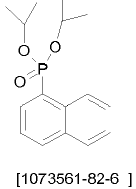 | 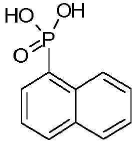 | 74% |
| A6 | 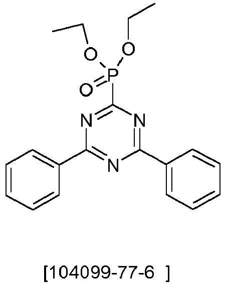 | 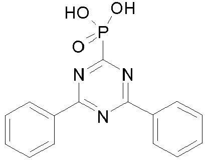 | 70% |

### Example B: Synthesis of phenylphosphoric dichloride

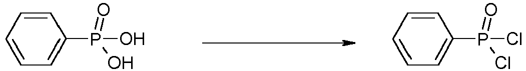

39 g (250 mmol) of phenylphosphoric acid are dissolved in 1500 ml of methylene chloride, in which 10 drops of DMF are added. Afterwards, 90 ml (1030 mmol) of oxalyl chloride are added dropwise at room temperature in 400 ml of methylene chloride and the mixture is then stirred at 45 ° C during 5 hours. The solvent is removed under vacuum and the product is recrystallized from hexane under a protective gas.
Yield: 46 g (239 mmol), 96%.

The following compounds are prepared analogously:

| | ***Reactant 1*** | ***Product*** | ***Yield*** |
|---|---|---|---|
| B1 | 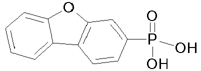 | 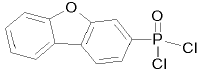 | 67% |
| B2 | 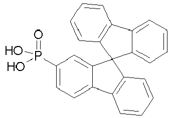 | 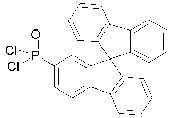 | 70% |
| B3 | 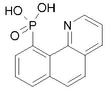 | 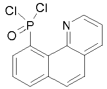 | 65% |
| B4 | 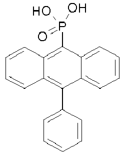 | 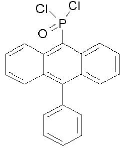 | 60% |
| B5 | 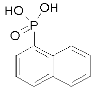 | 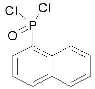 | 74% |
| B6 | 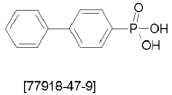 | 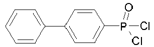 | 77% |
| B7 | 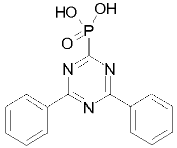 | 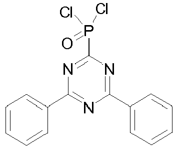 | 79% |

### Example C: General synthesis of N,N'-Diaryl-1,2-benzoldiamine

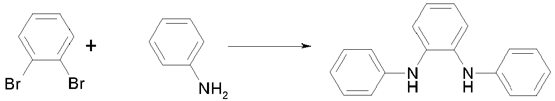

1.06 g (4.75 mmol) of Pd(OAc)₂ and 14.46 ml (14.46 mmol) of tri-tert-butylphosphine (1M solution in toluene) are added to 660 ml of degassed toluene and the mixture is stirred during 5 min. Then, 240 mmol of 1,2-dibromobenzene derivative, 505 mmol of the arylamine and 67.22 g (700 mmol) of sodium tert-butylate are added to the reaction mixture, which is degassed and then stirred at 140 °C during 10 h under an inert gas. After cooling, the solution is mixed with 600 ml of a NH₄Cl solution and 150 ml of ethyl acetate, the phases are separated, washed with water, dried over MgSO⁴ and concentrated. The solid is dissolved in toluene and filtered through Celite. The crude product is stirred with hot heptane. This gives 65 g (223 mmol) of a crystalline solid. The yield is 93%.

The following compounds are prepared analogously:

| | **Reactant 1** | **Reactant 2** | **Product** | **Yield** |
|---|---|---|---|---|
| C1 | 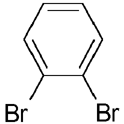 | 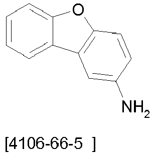 | 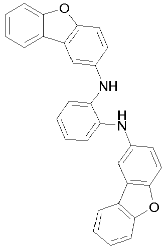 | 83% |
| C2 | 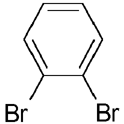 | 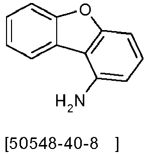 | 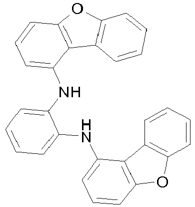 | 87% |
| C3 | 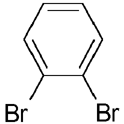 | 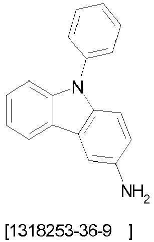 | 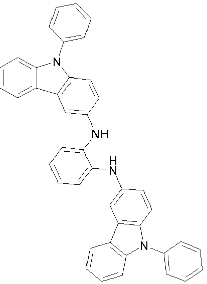 | 86% |
| C4 | 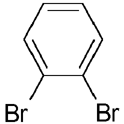 | 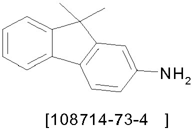 | 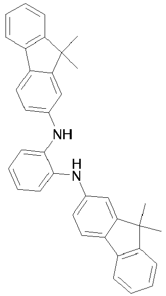 | 80% |
| C5 | 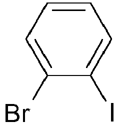 | 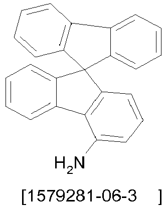 | 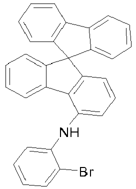 | 72% |
| C6 | 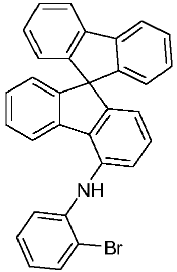 | 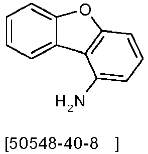 | 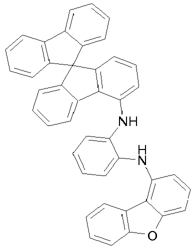 | 75% |

### Example D: Synthesis of N-biphenyl-4-yl-N'-phenyl-1,2-phenyldiamine

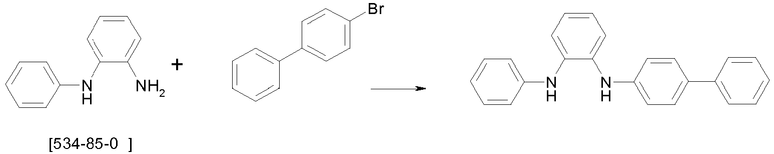

0.35 g (1.58 mmol) of Pd(OAc)₂ and 4.8 ml (4.86 mmol) of tri-tert-butylphosphine (1M solution in toluene) are added to 660 mL of degassed toluene and the mixture is stirred during 5 minutes. Then, the solution is treated with 37.2 g (160 mmol) 4-bromobiphenyl, 29,4g (160 mmol) of N-phenyl-o-phenylenediamine and 22.4 g (233 mmol) of sodium tert-butoxide, the mixture is then degassed and stirred under an inert gas at 140 °C for 10h. After cooling, the solution is mixed with 200 ml of a NH₄Cl solution and 50 ml of ethyl acetate, the phases are separated, washed with water, dried over MgSO₄ and concentrated. The solid is dissolved in toluene and filtered through Celite. The crude product is stirred with hot heptane and washed with MeOH. This gives 47 g (140 mmol) of a crystalline solid. The yield is 80%.

The following compounds are prepared analogously:

| | **Reactant 1** | **Reactant 2** | **Product** | **Yield** |
|---|---|---|---|---|
| D1 | 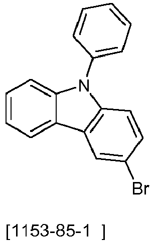 | 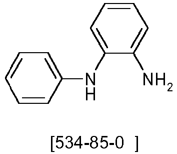 | 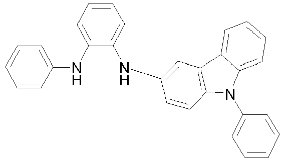 | 62% |
| D2 | 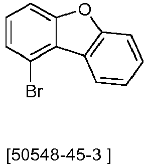 | 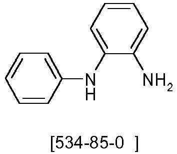 | 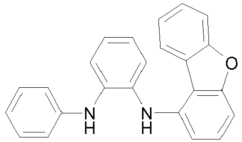 | 77% |
| D3 | 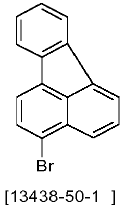 | 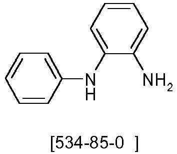 | 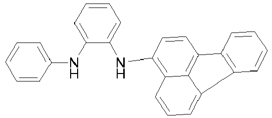 | 67% |
| D4 | 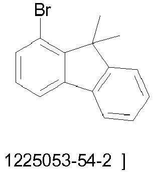 | 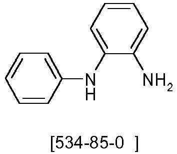 | 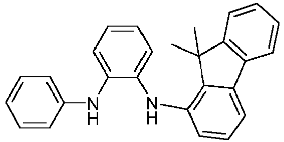 | 75% |
| D5 | 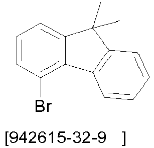 | 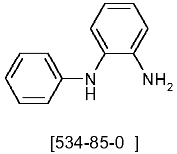 | 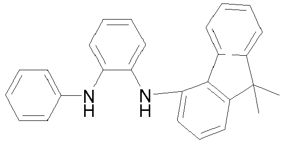 | 71% |
| D6 | 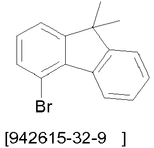 | 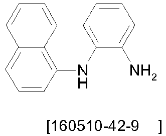 | 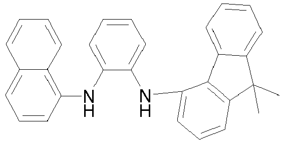 | 83% |
| D7 | 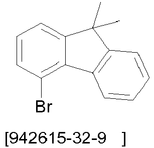 | 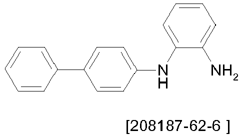 | 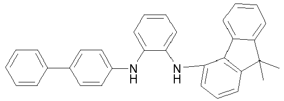 | 80% |
| D8 | 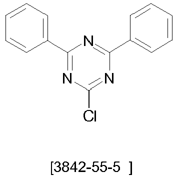 | 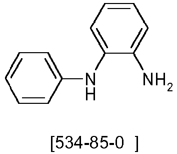 | 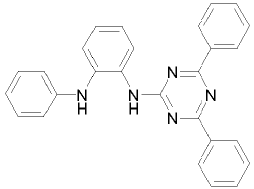 | 76% |
| D9 | 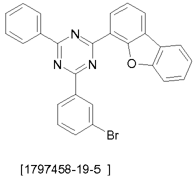 | 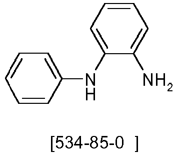 | 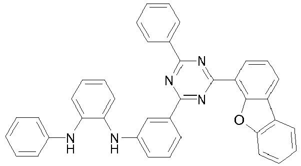 | 79% |
| D10 | 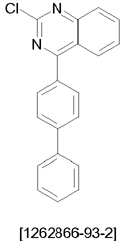 | 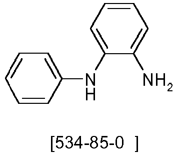 | 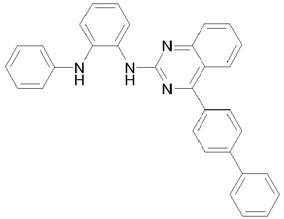 | 64% |

### Example E: Synthesis of 1,2,3-triphenyl-1,3-dihydro-benzo[1,3,2] diazaphosphole 2-oxide

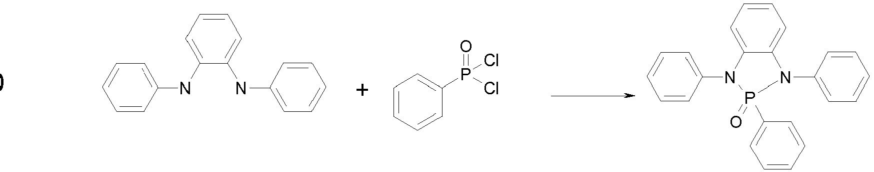

41 g (158 mmol) of N,N'-diaryl-1,2-phenyldiamine is dissolved in 500 ml of pyridine and cooled down to 0 °C. A solution comprising 30 g (158 mmol) of phenyl phosphoric dichloride dissolved in 1000 ml of toluene is added dropwise to the reaction mixture at 0°C. The mixture is stirred during 1 hour and then heated under reflux during 24 h. The solvent is evaporated under vacuum, the solid is boiled in ethyl acetate, filtered off, washed once with 100 ml acetic acid ester and then recrystallized from dioxane.
Yield: 41 g (106 mmol), 69%.

The following compounds are prepared analogously:

| | **Reactant 1** | **Reactant 2** | **Product** | **Yield** |
|---|---|---|---|---|
| E1 | 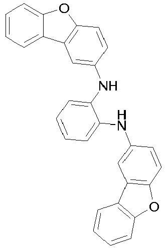 | 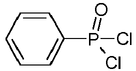 | 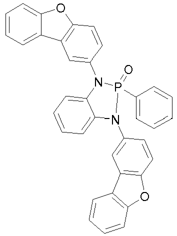 | 70% |
| E2 | 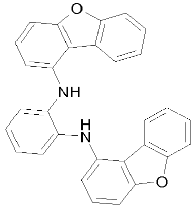 | 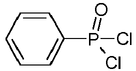 | 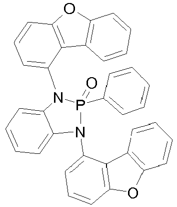 | 72% |
| E3 | 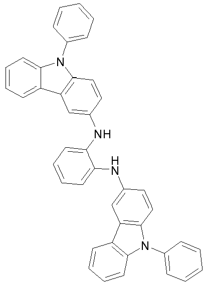 | 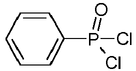 | 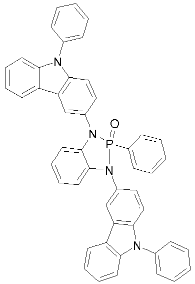 | 74% |
| E4 | 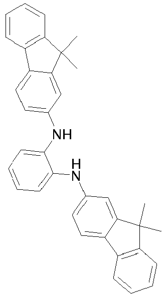 | 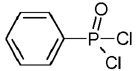 | 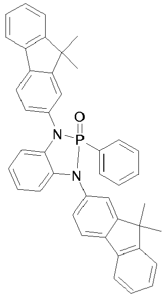 | 78% |
| E5 | 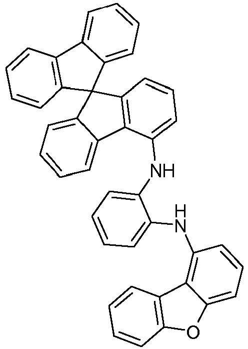 | 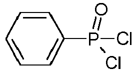 | 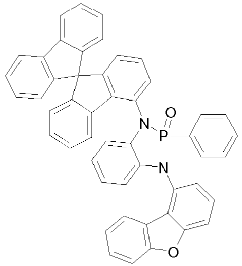 | 70% |
| E6 | 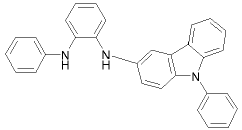 | 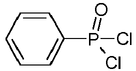 | 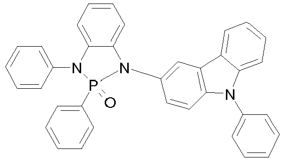 | 76% |
| E7 | 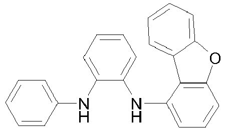 | 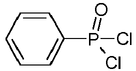 | 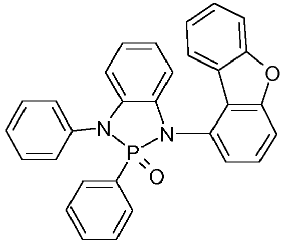 | 81% |
| E8 | 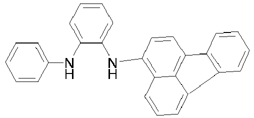 | 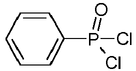 | 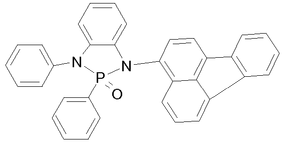 | 80% |
| E9 | 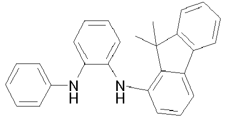 | 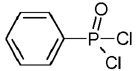 | 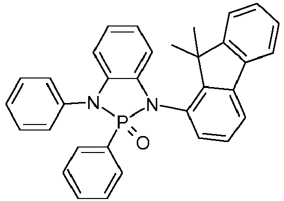 | 79% |
| E10 | 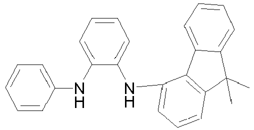 | 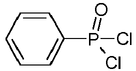 | 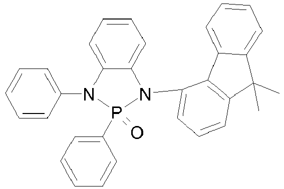 | 73% |
| E11 | 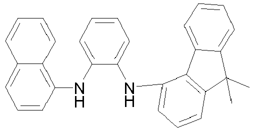 | 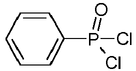 | 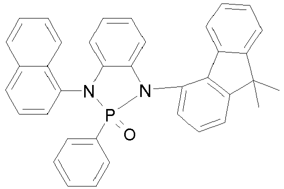 | 85% |
| E12 | 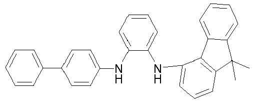 | 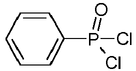 | 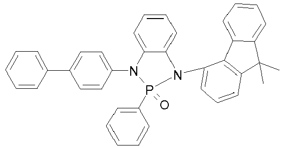 | 81% |
| E13 | 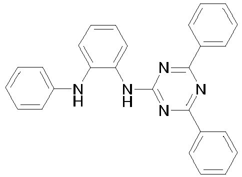 | 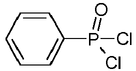 | 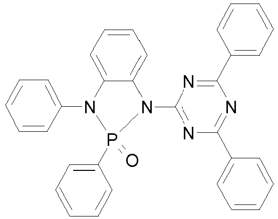 | 74% |
| E14 | 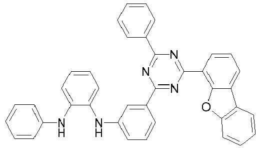 | 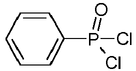 | 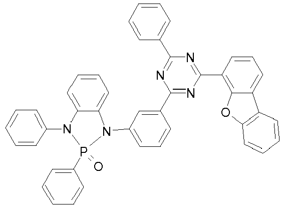 | 78% |
| E15 | 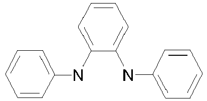 | 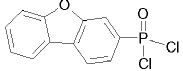 | 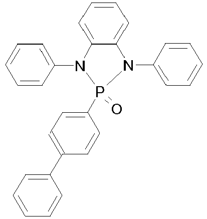 | 84% |
| E16 | 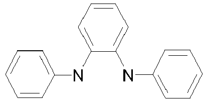 | 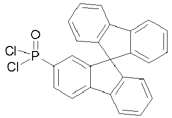 | 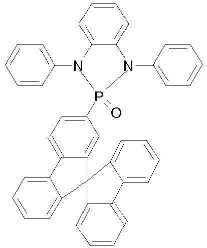 | 72% |
| E17 | 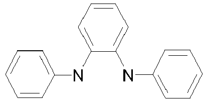 | 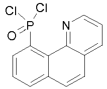 | 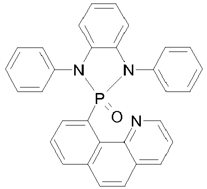 | 71% |
| E19 | 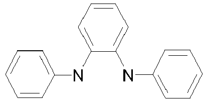 | 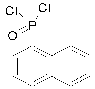 | 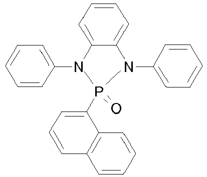 | 76% |
| E20 | 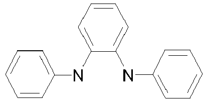 | 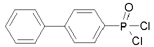 | 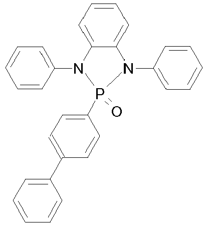 | 78% |
| E21 | 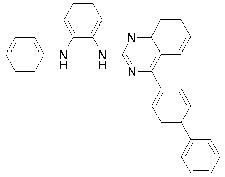 | 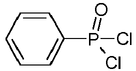 | 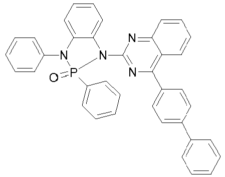 | 76% |
| E22 | 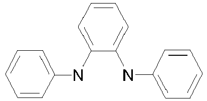 | 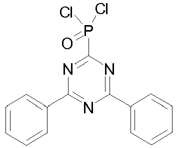 | 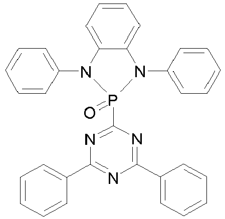 | 75% |

### Example F: Synthesis of 5-Bromo-1,2,3-triphenyl-1,3-dihydrobenzo[1,3,2]-diazaphosphole 2-oxide

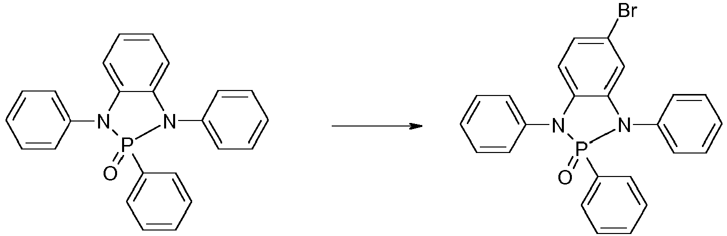

48 g (125 mmol) of 1,2,3-triphenyl-1,3-dihydro-benzo [1,3,2] diazaphosphole 2-oxide are suspended in 1000 ml of chloroform and mixed slowly with 48 g (275 mmol) of N-bromosuccinimide at room temperature. The mixture is then stirred during 16h. Afterwards, the reaction mixture is mixed with a solution of Na₂SO₄, the phases are then separated and evaporated. The product is dried, concentrated, and then recrystallized from dichloromethane to a purity of 99.0%. Yield: 52 g (113 mmol), 90% of the product as a white solid.

The following compounds are prepared analogously:

| | **Reactant 1** | **Product** | **Yield** |
|---|---|---|---|
| F1 | 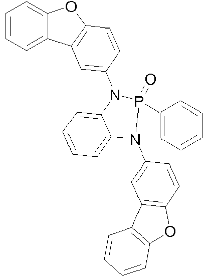 | 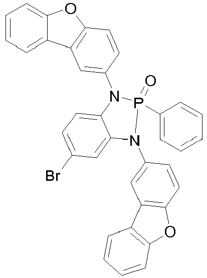 | 83% |
| F2 | 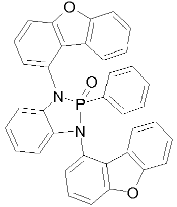 | 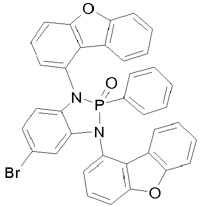 | 86% |
| F3 | 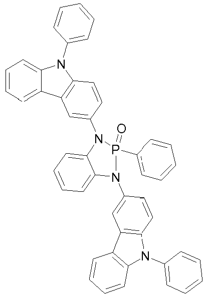 | 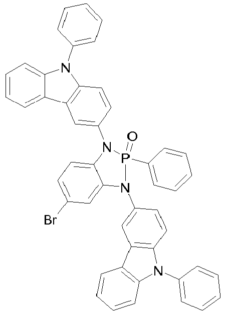 | 72% |
| F4 | 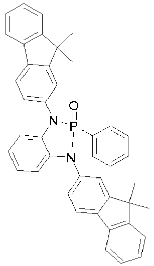 | 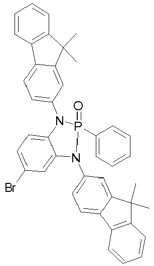 | 88% |
| F5 | 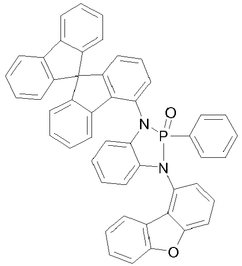 | 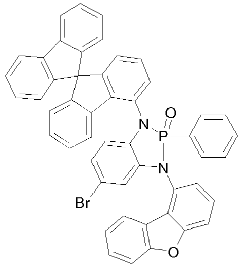 | 53% |
| F6 | 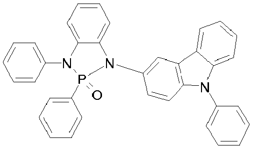 | 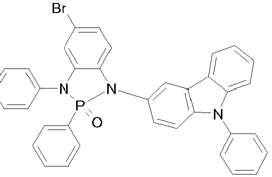 | 46% |
| F7 | 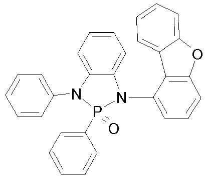 | 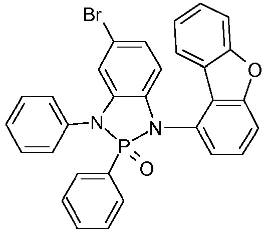 | 54% |
| F8 | 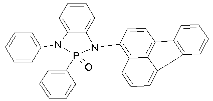 | 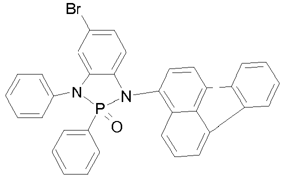 | 50% |
| F9 | 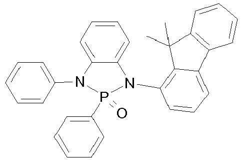 | 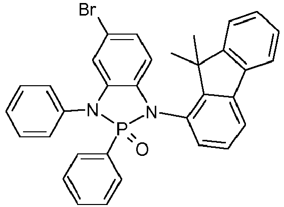 | 51% |
| F10 | 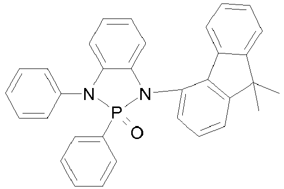 | 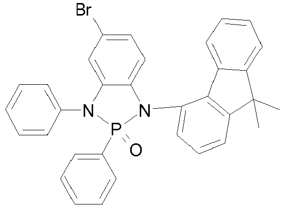 | 55% |
| F11 | 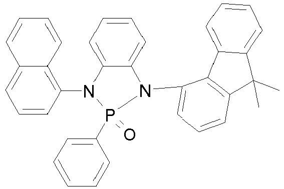 | 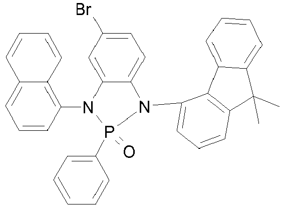 | 49% |
| F12 | 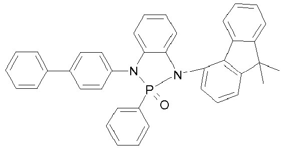 | 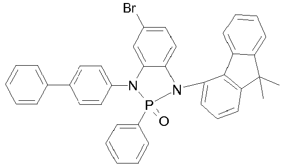 | 57% |
| F13 | 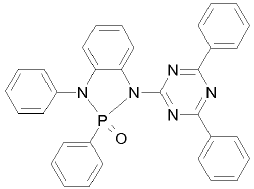 | 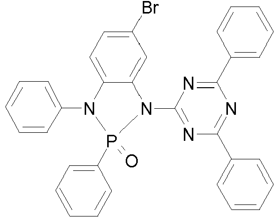 | 61% |
| F14 | 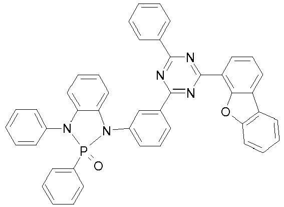 | 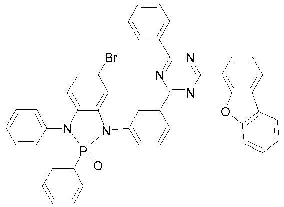 | 60% |
| F15 | 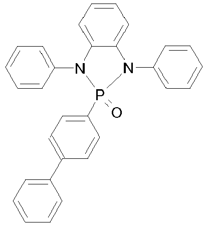 | 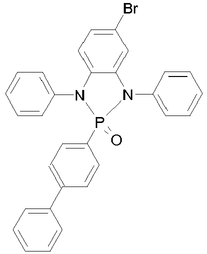 | 85% |
| F16 | 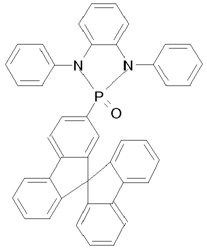 | 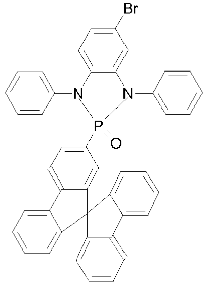 | 83% |
| F17 | 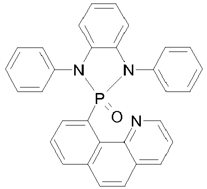 | 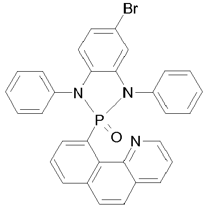 | 80% |
| F18 | 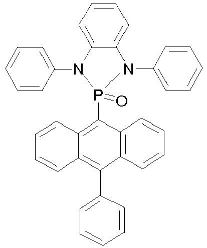 | 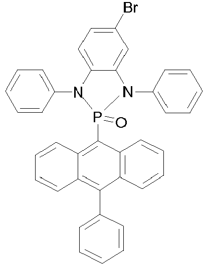 | 75% |
| F19 | 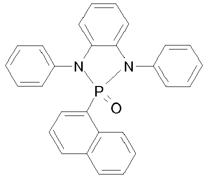 | 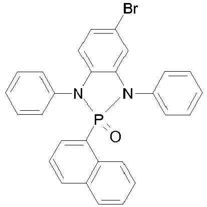 | 82% |
| F20 | 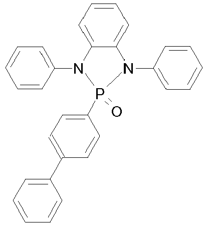 | 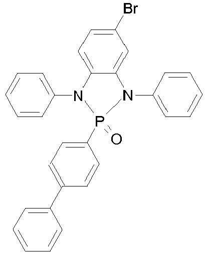 | 83% |
| F21 | 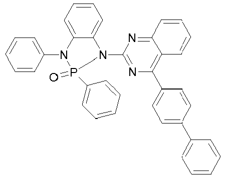 | 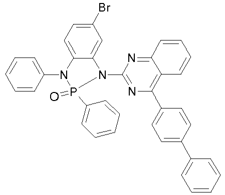 | 57% |
| F22 | 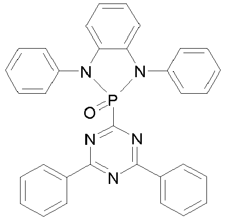 | 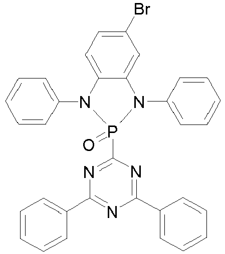 | 67% |

### Example G: Synthesis of 1,2,3-triphenyl-5-(4,4,5,5-tetramethyl-[1,3,2]dioxaborolan-2-yl)-1,3-dihydro-benzo[1,3,2]diazaphosphole 2-oxide

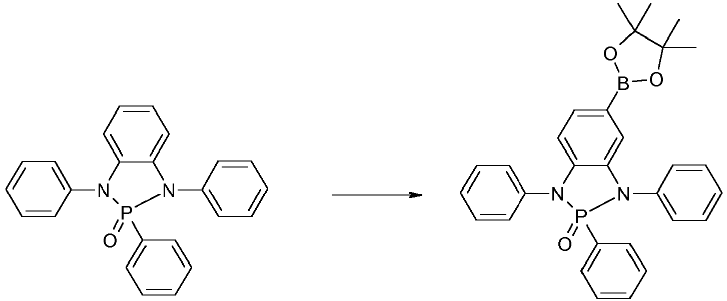

In a 2L four-necked flask, 50 g (105 mmol) of 5-bromo-1,2,3-triphenyl-1,3-dihydro-benzo [1,3,2]-diazaphosphole 2-oxide, 29.9 g (115 mmol) of bispinacolatodiborane (73183-34-3), 30.9 g (315 mmol) of potassium acetate and 2.25 g (3.1 mmol) of bis(triphenylphosphine)-palladium(II) chloride are mixed with 750 mL of anhydrous dioxane during 3 hours under reflux, until the reaction is complete. After cooling to room temperature, the organic phase is added to ethyl acetate and washed three times with 300 ml of water and dried with sodium sulfate. The combined organic phases are then concentrated by rotary evaporation until dryness. After recrystallization from heptane, the product is obtained as a solid. The yield is 49 g (96 mmol; 90%).

The following compounds are prepared analogously:

| | **Reactant 1** | **Product** | **Yield** |
|---|---|---|---|
| G1 | 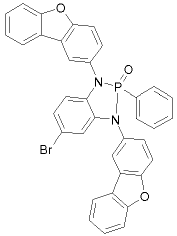 | 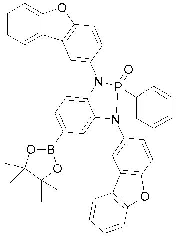 | 86% |
| G2 | 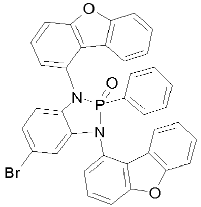 | 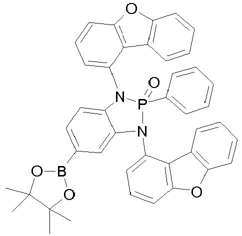 | 84% |
| G3 | 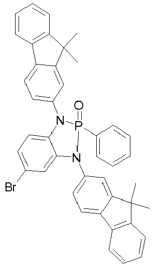 | 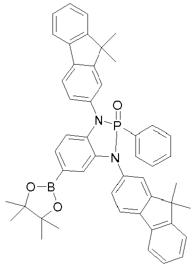 | 80% |

### Example H: Synthesis of 3-(2-oxo-1,2,3-triphenyl-2,3-dihydrobenzo[1,3,2]diazaphosphol-5-yl)-9-phenyl-9H-carbazole

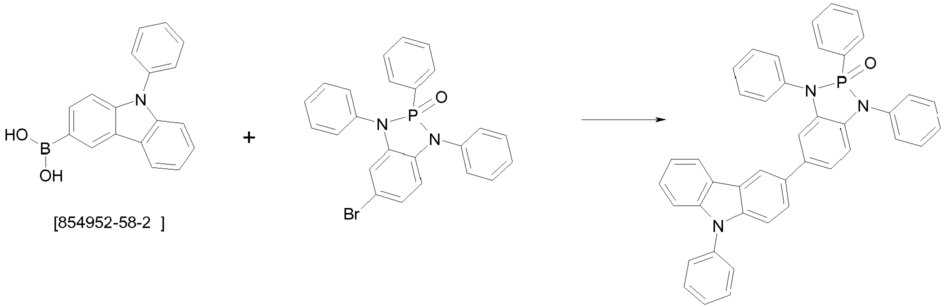

71.9 g (156 mmol) of 5-bromo-1,2,3-triphenyl-1,3-dihydro-benzo [1,3,2]-diazaphosphole 2-oxide, 50 g (172 mmol) of N-phenyl-carbazol-3-boronic acid and 36 g (340 mmol) of sodium carbonate are suspended in 1000 mL of ethylene glycol dimethyl ether and 280 mL of water. Then, 1.8 g (1.5 mmol) of tetrakis(triphenylphosphine)-palladium (0) are added to this suspension and the reaction mixture is heated under reflux during 16 h. After cooling, the organic phase is separated, filtered through silica gel, washed three times with 200 mL water and then concentrated to dryness. The product is purified via column chromatography on silica gel with toluene/heptane (1:2) and finally sublimated in high vacuum (p = 5 x 10⁻⁷ mbar) (purity 99.9%). The yield is 72 g (115 mmol), corresponding to 67% of theory.

The following compounds are prepared analogously:

| | **Reactant 1** | **Reactant 2** | **Product** | **Yield** |
|---|---|---|---|---|
| H1 | 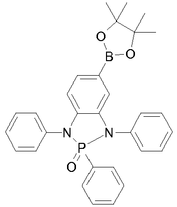 | 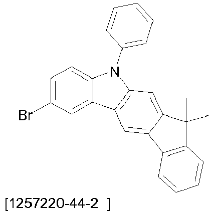 | 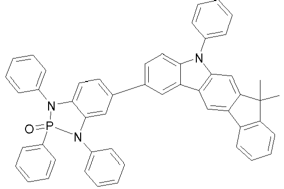 | 77% |
| H2 | 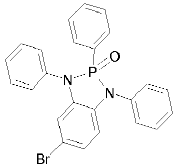 | 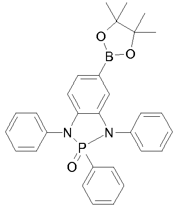 | 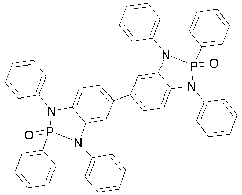 | 81% |
| H3 | 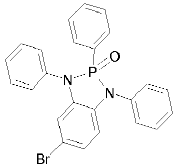 | 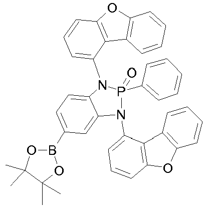 | 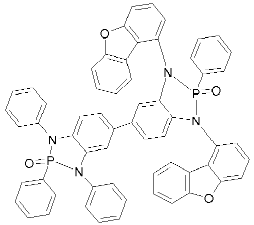 | 78% |
| H4 | 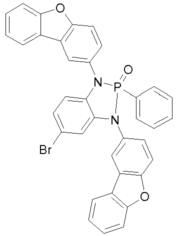 | 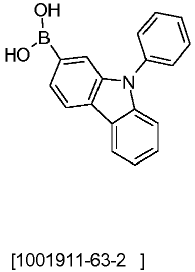 | 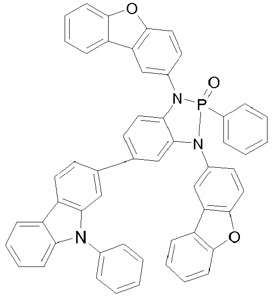 | 61% |
| H5 | 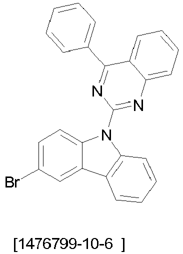 | 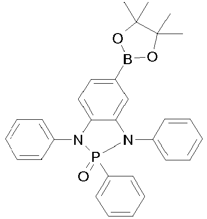 | 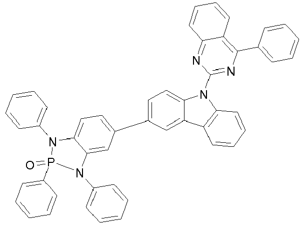 | 74% |
| H6 | 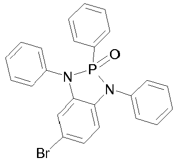 | 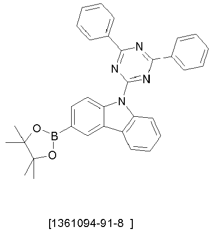 | 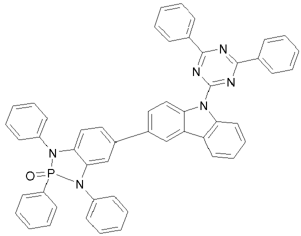 | 78% |
| H7 | 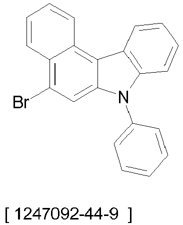 | 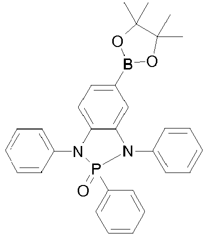 | 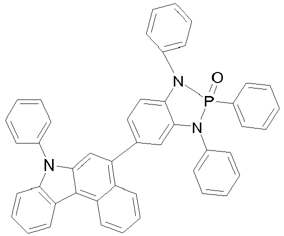 | 72% |
| H8 | 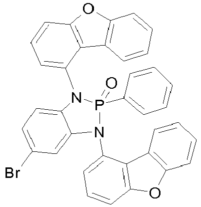 | 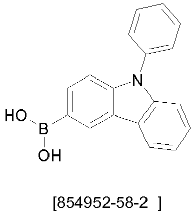 | 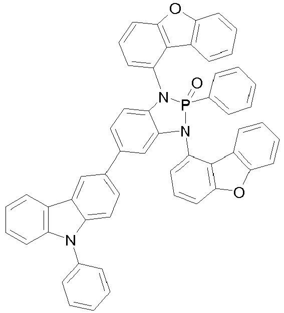 | 63% |
| H9 | 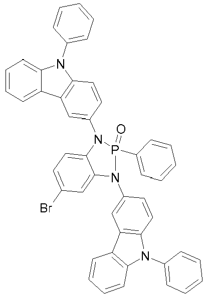 | 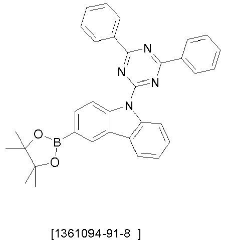 | 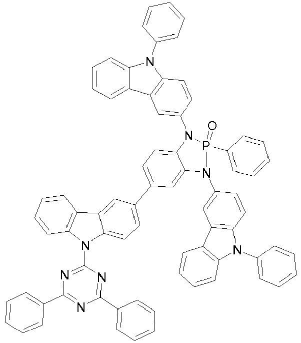 | 61% |
| H10 | 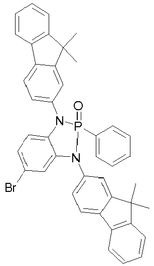 | 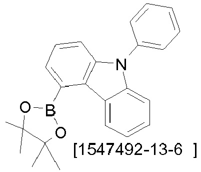 | 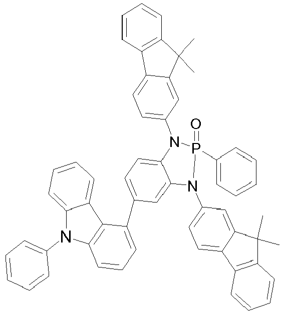 | 64% |
| H11 | 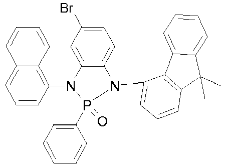 | 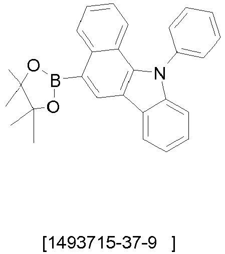 | 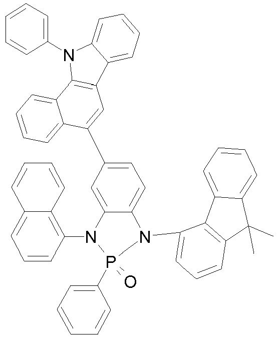 | 56% |
| H12 | 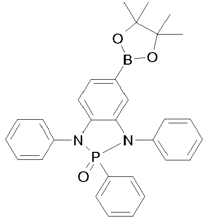 | 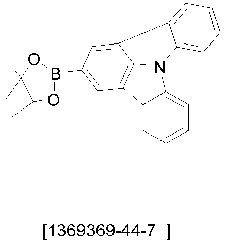 | 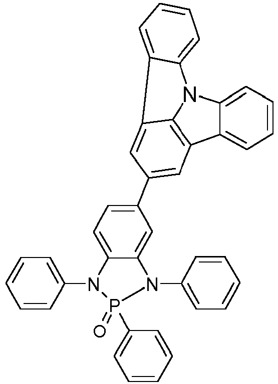 | 54% |
| H13 | 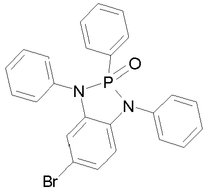 | 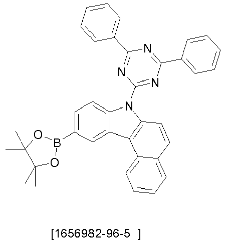 | 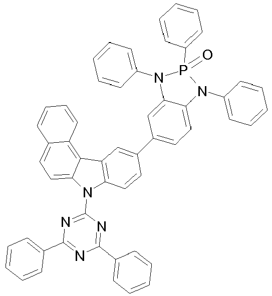 | 68% |
| H14 | 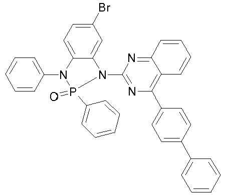 | 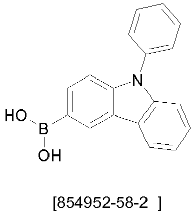 | 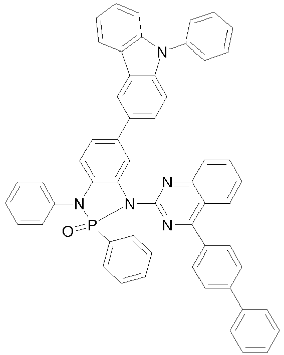 | 65% |
| H15 | 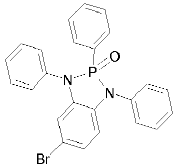 | 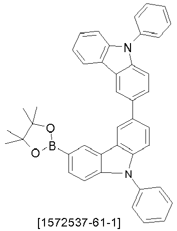 | 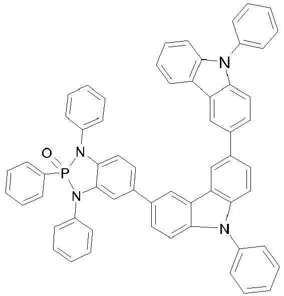 | 66% |
| H16 | 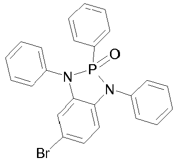 | 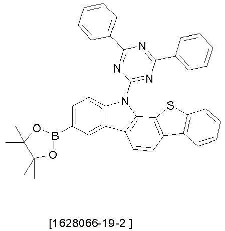 | 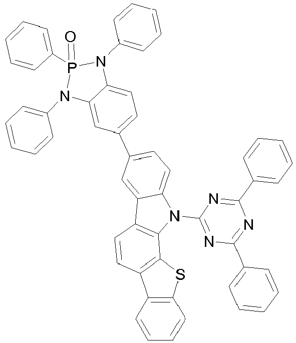 | 58% |
| H17 | 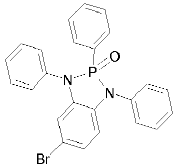 | 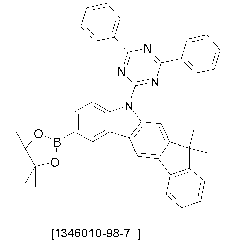 | 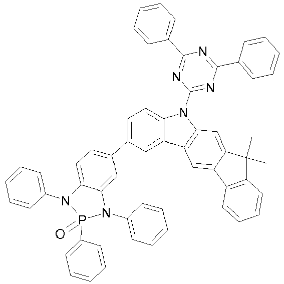 | 62% |
| H18 | 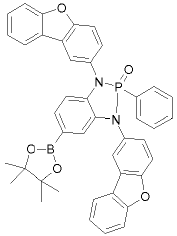 | 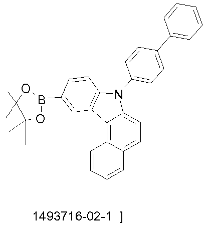 | 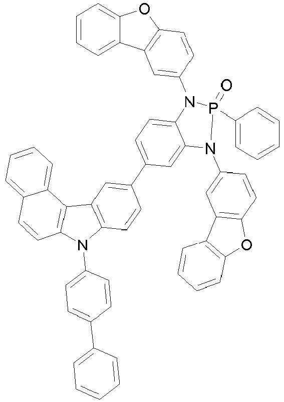 | 56% |
| H19 | 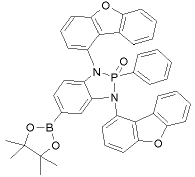 | 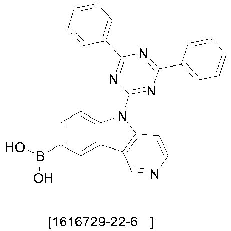 | 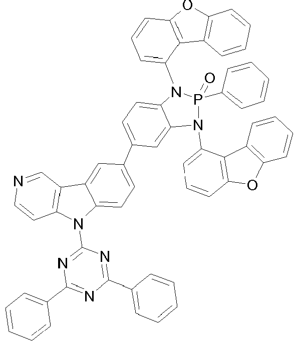 | 57% |
| H20 | 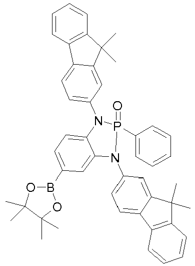 | 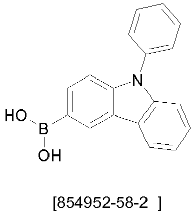 | 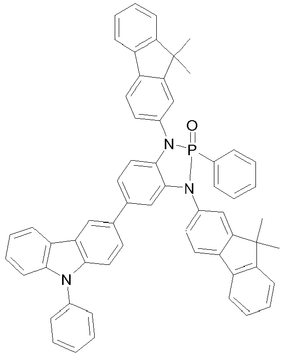 | 62% |
| H21 | 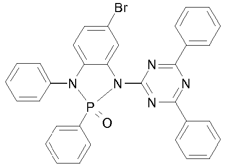 | 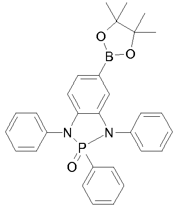 | 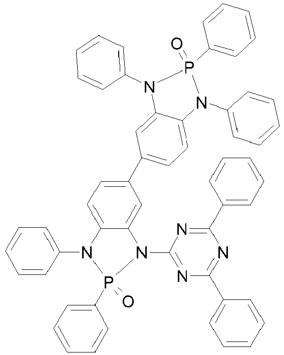 | 58% |
| H22 | 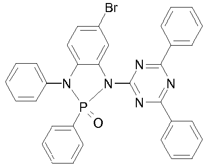 | 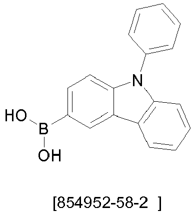 | 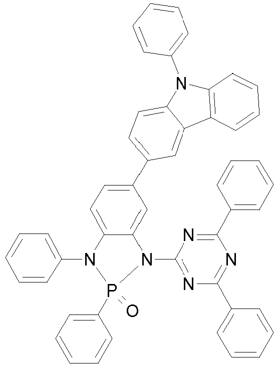 | 54% |
| H23 | 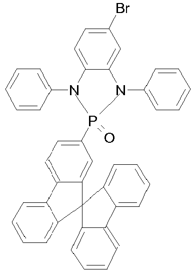 | 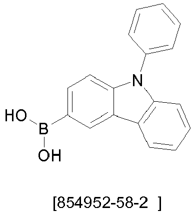 | 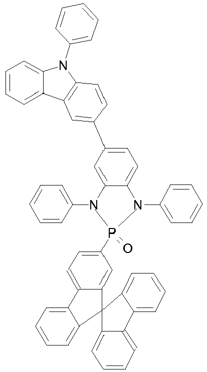 | 68% |
| H25 | 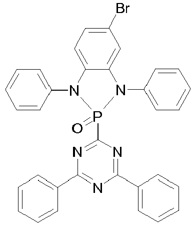 | 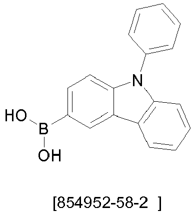 | 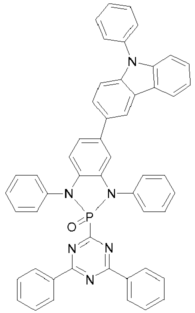 | 63% |
| H26 | 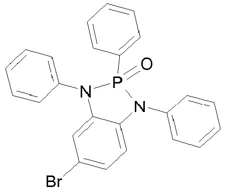 | 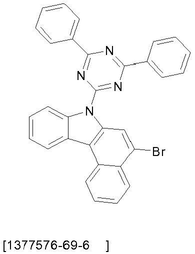 | 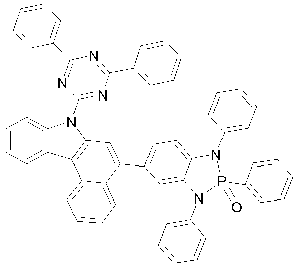 | 60% |
| H27 | 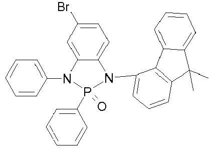 | 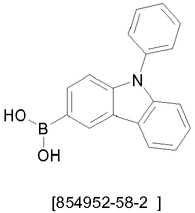 | 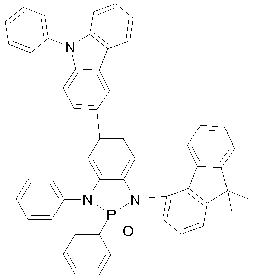 | 57% |
| H28 | 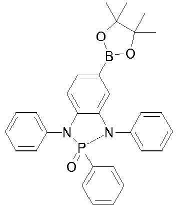 | 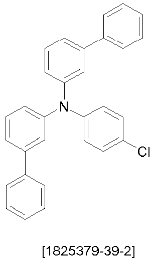 | 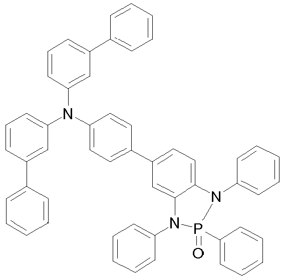 | 65% |
| H29 | 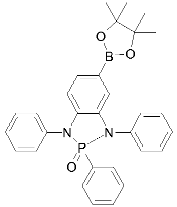 | 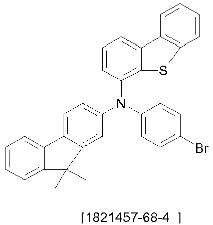 | 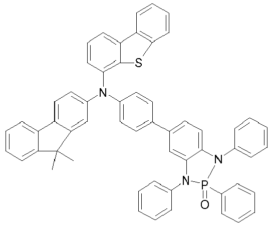 | 63% |
| H30 | 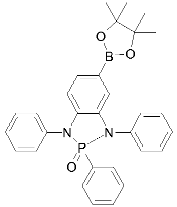 | 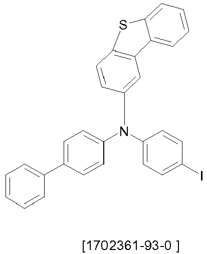 | 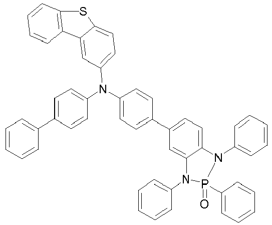 | 74% |
| H31 | 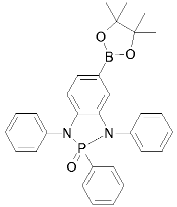 | 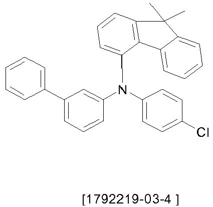 | 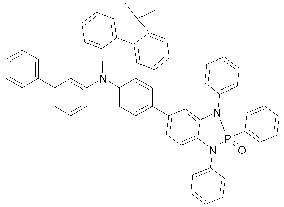 | 70% |
| H32 | 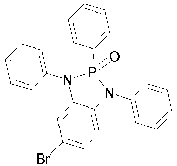 | 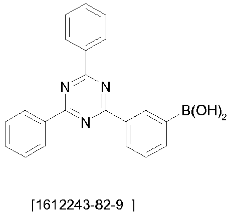 | 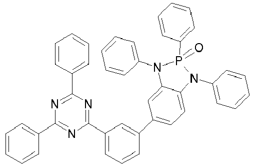 | 74% |
| H33 | 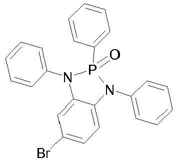 | 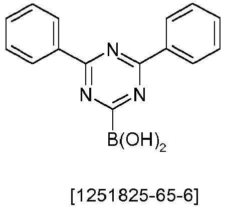 | 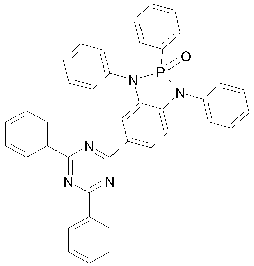 | 69% |
| H34 | 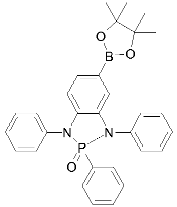 | 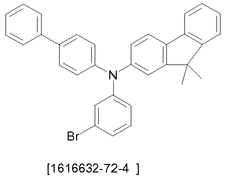 | 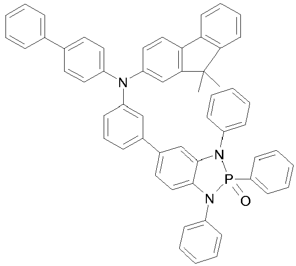 | 78% |
| H35 | 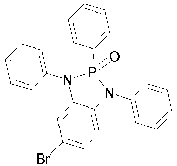 | 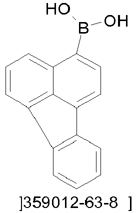 | 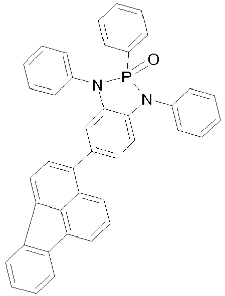 | 82% |
| H24 | 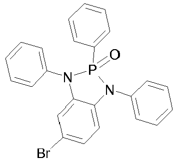 | 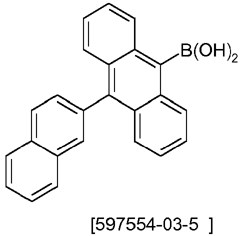 | 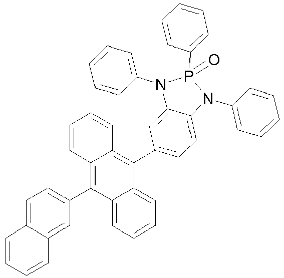 | 76% |
| H25 | 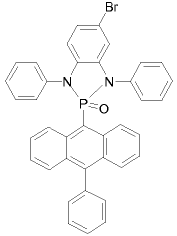 | 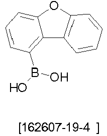 | 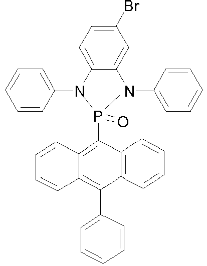 | 80% |

### Example I: Synthesis of 9-(2-oxo-1,2,3-triphenyl-2,3-dihydro-1H-benzo[1,3,2]diazaphosphol-5-yl)-3-phenyl-9H-carbazole

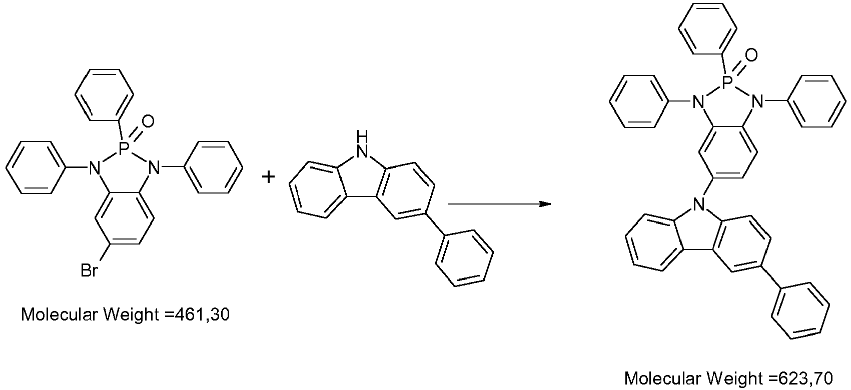

A degassed solution of 69 g (150 mmol) of 5-bromo-1,2,3-triphenyl-1,3-dihydro-benzo[1,3,2]-diazaphosphole 2-oxide and 36.5 g (150mmol) of 3-phenyl-9H-carbazole in 600 mL toluene is saturated with N₂ during 1h. Afterwards, this solution is mixed with 2.09 mL (8.6 mmol) of P(*t*Bu)₃, then with 1.38 g (6.1 mmol) of palladium(II)acetate and finally, 17.7g (185 mmol) of NaO*t*Bu in the solid state is added to the solution. The reaction mixture is heated under reflux during 1 h. After cooling to room temperature, 500 ml of water are carefully added to the reaction mixture. The aqueous phase is washed with 3x 50 ml of toluene, dried over MgSO₄ and the solvent removed under vacuum. Thereafter, the crude product is purified by chromatography on silica gel with heptane/acetic ester (20:1). The residue is recrystallized from toluene (5 x p = 10⁻⁶ mbar) and sublimated under high vacuum. The yield is 79 g (127mmol), corresponding to 85% of theory.

The following compounds are prepared analogously:

| | **Reactant 1** | **Reactant 2** | **Product** | **Yield** |
|---|---|---|---|---|
| I1 | 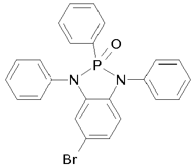 | 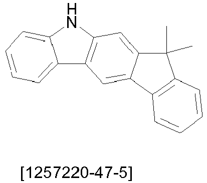 | 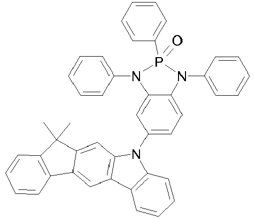 | 85% |
| I2 | 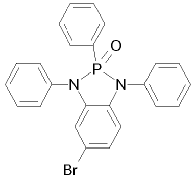 | 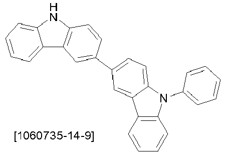 | 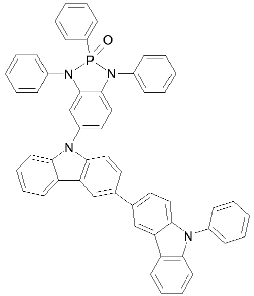 | 84% |
| I3 | 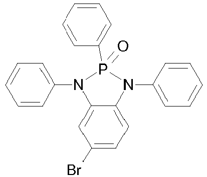 | 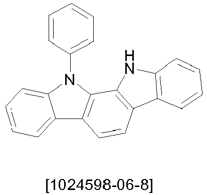 | 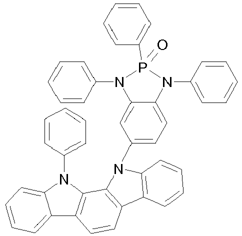 | 54% |
| I4 | 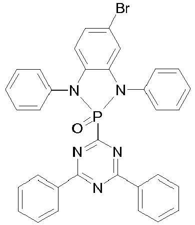 | 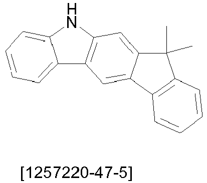 | 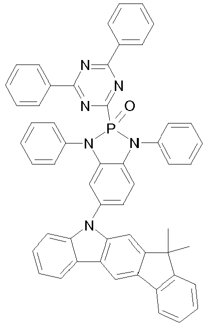 | 72% |
| I5 | 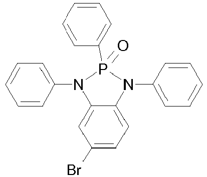 | 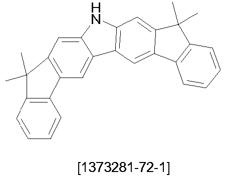 | 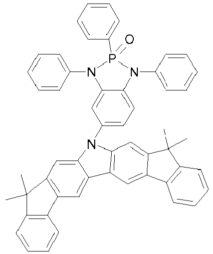 | 71% |
| I6 | 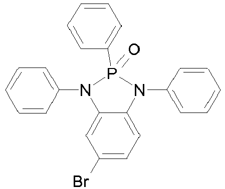 | 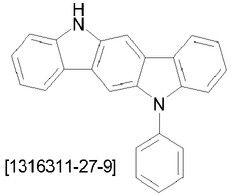 | 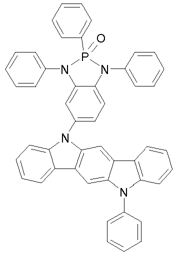 | 74% |
| I7 | 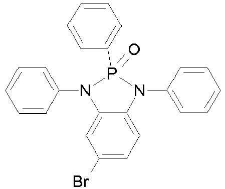 | 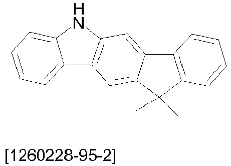 | 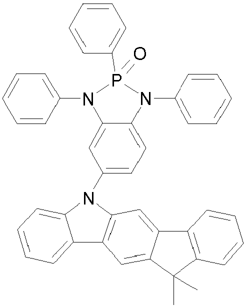 | 65% |
| I8 | 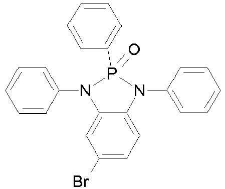 | 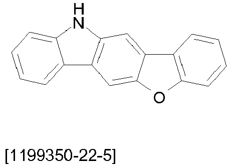 | 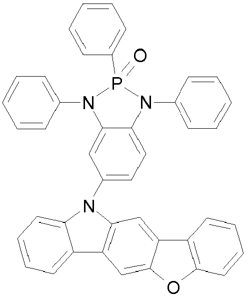 | 76% |
| I9 | 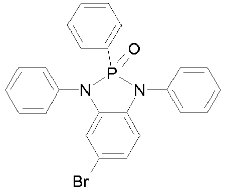 | 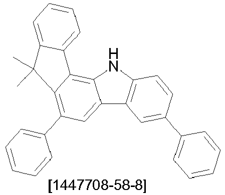 | 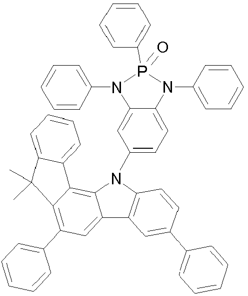 | 61% |
| I10 | 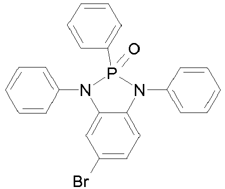 | 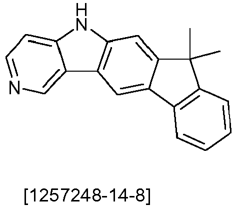 | 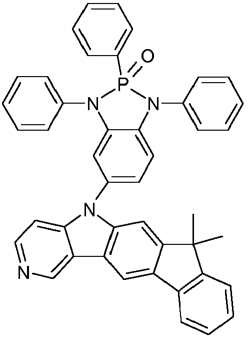 | 70% |
| I11 | 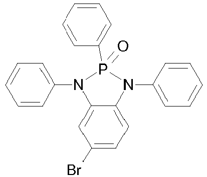 | 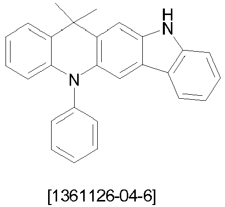 | 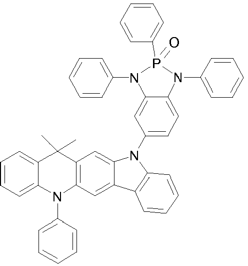 | 83% |
| I12 | 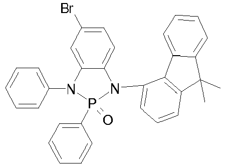 | 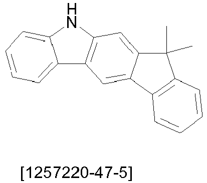 | 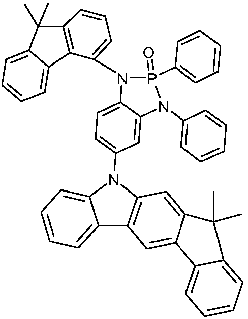 | 76% |

### Example J: Synthesis of Biphenyl-4-yl-(9,9-dimethyl-9H-fluoren-4-yl)-(2-oxo-1,2,3-triphenyl-2,3-dihydro-1H-benzo[1,3,2]diazaphosphol-5-yl)-amine

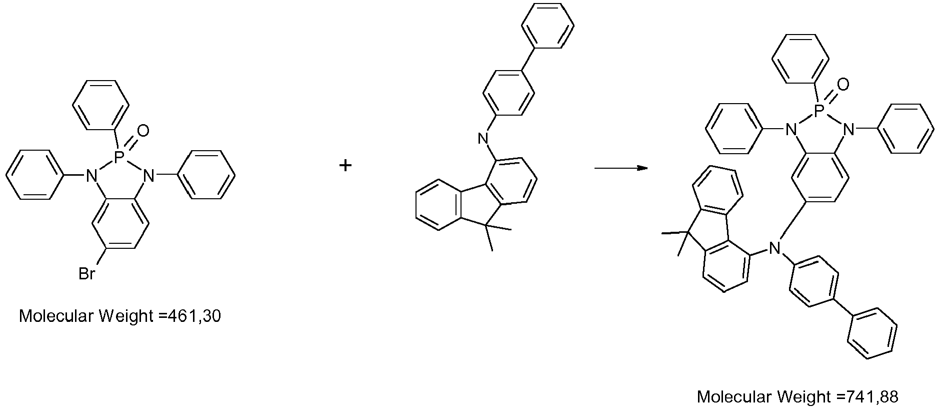

A mixture of 9.3 g (26 mmol) of biphenyl-4-yl-(9,9-dimethyl-9H-fluoren-4-yl) amine, 11.9 g (26 mmol) of 5-bromo-1,2,3-triphenyl-1,3-dihydro-benzo [1,3,2]-diazaphosphole 2-oxide, 7.7 g (80 mmol) of sodium tert-butylate, 2.6 ml (78 mmol) of tri-tert-butylphosphine (1M, toluene), 224 mg (2.6 mmol) of palladium(II)acetate and 300 ml of mesitylene are heated during 24h under reflux. After cooling, 200 ml of water are added to the mixture, which is stirred during 30 minutes. Then, the organic phase is separated, filtered on Celite and the solvent is removed in vacuum. The residue is recrystallized from DMF five times, and finally sublimated (p=10⁻⁶ mbar, T = 340-350 ° C). Yield: 13.8 g (18.6 mmol), 72% of theory: 99.9% after HPLC.

The following compounds are prepared analogously:

| | **Reactant 1** | **Reactant 2** | **Product** | **Yield** |
|---|---|---|---|---|
| J1 | 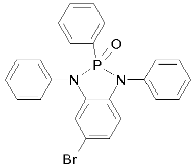 | 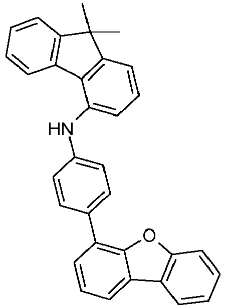 | 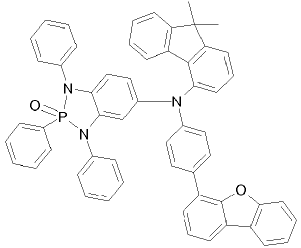 | 61% |
| J2 | 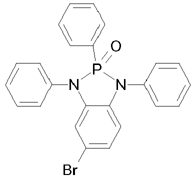 | 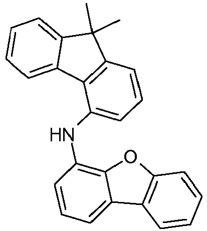 | 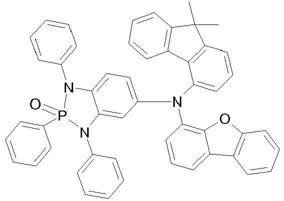 | 65% |
| J3 | 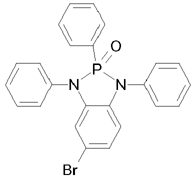 | 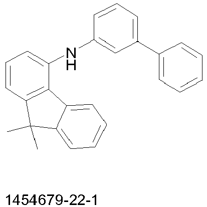 | 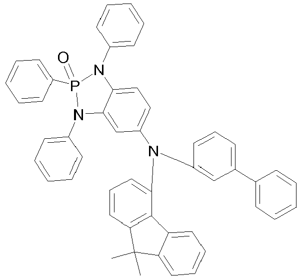 | 66% |
| J4 | 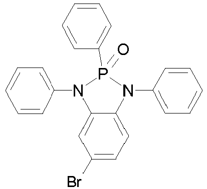 | 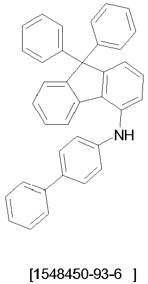 | 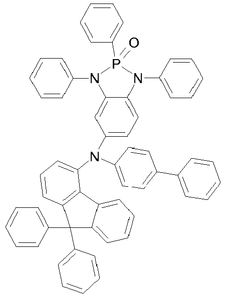 | 69% |
| J5 | 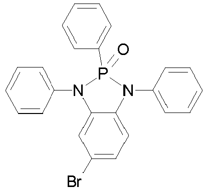 | 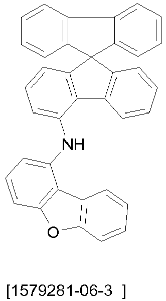 | 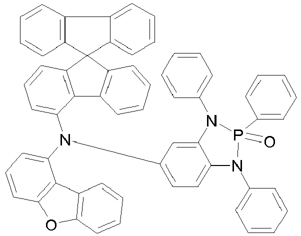 | 64% |
| J6 | 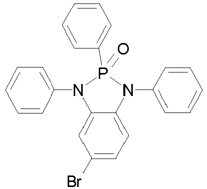 | 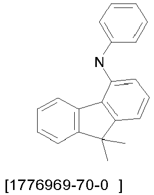 | 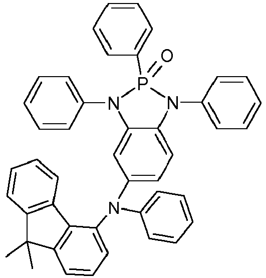 | 70% |

### B) Fabrication of OLEDs

The following examples V1 to E7 (see Table 1 and 2) show data of various OLEDs.

### Substrate pre-treatment of examples V1-E7:

Glass plates with structured ITO (50 nm, indium tin oxide) form the substrates on which the OLEDs are processed. Before evaporation of the OLED materials, the substrates are cleaned in a wet process (using filtered deionized water and the detergent "Extran" of Merck KGaA). Subsequently the clean and dry substrates are exposed to a UV-Ozone plasma and then coated with a layer of 20nm PEDOT:PSS (Poly(3,4-ethylendioxythiophen) poly(styrolsulfonate), by using an aqueous solution of CLEVIOS™ P VP AI 4083 purchased from Heraeus Precious Metals GmbH, Germany, for better processing. Before evaporating OLED materials onto the glass substrates, these are dried for 15 minutes at 170°C.

The OLEDs have in principle the following layer structure: substrate / hole-transport layer (HTL) / optional interlayer (IL) / electron-blocking layer (EBL) / emission layer (EML) / optional hole-blocking layer (HBL) / electron-transport layer (ETL) / optional electron-injection layer (EIL) and finally a cathode. The cathode is formed by an aluminium layer with a thickness of 100 nm. The exact layer structure is denoted in Table 1 (ITO, PEDOT:PSS and Aluminium layers are omitted for clarity). The materials used for the OLED fabrication are presented in Table 3.

All materials are applied by thermal vapour deposition in a vacuum chamber. The emission layer here always consists of at least one matrix material (host material) and an emitting dopant (emitter), which is admixed with the matrix material or matrix materials in a certain proportion by volume by co-evaporation. An expression such as IC1:M1:TEG1 (55%:35%:10%) here means that material IC1 is present in the layer in a proportion by volume of 55%, M1 is present in the layer in a proportion of 35% and TEG1 is present in the layer in a proportion of 10%. Analogously, the electron-transport layer may also consist of a mixture of two materials.

The OLEDs are characterised by standard methods. For this purpose, the electroluminescence spectra, the external quantum efficiency (EQE1000, measured in % at 1000 cd/m²) and the voltage (U1000, measured at 1000 cd/m² in V) are determined from current/ voltage/luminance characteristic lines (IUL characteristic lines) assuming a Lambertian emission profile. Lifetime LT is defined as the time in hours (h), after which the starting brightness is reduced to a certain level L1 in % of the starting brightness. Here L0;j0 = 4000 cd/m² and L1 = 70% in table 2 means, that the starting brightness is reduced from 4000 cd/m² to 2800 cd/m² after the time in hours (h) of column "LT". Analogously, L0;j0 = 20mA/cm², L1= 80% means, that the starting brightness at a current density of 20mA/cm² after the time "LT" in hours (h), is reduced to 80% of it's starting value.

The device data of various OLEDs is summarized in Table 2. The examples V1-V3 are comparison examples according to the state-of-the-art. The examples E1-E7 show data of OLEDs according to the invention.
In the following section several examples are described in more detail to show the advantages of the inventive OLEDs.

### Use of inventive compounds as host material in phosphorescent OLEDs

The use of the inventive compounds as host material results in significantly improved OLED device data compared to state-of-the-art materials, especially with respect to lifetime.
The use of the inventive materials Inv1 - Inv7 as host materials in phosphorescent green OLEDs results in a 15-40% improved lifetime compared to devices with the materials SdT1-SdT3 (comparison of examples V1 and V2 with E1, E2 and E4-E7 and the comparison of V3 with E3, respectively).

**Table 1: OLED laver structure**

| Bsp. | HIL Dicke | IL Dicke | HTL Dicke | EML Dicke | HBL Dicke | ETL Dicke |
|---|---|---|---|---|---|---|
| V1 | SpA1 70nm | HATCN 5nm | SpMA1 70nm | IC5:SdT1:TEG1 (60%:30%:10%) 30nm | ST2 10nm | ST2:LiQ (50%:50%) 30nm |
| V2 | SpA1 70nm | HATCN 5nm | SpMA1 70nm | IC5:SdT2:TEG1 (60%:30%:10%) 30nm | ST2 10nm | ST2:LiQ (50%:50%) 30nm |
| V3 | SpA1 70nm | HATCN 5nm | SpMA1 70nm | IC5:SdT3:TEG1 (60%:30%:10%) 30nm | ST2 10nm | ST2:LiQ (50%:50%) 30nm |
| E1 | SpA1 70nm | HATCN 5nm | SpMA1 70nm | IC5:Inv1:TEG1 (60%:30%:10%) 30nm | ST2 10nm | ST2:LiQ (50%:50%) 30nm |
| E2 | SpA1 70nm | HATCN 5nm | SpMA1 70nm | IC5:Inv2:TEG1 (60%:30%:10%) 30nm | ST2 10nm | ST2:LiQ (50%:50%) 30nm |
| E3 | SpA1 70nm | HATCN 5nm | SpMA1 70nm | IC5:Inv3:TEG1 (60%:30%:10%) 30nm | ST2 10nm | ST2:LiQ (50%:50%) 30nm |
| E4 | SpA1 70nm | HATCN 5nm | SpMA1 70nm | IC5:Inv4:TEG1 (60%:30%:10%) 30nm | ST2 10nm | ST2:LiQ (50%:50%) 30nm |
| E5 | SpA1 70nm | HATCN 5nm | SpMA1 70nm | IC5:Inv5:TEG1 (60%:30%:10%) 30nm | ST2 10nm | ST2:LiQ (50%:50%) 30nm |
| E6 | SpA1 70nm | HATCN 5nm | SpMA1 70nm | IC5:Inv6:TEG1 (60%:30%:10%) 30nm | ST2 10nm | ST2:LiQ (50%:50%) 30nm |
| E7 | SpA1 70nm | HATCN 5nm | SpMA1 70nm | IC5:Inv7:TEG1 (60%:30%:10%) 30nm | ST2 10nm | ST2:LiQ (50%:50%) 30nm |

**Table 2: OLED device data**

| Bsp. | U1000 (V) | EQE 1000 | L₀; j₀ | L₁ % | LT (h) |
|---|---|---|---|---|---|
| V1 | 3.4 | 15.3% | 20 mA/cm² | 80 | 140 |
| V2 | 3.5 | 15.4% | 20 mA/cm² | 80 | 120 |
| V3 | 3.6 | 15.3% | 20 mA/cm² | 80 | 100 |
| E1 | 3.5 | 15.3% | 20 mA/cm² | 80 | 175 |
| E2 | 3.4 | 15.5% | 20 mA/cm² | 80 | 190 |
| E3 | 3.6 | 15.4% | 20 mA/cm² | 80 | 130 |
| E4 | 3.3 | 15.6% | 20 mA/cm² | 80 | 165 |
| E5 | 3.3 | 15.5% | 20 mA/cm² | 80 | 170 |
| E6 | 3.5 | 16.1% | 20 mA/cm² | 80 | 175 |
| E7 | 3.5 | 15.4% | 20 mA/cm² | 80 | 180 |

**Tabelle 3: Chemical structures of the OLED materials**

| | |
|---|---|
| 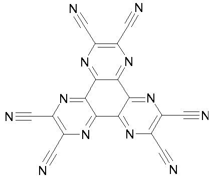 | 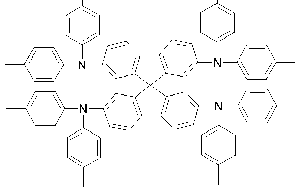 |
| HATCN | SpA1 |
| 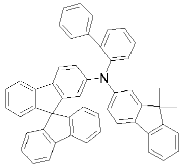 | 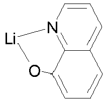 |
| SpMA1 | LiQ |
| 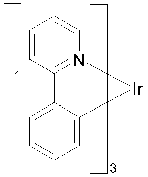 | 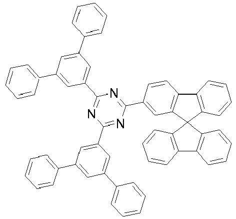 |
| TEG1 | ST2 |
| 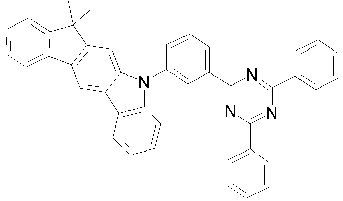 | 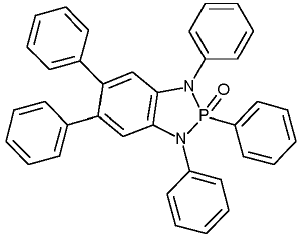 |
| IC5 | SdT1 |
| 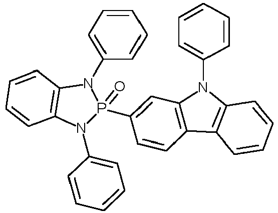 | 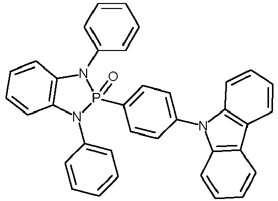 |
| SdT2 | SdT3 |
| 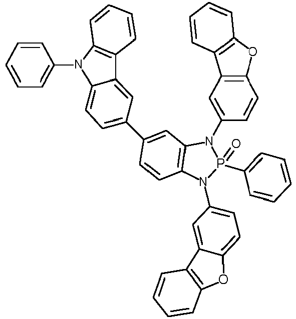 | 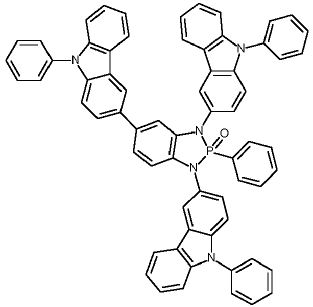 |
| Inv1 | Inv2 |
| 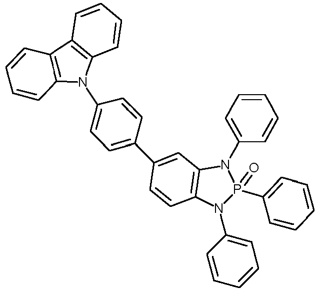 | 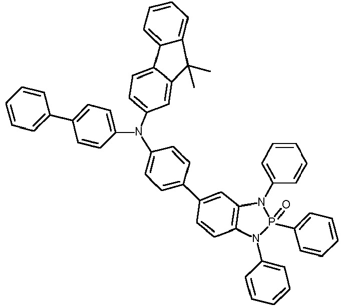 |
| Inv3 | Inv4 |
| 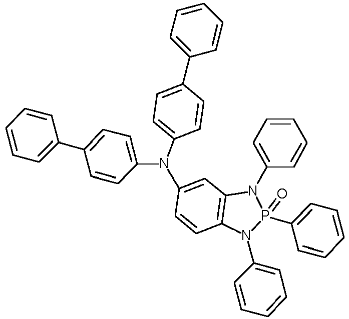 | 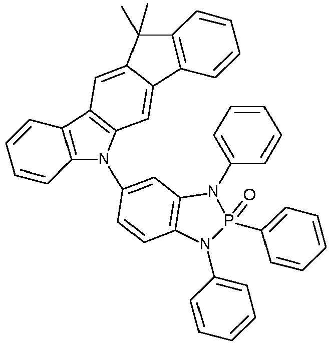 |
| Inv5 | Inv6 |
| 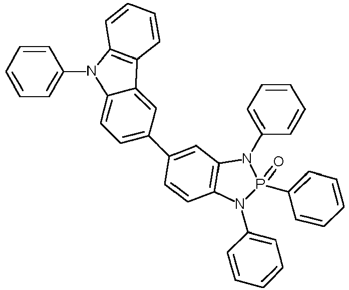 | |
| Inv7 | |

## Claims

1. Compound of the formula (1), 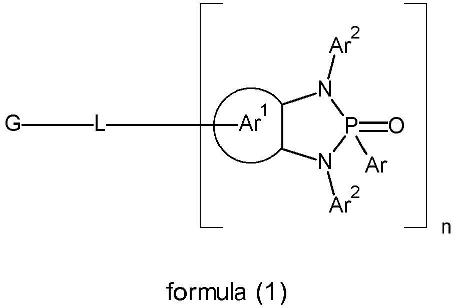 where:
L is a single bond or an aromatic or heteroaromatic ring system having 5 to 30 aromatic ring atoms, which may be substituted by one or more radicals R;
G is an aromatic or heteroaromatic ring system having 5 to 60 aromatic ring atoms, which may be substituted by one or more radicals R; or G is a group -N(Ar³)₂;
Ar, Ar² are, on each occurrence, identically or differently, an aromatic or heteroaromatic ring system having 5 to 60 aromatic ring atoms, which may be substituted by one or more radicals R;
Ar¹ is an aryl or heteroaryl group having 6 to 10 aromatic ring atoms, which may be substituted by one or more radicals R;
Ar³ is, on each occurrence, identically or differently, an aromatic or heteroaromatic ring system having 5 to 60 aromatic ring atoms, which may be substituted by one or more radicals R; where two groups Ar³ present in a group -N(Ar³)₂ are allowed to be connected via a single bond or a divalent bridge;
R is on each occurrence, identically or differently, H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R¹, where one or more, preferably non-adjacent CH₂ groups may be replaced by (R¹)C=C(R¹), C=C, Si(R¹)₂, Ge(R¹)₂, Sn(R¹)₂, C=O, C=S, C=Se, P(=O)(R¹), SO, SO₂, N(R¹), O, S or CON(R¹) and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, where optionally two adjacent substituents R can form a mono- or polycyclic, aliphatic, aromatic or heteroaromatic ring system with one another;
Ar⁴ is an aromatic or heteroaromatic ring system having 5 to 60 aromatic ring atoms, which may be substituted by one or more radicals R¹;
R¹ is on each occurrence, identically or differently, H, D, F, Cl, Br, I, CHO, N(R²)₂, C(=O)R², P(=O)(R²)₂, S(=O)R², S(=O)₂R², (R²)C=C(R²)₂, CN, NO₂, Si(R²)₃, B(OR²)₂, B(R²)₂, B(N(R²)₂)₂, OSO₂R², a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R², where one or more, preferably non-adjacent CH₂ groups may be replaced by (R²)C=C(R²), C≡C, Si(R²)₂, Ge(R²)₂, Sn(R²)₂, C=O, C=S, C=Se, P(=O)(R²), SO, SO₂, N(R²), O, S or CON(R²) and where one or more H atoms may be replaced by D, F, Cl, Br, I, CN or NO₂, or an aromatic or heteroaromatic ring system having 5 to 60 aromatic ring atoms, which may in each case be substituted by one or more radicals R², or an aryloxy or heteroaryloxy group having 5 to 60 aromatic ring atoms, which may be substituted by one or more radicals R², where optionally two adjacent substituents R¹ can form a mono- or polycyclic, aliphatic, aromatic or heteroaromatic ring system with one another;
R² is on each occurrence, identically or differently, H, D, F, Cl, Br, I, CHO, CN, NO₂, a straight-chain alkyl, alkoxy or thioalkoxy group having 1 to 20 C atoms or a straight-chain alkenyl or alkynyl group having 2 to 20 C atoms or a branched or cyclic alkyl, alkenyl, alkynyl, alkoxy or thioalkoxy group having 3 to 20 C atoms, or an aromatic or heteroaromatic ring system having 5 to 30 aromatic ring atoms or an aryloxy or heteroaryloxy group having 5 to 30 aromatic ring atoms; where optionally two adjacent substituents R² can form a mono- or polycyclic, aliphatic, aromatic or heteroaromatic ring system with one another;
n is 1, 2 or 3;
with the proviso that, if L is a single bond, then G does not stand for benzene.

2. Compound according to claim 1 selected from the compounds of formula (1-1), 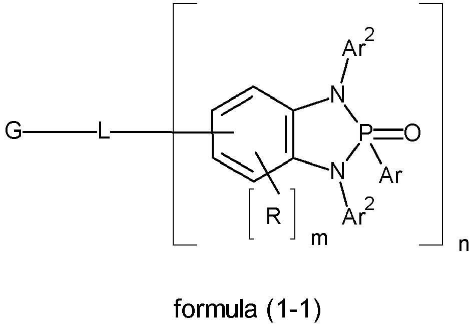 where m is 0, 1, 2 or 3 and where the other symbols and indices used have the same meanings as given in claim 1.

3. Compound according to claim 1 or 2, **characterized in that** L is a single bond or an aromatic or heteroaromatic ring system selected from benzene, naphthalene, biphenyl, terphenyl, fluorene, spirobifluorene, dibenzofuran, dibenzothiophene, carbazole or benzocarbazole, each of which may be substituted by one or more radicals R.

4. Compound according to one or more of the preceding claims, **characterized in that** G is an aromatic or heteroaromatic ring system selected from naphthalene, anthracene, fluoranthene, biphenyl, terphenyl, fluorene, furan, benzofuran, dibenzofuran, thiophene, benzothiophene, dibenzothiophene, carbazole, benzocarbazole, indolocarbazole, indenocarbazole, pyridine, quinoline, isoquinoline, pyridazine, benzopyridazine, benzimidazole, pyrimidine, benzopyrimidine, quinoxaline, pyrazine, azacarbazole, benzocarboline, phenanthroline, 1,3,5-triazine, 1,2,4-triazine or 1,2,3-triazine, each of which may be substituted by one or more radicals R.

5. Compound according to one or more of the preceding claims, **characterized in that** G is an aromatic or heteroaromatic ring system selected from the groups of formulae (G-1) to (G-10), 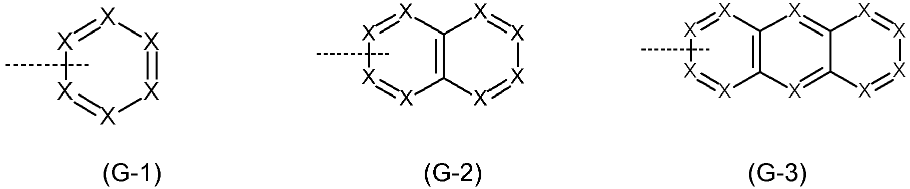 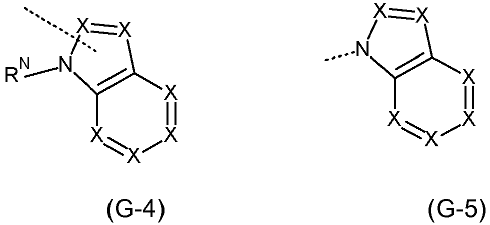 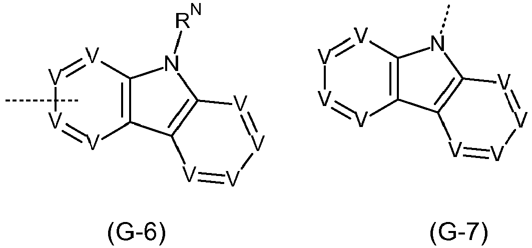 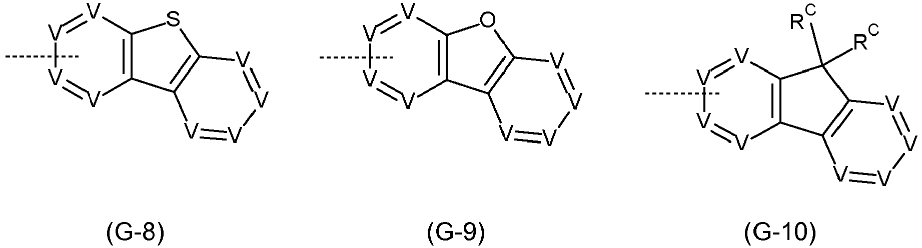 where the dashed bond indicates the bonding to the group L or, if L is a single bond, to the group Ar¹ as depicted in formula (1); and where
X is on each occurrence, identically or differently, CR or N; where X is a C atom when a group L or Ar¹ is bonded to X, where there are maximum three X groups per 6-membered ring, which stand for N, and two X groups per 5-membered ring, which stand for N; with the proviso that, in formula (G-1), at least one X stands for N;
V is on each occurrence, identically or differently, CR or N; V is a C atom when a group L or Ar¹ is bonded to V; or two adjacent groups V form together a group of formula (V-1) or (V-2), 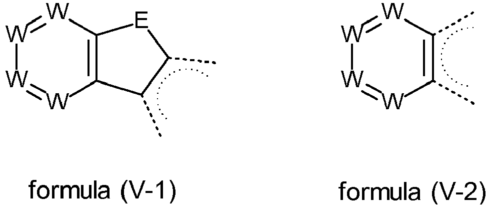
where the dashed bonds in formula (V-1) and (V-2) indicate the bonding to the structures depicted in formulae (G-5) to (G-10);
W is on each occurrence, identically or differently, CR or N; wherein there are maximum three X groups per 6-membered ring, which stand for N;
E is O, S, N(R^{N}), C(R^{C})₂;
R^{N}, R^{C} are on each occurrence, identically or differently, H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, a straight-chain alkyl, alkoxy or thioalkoxy group having 1 to 40 C atoms or a straight-chain alkenyl or alkynyl group having 2 to 40 C atoms or a branched or cyclic alkyl, alkenyl, alkynyl, alkoxy or thioalkoxy group having 3 to 40 C atoms, each of which may be substituted by one or more radicals R¹, where one or more, preferably non-adjacent CH₂ groups may be replaced by (R¹)C=C(R¹), C=C, Si(R¹)₂, Ge(R¹)₂, Sn(R¹)₂, C=O, C=S, C=Se, P(=O)(R¹), SO, SO₂, N(R¹), O, S or CON(R¹) and where one or more H atoms may be replaced by D, F, Cl, Br, I, CN or NO₂, or an aromatic or heteroaromatic ring system having 5 to 60 aromatic ring atoms, which may in each case be substituted by one or more radicals R¹, or an aryloxy or heteroaryloxy group having 5 to 60 aromatic ring atoms, which may be substituted by one or more radicals R¹, where optionally two adjacent substituents R^{C} can form a mono- or polycyclic, aliphatic, aromatic or heteroaromatic ring system with one another.

6. Compound according to one or more of the preceding claims, **characterized in that** G is an aromatic or heteroaromatic ring system selected from the groups of formulae (G-11) to (G-64), 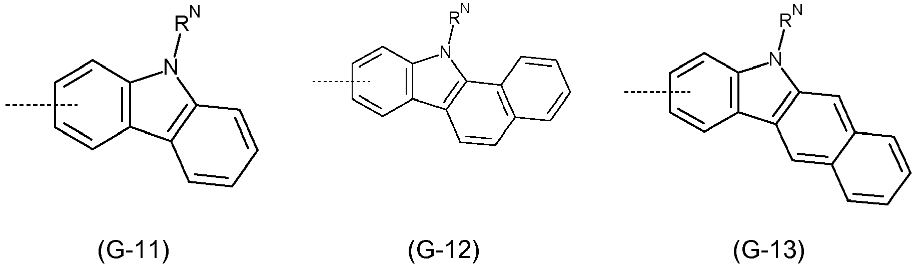 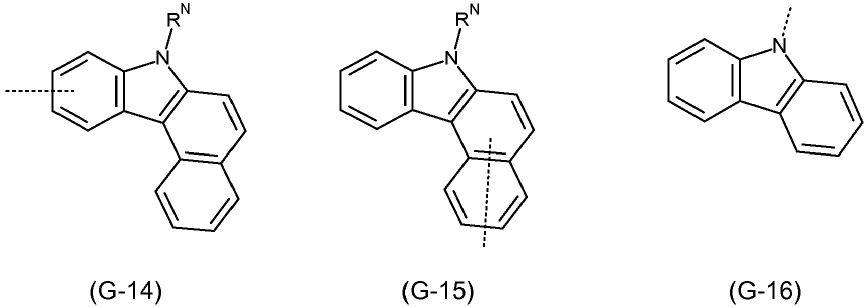 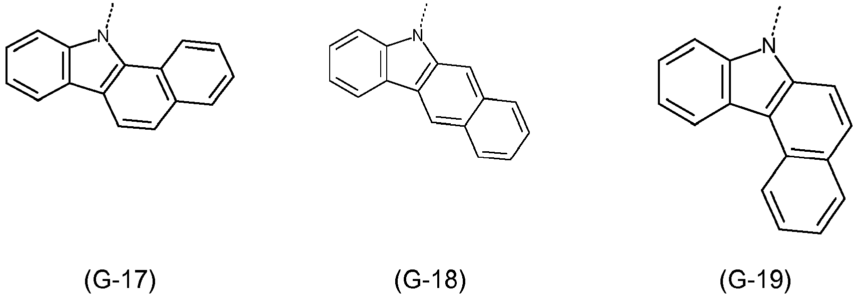 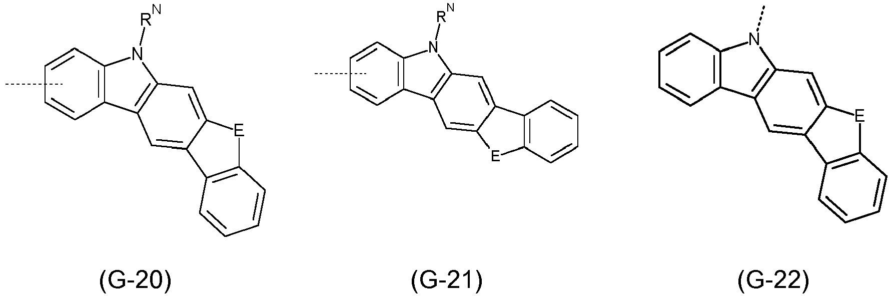 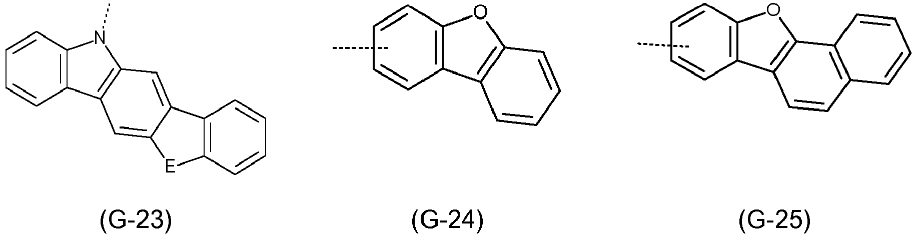 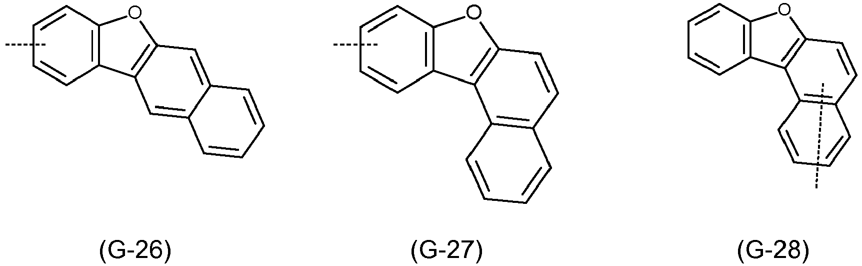 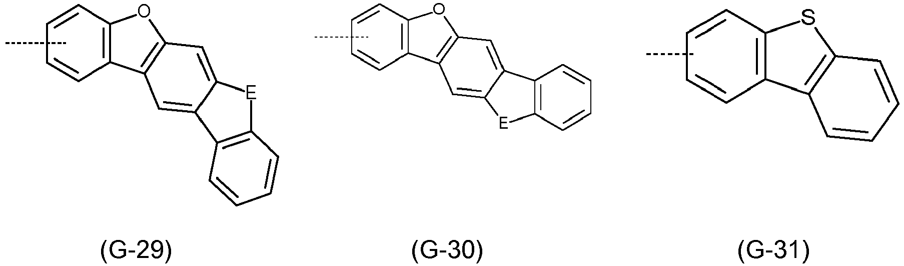 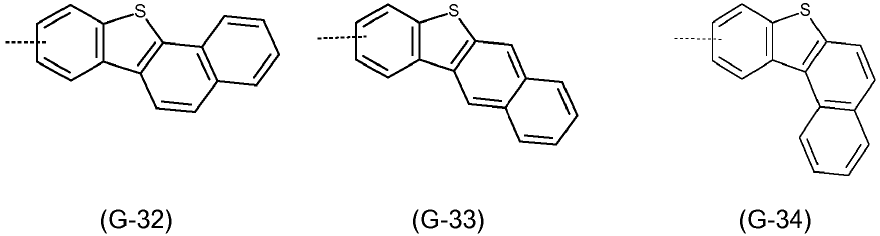 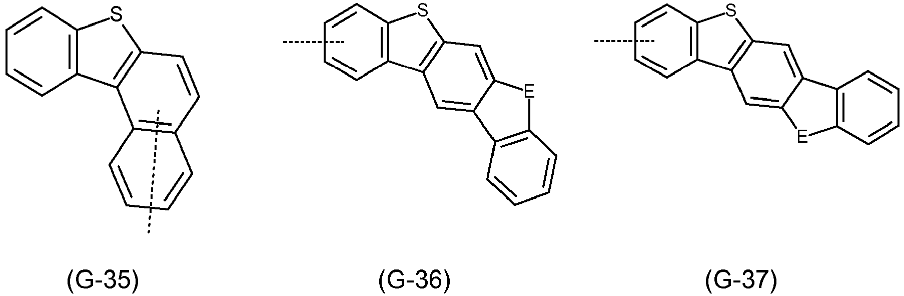 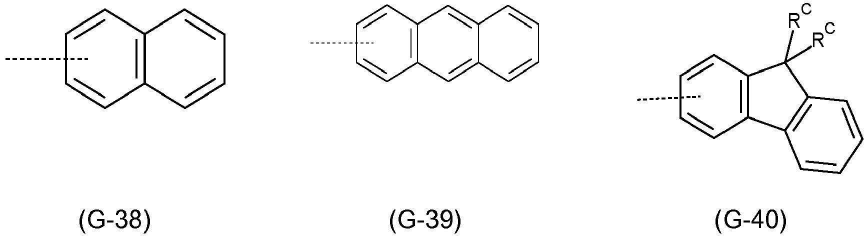 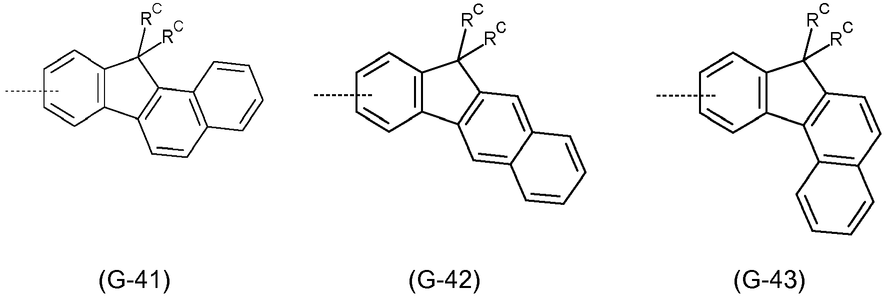 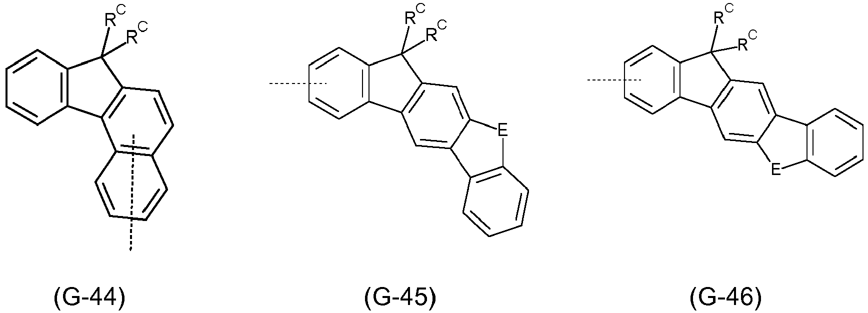 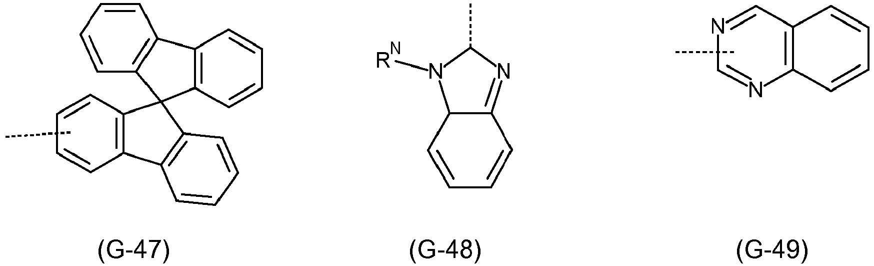 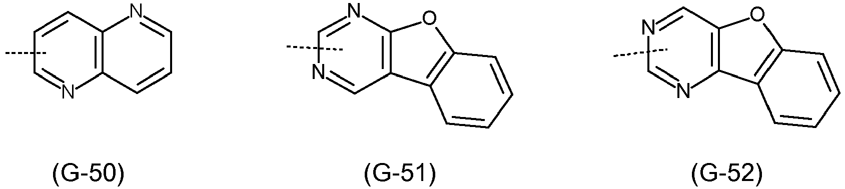 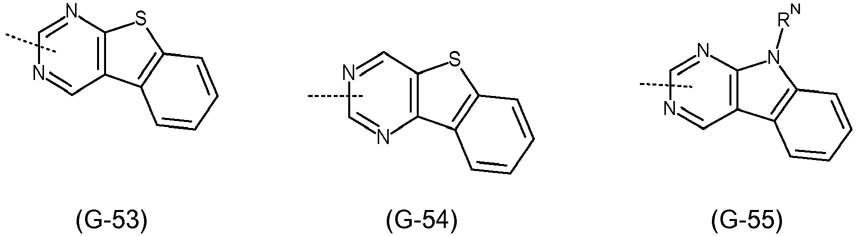 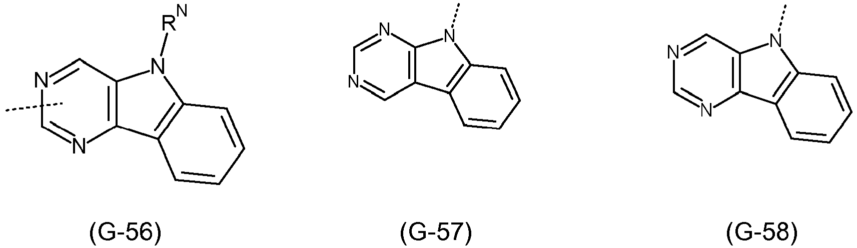 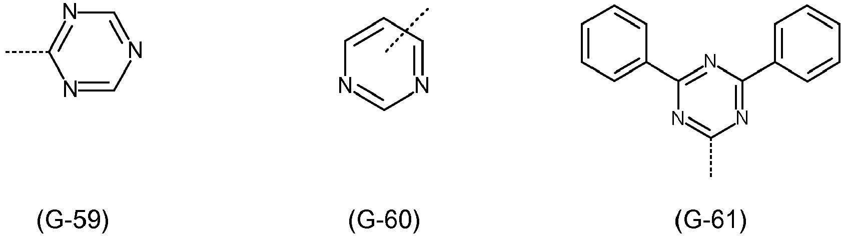 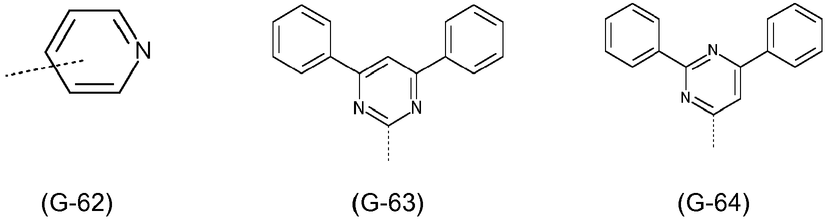
where the dashed bond indicates the bonding to the group L or, if L is a single bond, to the diazaphosphole moiety depicted in formula (1);
the symbols R^{C}, R^{N} and E have the same meaning as in claim 5; and
the groups of formulae (G-11) to (G-64) are optionally substituted by one or more radicals R at any free positions, where R has the same meaning as in claim 1.

7. Compound according to one or more of claims 1 to 3, **characterized in that** G stands for a group -N(Ar³)₂, where Ar³ is selected on each occurrence, identically or differently, from benzene, naphthalene, fluoranthene, biphenyl, terphenyl, fluorene, spirobifluorene, cis- or trans-indenofluorene, furan, benzofuran, isobenzofuran, dibenzofuran, thiophene, benzothiophene, isobenzothiophene, dibenzothiophene, carbazole, benzocarbazole, indolocarbazole and indenocarbazole, which may be substituted by one or more radicals R, and where two groups Ar³ present in a group -N(Ar³)₂ are allowed to be connected via a single bond or a divalent bridge.

8. Compound according to claim 7, **characterized in that** G stands for a group -N(Ar³)₂, where Ar³ is selected on each occurrence, identically or differently, from the groups of the following formulae (A-1) to (A-48), 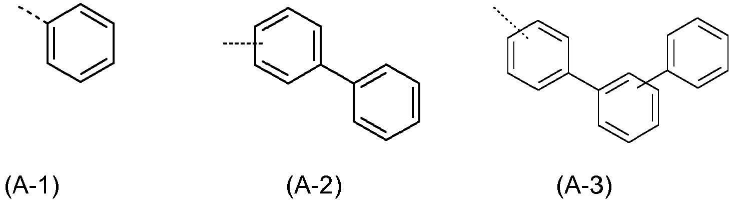 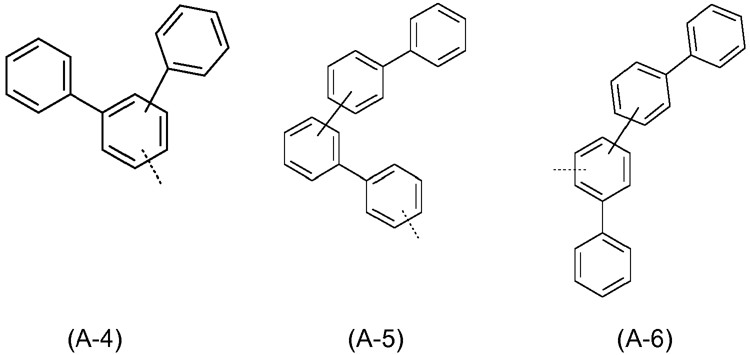 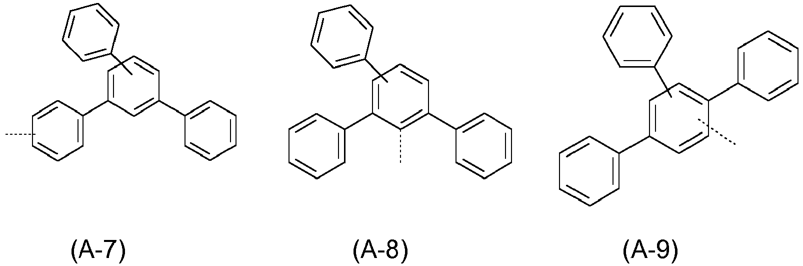 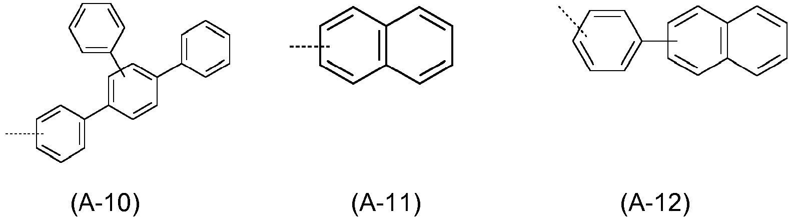 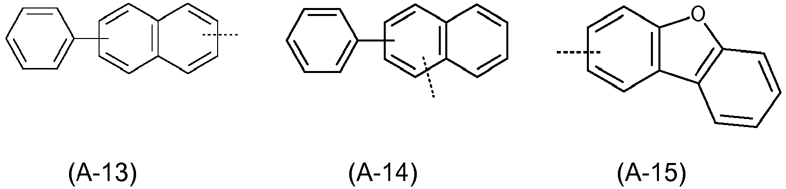 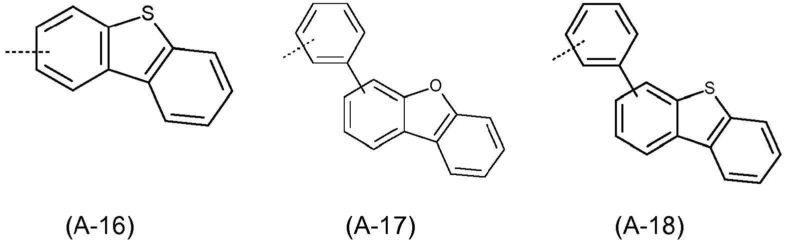 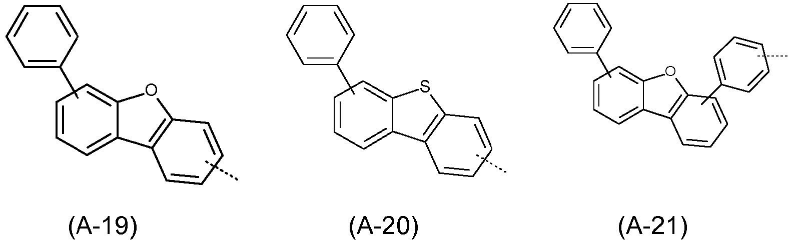 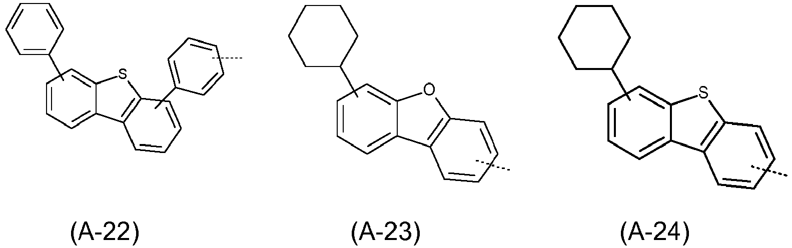 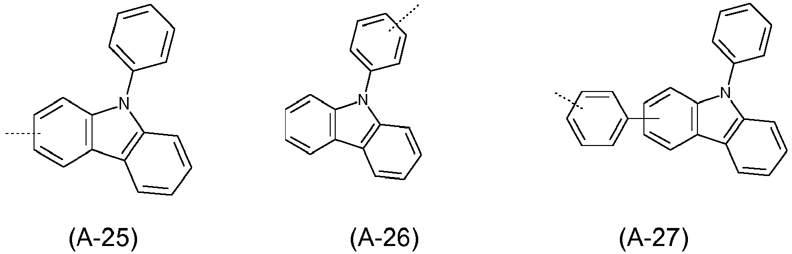 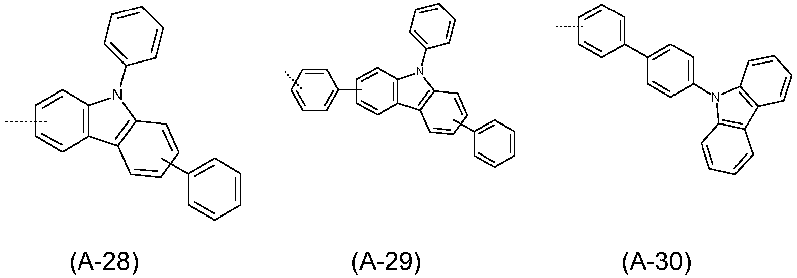 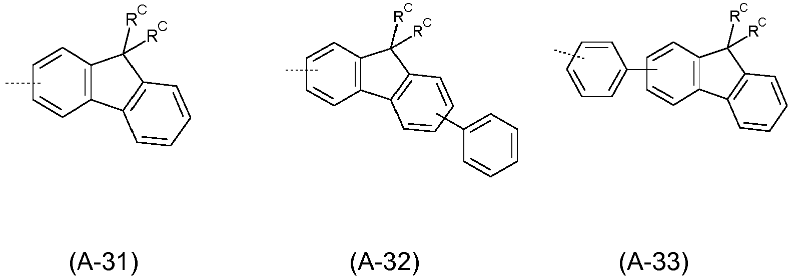 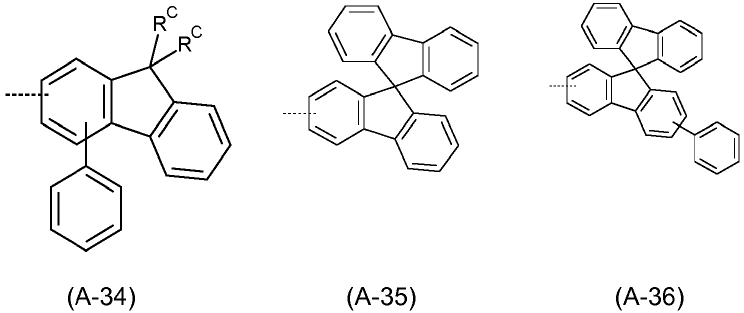 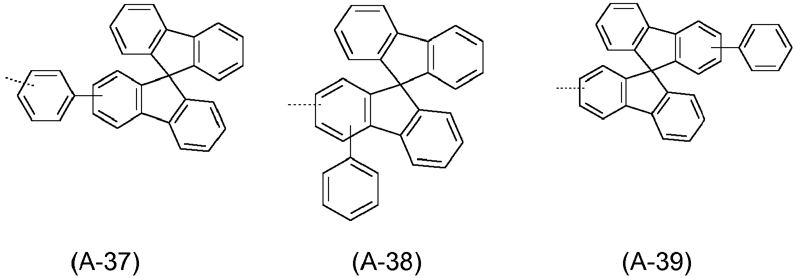 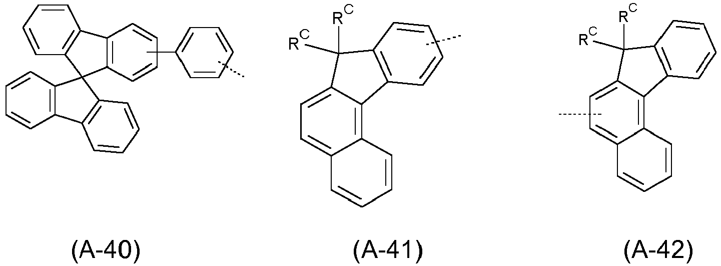 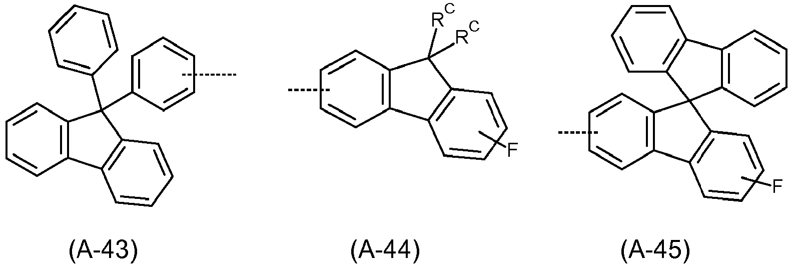 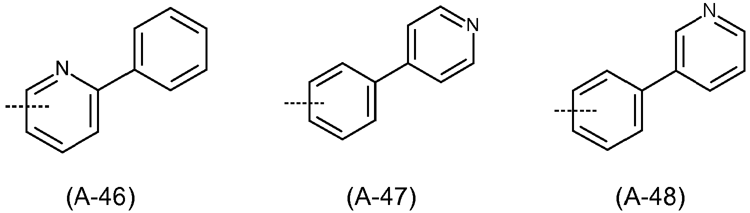
where the dashed bonds indicate the bonds to the nitrogen atom,
where the groups of formulae (A-1) to (A-48) may further be substituted at each free position by a group R as in claim 1 and
where the groups R^{C}, in formulae (A-31) to (A-34), (A-41), (A-42) and (A-44) has the same meaning as in claim 5.

9. Compound according to claim 7, **characterized in that** G stands for a group -N(Ar³)₂, where the two groups Ar³ are connected via a single bond or a divalent bridge and form a group selected from formulae (E-1) to (E-24), 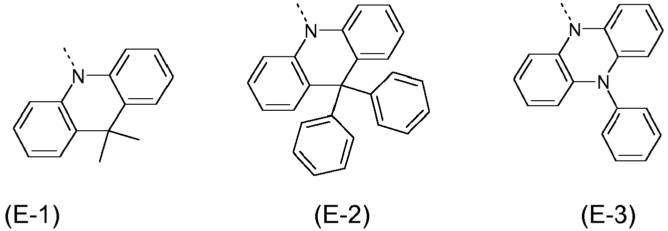 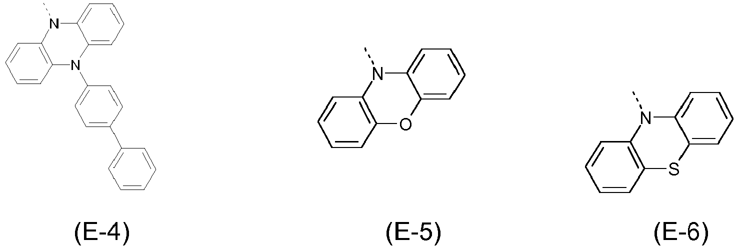 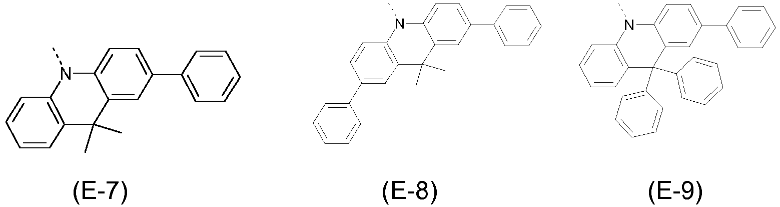 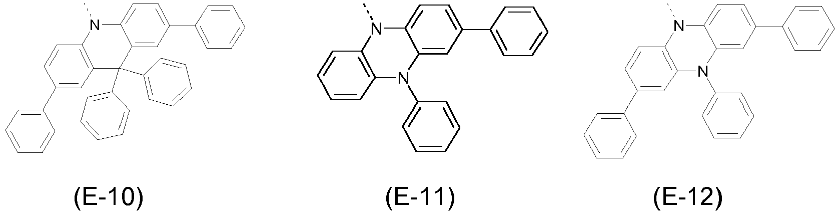 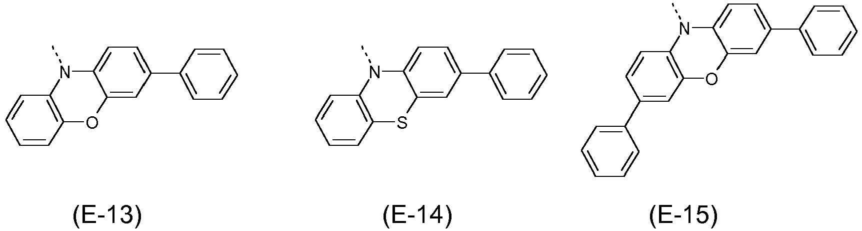 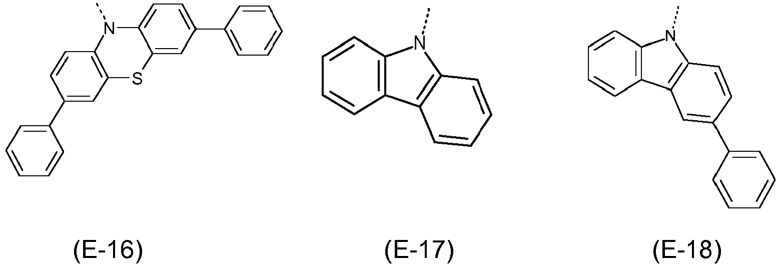 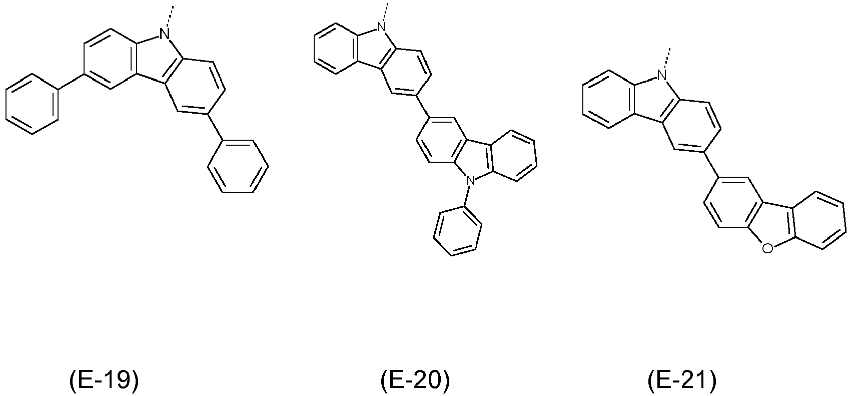 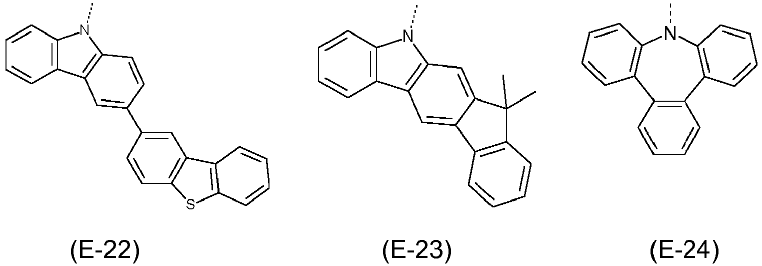
where the dashed bond indicates the bonding to the group L or, if L is a single bond, to the diazaphosphole moiety depicted in formula (1);
and where the groups (E-1) to (E-24) may be substituted at each free position by a group R as defined in claim 1.

10. Compound according to one or more of the preceding claims, **characterized in that** the compounds of formula (1) comprise at least one group Ar, Ar², R or R^{N}, which is selected from substituted or non-substituted triazine, pyrimidine, pyrazine, pyridazine, pyridine, imidazole, pyrazole, oxazole, oxadiazole, triazole, thiazole, thiadiazole, benzimidazole, quinolone, isoquinoline and quinoxaline.

11. Compound according to one or more of claims 1 to 9, **characterized in that** the compounds of formula (1) comprise at least one group Ar, Ar², R or R^{N}, which is selected from substituted or non-substituted pyrrole, furan, thiophene, benzothiophene, benzofuran, indole, carbazole, dibenzothiophene, dibenzofuran and azacarbazole.

12. Process for the preparation of a compound according to one or more of claims 1 to 11, in which a group selected from an aromatic or heteroaromatic ring system, an arylamino group or a carbazole derivative, is connected to the phenyl ring condensed on the diazaphosphole moiety of a diazaphosphole derivative via a C-N or a C-C coupling.

13. A formulation comprising at least one compound according to one or more of claims 1 to 11, and at least one solvent.

14. An electronic device comprising at least one compound according to one or more of claims 1 to 11, selected from the group consisting of organic electroluminescent devices, organic integrated circuits, organic field-effect transistors, organic thin-film transistors, organic light-emitting transistors, organic solar cells, dye-sensitised organic solar cells, organic optical detectors, organic photoreceptors, organic field-quench devices, light-emitting electrochemical cells, organic laser diodes and organic plasmon emitting devices.

15. An organic electroluminescent device, **characterised in that** the compound according to one or more of claims 1 to 11 is employed as one or more of a matrix material for phosphorescent or fluorescent emitters, an electron-blocking or exciton-blocking material, a hole-blocking material, or an electron-transport material.

## Patentansprüche

1. Verbindung der Formel (1), 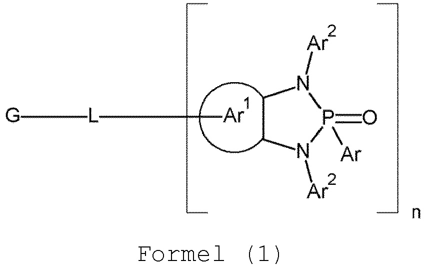 wobei für die verwendeten Symbole und Indizes gilt:
L ist eine Einfachbindung oder ein aromatisches oder heteroaromatisches Ringsystem mit 5 bis 30 aromatischen Ringatomen, das durch einen oder mehrere Reste R substituiert sein kann;
G ist ein aromatisches oder heteroaromatisches Ringsystem mit 5 bis 60 aromatischen Ringatomen, das durch einen oder mehrere Reste R substituiert sein kann; oder G ist eine Gruppe -N(Ar³)₂;
Ar, Ar² sind bei jedem Auftreten gleich oder verschieden ein aromatisches oder heteroaromatisches Ringsystem mit 5 bis 60 Ringatomen, das durch einen oder mehrere Reste R substituiert sein kann;
Ar¹ ist eine Aryl- oder Heteroarylgruppe mit 6 bis 10 aromatischen Ringatomen, die durch einen oder mehrere Reste R substituiert sein kann;
Ar³ ist bei jedem Auftreten gleich oder verschieden ein aromatisches oder heteroaromatisches Ringsystem mit 5 bis 60 Kohlenstoffatomen, das durch einen oder mehrere Reste R substituiert sein kann; wobei zwei Gruppen Ar³, die in einer Gruppe -N(Ar³)₂ vorliegen, über eine Einfachbindung oder eine zweiwertige Brücke verbunden sein können;
R ist bei jedem Auftreten gleich oder verschieden H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils durch einen oder mehrere Reste R¹ substituiert sein kann, wobei eine oder mehrere, vorzugsweise nicht benachbarte CH₂-Gruppen durch (R¹)C=C(R¹), C≡C, Si(R¹)₂, Ge(R¹)₂, Sn(R¹)₂, C=O, C=S, C=Se, P(=O)(R¹), SO, SO₂, N(R¹), O, S oder CON(R¹) ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, wobei gegebenenfalls zwei oder mehr benachbarte Substituenten R miteinander ein mono- oder polycyclisches, aliphatisches, aromatisches oder heteroaromatisches Ringsystem bilden können;
Ar⁴ ist ein aromatisches oder heteroaromatisches Ringsystem mit 5 bis 60 aromatischen Ringatomen, das durch einen oder mehrere Reste R¹ substituiert sein kann;
R¹ ist bei jedem Auftreten gleich oder verschieden H, D, F, Cl, Br, I, CHO, N(R²)₂, C(=O)R², P(=O)(R²)₂, S(=O)R², S(=O)₂R², (R²)C=C(R²)₂, CN, NO₂, Si(R²)₃, B(OR²)₂, B(R²)₂, B(N(R²)₂)₂, OSO₂R², eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils durch einen oder mehrere Reste R² substituiert sein kann, wobei eine oder mehrere, vorzugsweise nicht benachbarte CH₂-Gruppen durch (R²)C=C(R²), C≡C, Si(R²)₂, Ge(R²)₂, Sn(R²)₂, C=O, C=S, C=Se, P(=O)(R²), SO, SO₂, N(R²), O, S oder CON(R²) ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R² substituiert sein kann, oder eine Aryloxy- oder Heteroaryloxygruppe mit 5 bis 60 aromatischen Ringatomen, die durch einen oder mehrere Reste R² substituiert sein kann, wobei gegebenenfalls zwei oder mehr benachbarte Substituenten R¹ miteinander ein mono- oder polycyclisches, aliphatisches, aromatisches oder heteroaromatisches Ringsystem bilden können;
R² ist bei jedem Auftreten gleich oder verschieden H, D, F, Cl, Br, I, CHO, CN, NO₂, eine geradkettige Alkyl-, Alkoxy- oder Thioalkoxygruppe mit 1 bis 20 C-Atomen oder eine geradkettige Alkenyl- oder Alkinylgruppe mit 2 bis 20 C-Atomen oder eine verzweigte oder cyclische Alkyl-, Alkenyl-, Alkinyl-, Alkoxy- oder Thioalkoxygruppe mit 3 bis 20 C-Atomen oder ein aromatisches oder heteroaromatisches Ringsystem mit 5 bis 30 aromatischen Ringatomen oder eine Aryloxy- oder Heteroaryloxygruppe mit 5 bis 30 aromatischen Ringatomen, wobei gegebenenfalls zwei oder mehr benachbarte Substituenten R² miteinander ein mono- oder polycyclisches, aliphatisches, aromatisches oder heteroaromatisches Ringsystem bilden können;
n ist 1, 2 oder 3;
mit der Maßgabe, dass dann, wenn L eine Einfachbindung ist, G nicht für Benzol steht.

2. Verbindung nach Anspruch 1, ausgewählt aus den Verbindungen der Formel (1-1), 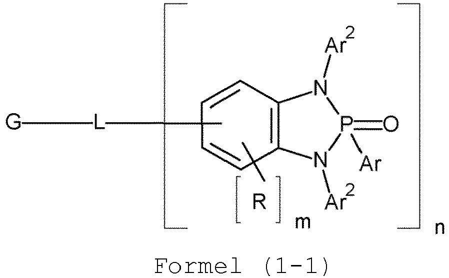 wobei m 0, 1, 2 oder 3 ist und wobei die anderen verwendeten Symbole und Indices die gleichen Bedeutungen wie in Anspruch 1 haben.

3. Verbindung nach Anspruch 1 oder 2, **dadurch gekennzeichnet, dass** L eine Einfachbindung oder ein aromatisches oder heteroaromatisches Ringsystem, das aus Benzol, Naphthalin, Biphenyl, Terphenyl, Fluoren, Spirobifluoren, Dibenzofuran, Dibenzothiophen, Carbazol oder Benzocarbazol, die jeweils durch einen oder mehrere Reste R substituiert sein können, ausgewählt ist, ist.

4. Verbindung nach einem oder mehreren der vorhergehenden Ansprüche, **dadurch gekennzeichnet, dass** G ein aromatisches oder heteroaromatisches Ringsystem ist, das aus Naphthalin, Anthracen, Fluoranthen, Biphenyl, Terphenyl, Fluoren, Furan, Benzofuran, Dibenzofuran, Thiophen, Benzothiophen, Dibenzothiophen, Carbazol, Benzocarbazol, Indolocarbazol, Indenocarbazol, Pyridin, Chinolin, Isochinolin, Pyridazin, Benzopyridazin, Benzimidazolyl, Pyrimidin, Benzopyrimidin, Chinoxalin, Pyrazin, Azacarbazol, Benzocarbolin, Phenanthrolin, 1,3,5-Triazin, 1,2,4-Triazin oder 1,2,3-Triazin, die jeweils durch einen oder mehrere Reste R substituiert sein können, ausgewählt ist.

5. Verbindung nach einem oder mehreren der vorhergehenden Ansprüche, **dadurch gekennzeichnet, dass** G ein aromatisches oder heteroaromatisches Ringsystem ist, das aus den Gruppen der Formeln (G-1) bis (G-10) ausgewählt ist, 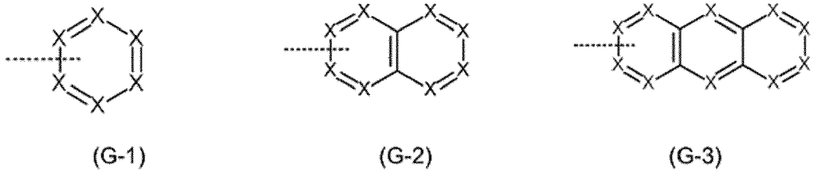 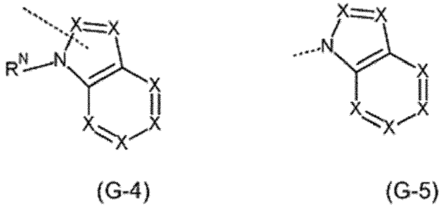 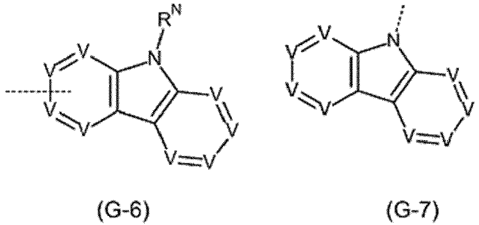 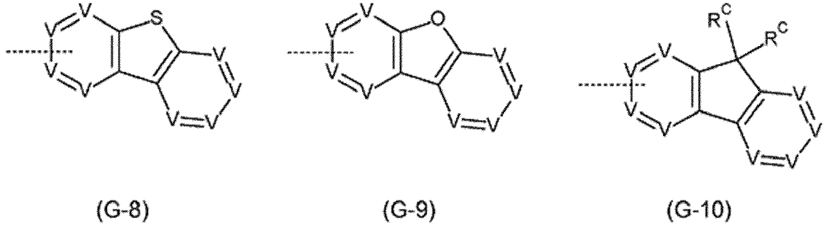 wobei die gestrichelte Bindung die Anbindung an die Gruppe L oder dann, wenn L eine Einfachbindung ist, an die Gruppe Ar¹ gemäß der Darstellung in Formel (1) anzeigt und wobei
X bei jedem Auftreten gleich oder verschieden CR oder N ist; wobei X ein C-Atom ist, wenn eine Gruppe L oder Ar¹ an X gebunden ist, wobei pro 6-gliedrigem Ring maximal drei X-Gruppen, die für N stehen, und pro 5-gliedrigem Ring maximal zwei X-Gruppen, die für N stehen, vorliegen; mit der Maßgabe, dass in Formel (G-1) mindestens ein X für N steht;
V bei jedem Auftreten gleich oder verschieden CR oder N ist; V ein C-Atomen ist, wenn eine Gruppe L oder Ar¹ an V gebunden ist oder 2 benachbarte Gruppen V zusammen eine Gruppe der Formel (V-1) oder (V-2) bilden, 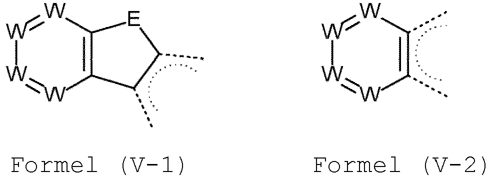
wobei die gestrichelten Bindungen in (V-1) und (V-2) die Anbindung an die in den Formeln (G-5) bis (G-10) dargestellten Strukturen anzeigen;
W bei jedem Auftreten gleich oder verschieden CR oder N ist; wobei pro 6-gliedrigem Ring maximal drei X-Gruppen, die für N stehen, vorliegen;
E O, S, N(R^{N}), C(R^{C})₂ ist;
R^{N}, R^{C} bei jedem Auftreten gleich oder verschieden H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, eine geradkettige Alkyl-, Alkoxy- oder Thioalkoxygruppe mit 1 bis 40 C-Atomen oder eine geradkettige Alkenyl- oder Alkinylgruppe mit 2 bis 40 C-Atomen oder eine verzweigte oder cyclische Alkyl-, Alkenyl-, Alkinyl-, Alkoxy- oder Thioalkoxygruppe mit 3 bis 40 C-Atomen, die jeweils durch einen oder mehrere Reste R¹ substituiert sein kann, wobei eine oder mehrere, vorzugsweise nicht benachbarte CH₂-Gruppen durch (R¹)C=C(R¹), C≡C, Si(R¹)₂, Ge(R¹)₂, Sn(R¹)₂, C=O, C=S, C=Se, P(=O)(R¹), SO, SO₂, N(R¹), O, S oder CON(R¹) ersetzt sein können und wobei ein oder mehrere H-Atome durch D, F, Cl, Br, I, CN oder NO₂ ersetzt sein können, oder ein aromatisches oder heteroaromatisches Ringsystem mit 5 bis 60 aromatischen Ringatomen, das jeweils durch einen oder mehrere Reste R¹ substituiert sein kann, oder eine Aryloxy- oder Heteroaryloxygruppe mit 5 bis 60 aromatischen Ringatomen, die durch einen oder mehrere Reste R¹ substituiert sein kann, sind, wobei gegebenenfalls zwei oder mehr benachbarte Substituenten R^{C} miteinander ein mono- oder polycyclisches, aliphatisches, aromatisches oder heteroaromatisches Ringsystem bilden können.

6. Verbindung nach einem oder mehreren der vorhergehenden Ansprüche, **dadurch gekennzeichnet, dass** G ein aromatisches oder heteroaromatisches Ringsystem ist, das aus den Gruppen (G-11) bis (G-64) ausgewählt ist, 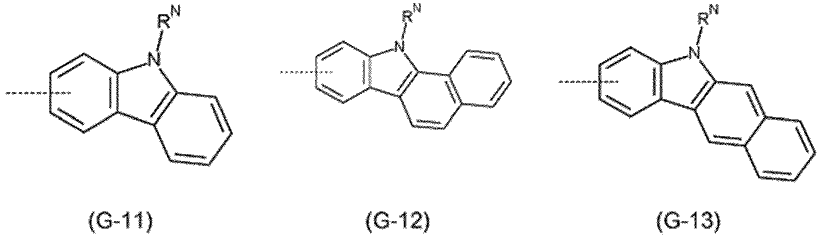 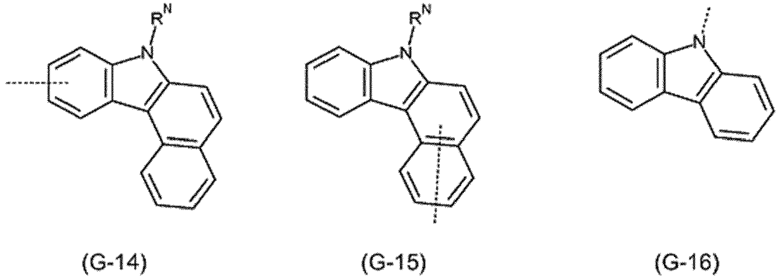 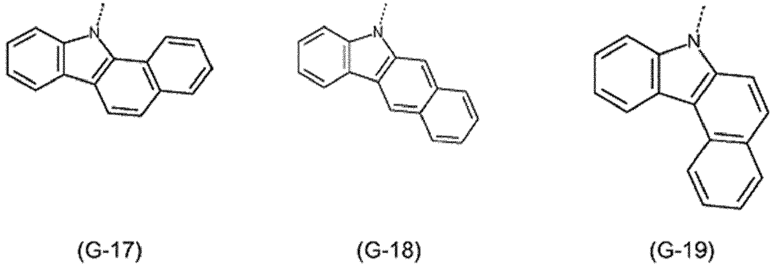 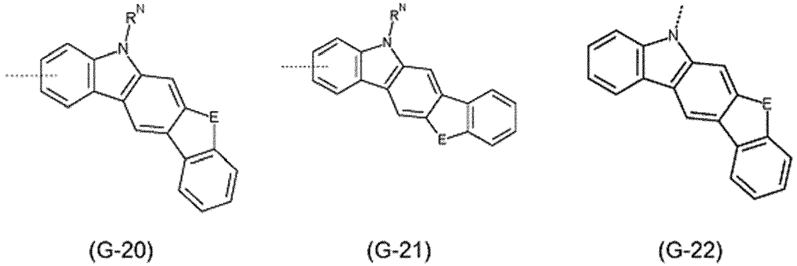 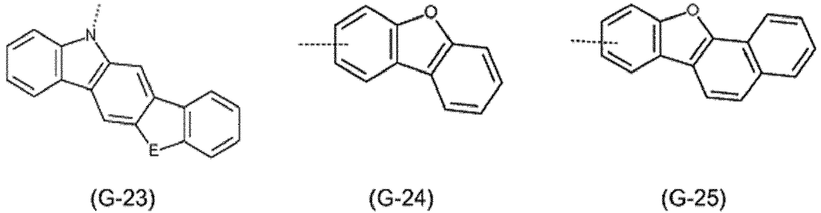 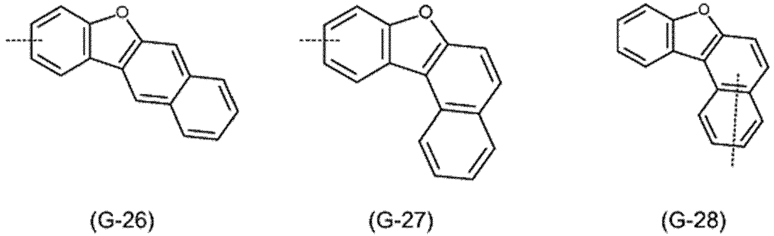 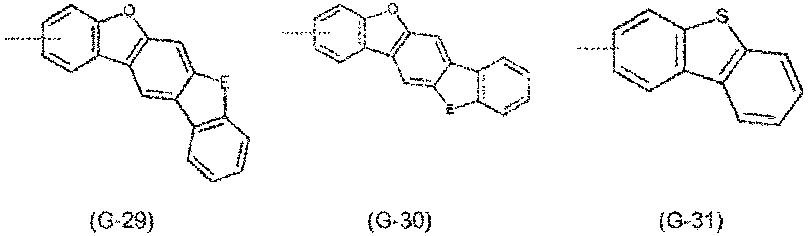 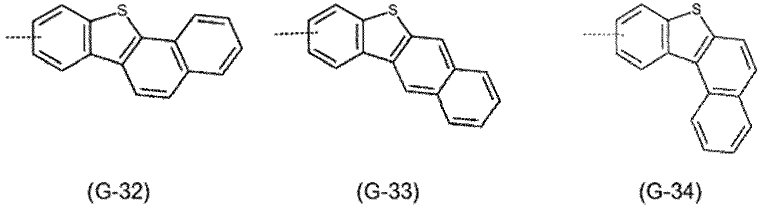 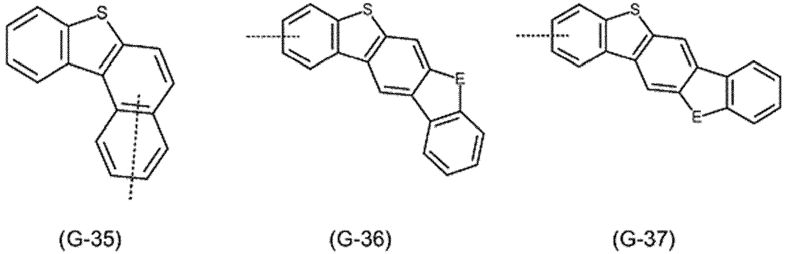 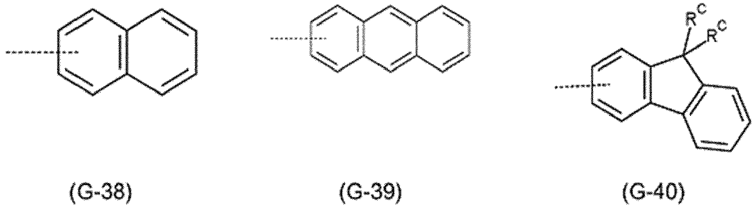 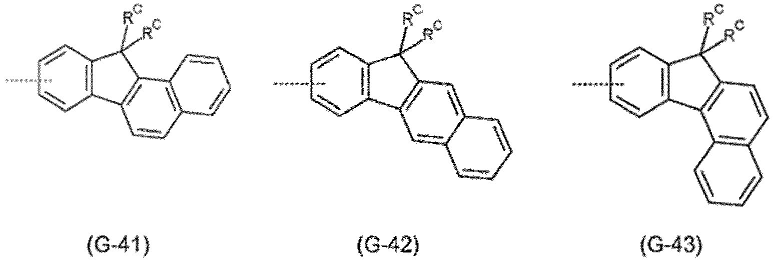 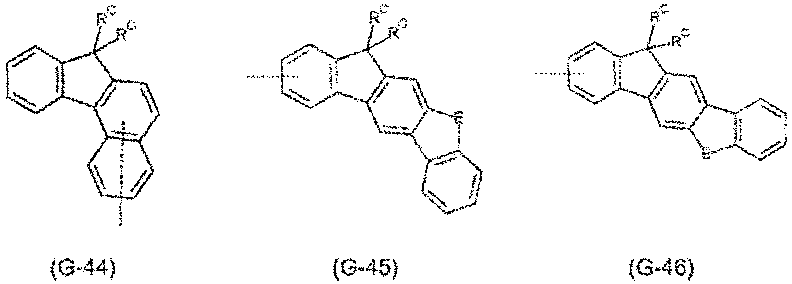 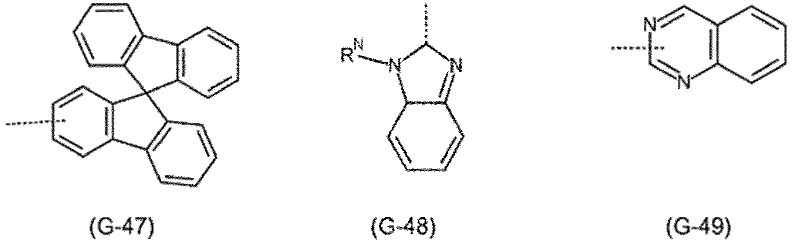 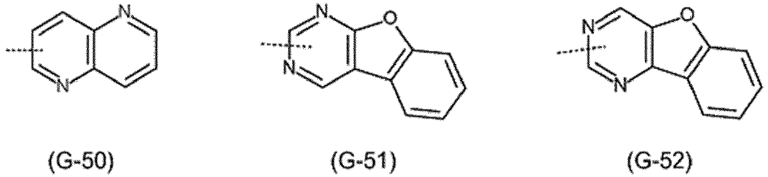 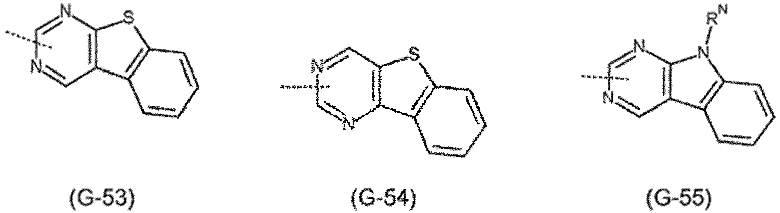 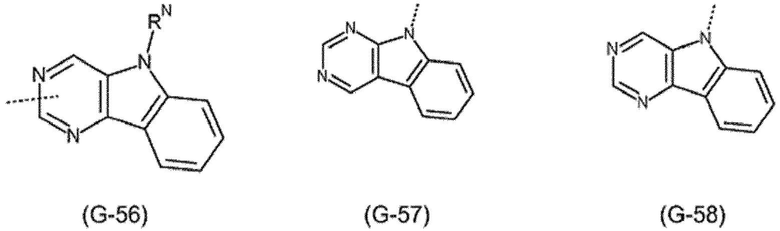 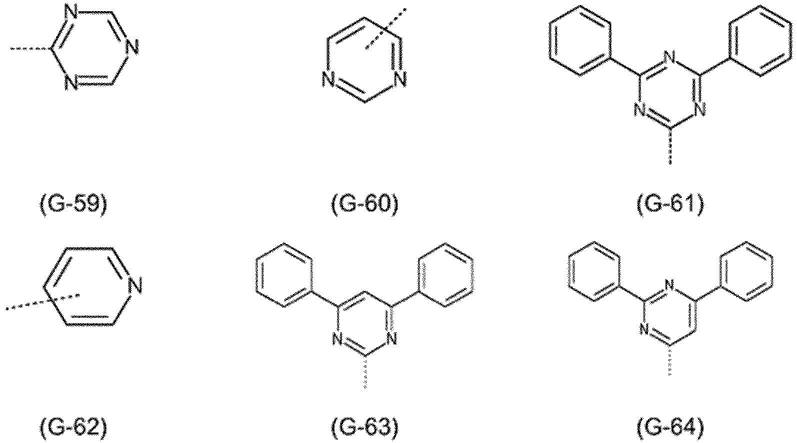
wobei die gestrichelte Bindung die Anbindung an die Gruppe L oder dann, wenn L eine Einfachbindung ist, an die in Formel (1) dargestellte Diazaphospholgruppierung anzeigt;
die Symbole R^{C}, R^{N} und E die gleiche Bedeutung wie in Anspruch 5 haben und
die Gruppen der Formeln (G-11) bis (G-64) gegebenenfalls an beliebigen freien Positionen durch einen oder mehrere Reste R substituiert sind, wobei R die gleiche Bedeutung wie in Anspruch 1 hat.

7. Verbindung nach einem oder mehreren der Ansprüche 1 bis 3, **dadurch gekennzeichnet, dass** G für eine Gruppe - N(Ar³)₂ steht, wobei Ar³ bei jedem Auftreten gleich oder verschieden aus Benzol, Naphthalin, Fluoranthen, Biphenyl, Terphenyl, Fluoren, Spirobifluoren, cis- oder trans-Indenofluoren, Furan, Benzofuran, Isobenzofuran, Dibenzofuran, Thiophen, Benzothiophen, Isobenzothiophen, Dibenzothiophen, Carbazol, Benzocarbazolyl, Indolocarbazol und Indenocarbazolyl, die durch einen oder mehrere Reste R substituiert sein können, ausgewählt ist und wobei zwei Gruppen Ar³, die in einer Gruppe -N(Ar³)₂ vorliegen, über eine Einfachbindung oder eine zweiwertige Brücke verbunden sein können.

8. Verbindung nach Anspruch 7, **dadurch gekennzeichnet, dass** G für eine Gruppe -N(Ar³)₂ steht, wobei Ar³ bei jedem Auftreten gleich oder verschieden aus den Gruppen der folgenden Formeln (A-1) bis (A-48) ausgewählt ist, 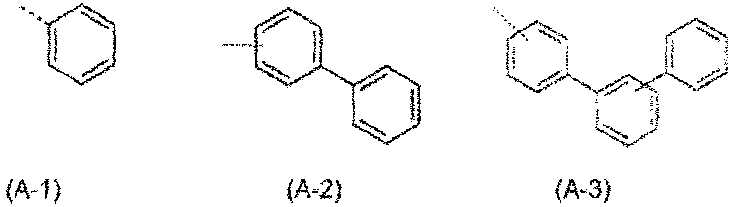 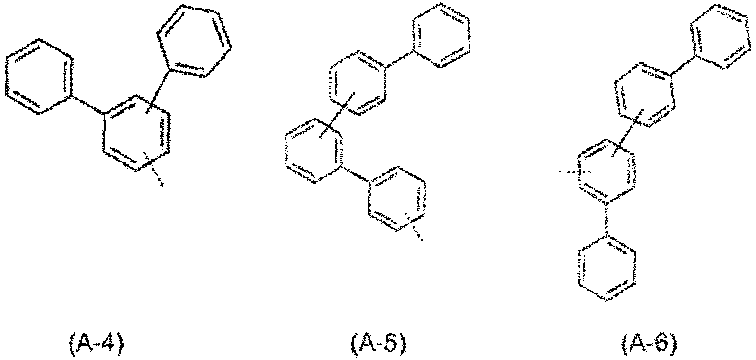 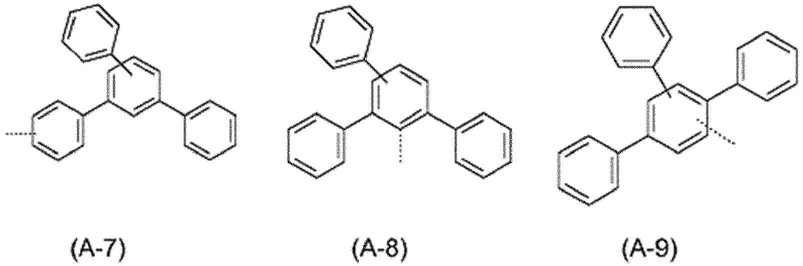 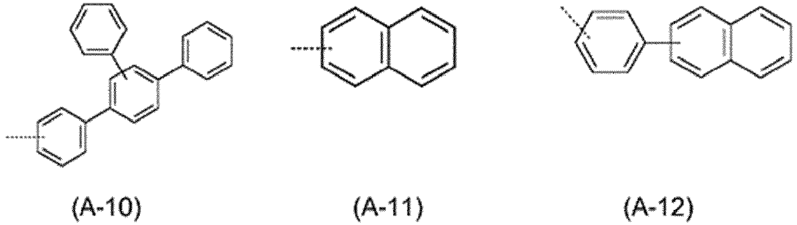 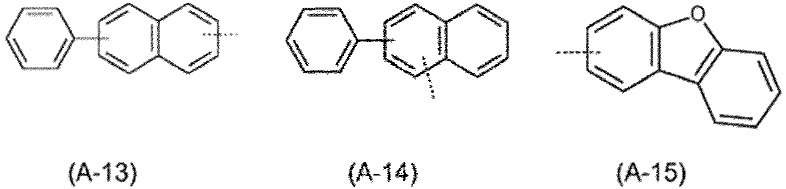 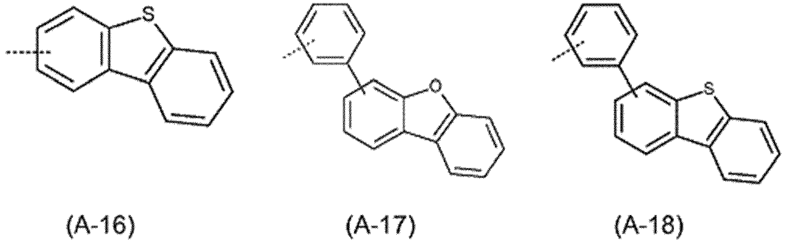 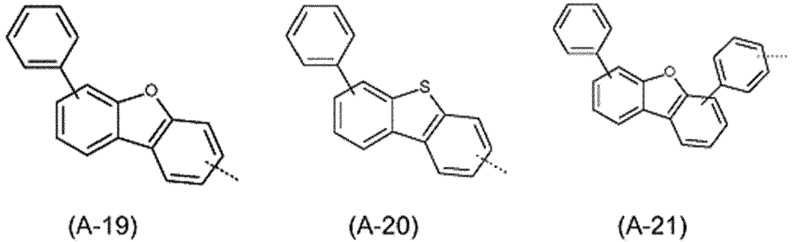 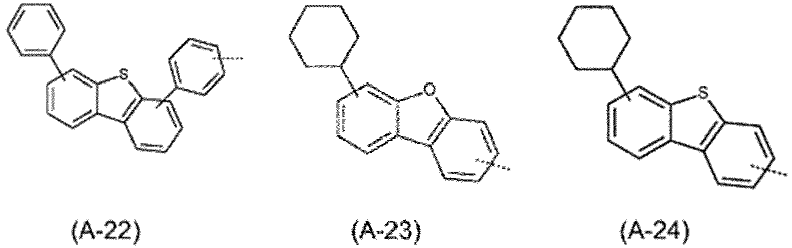 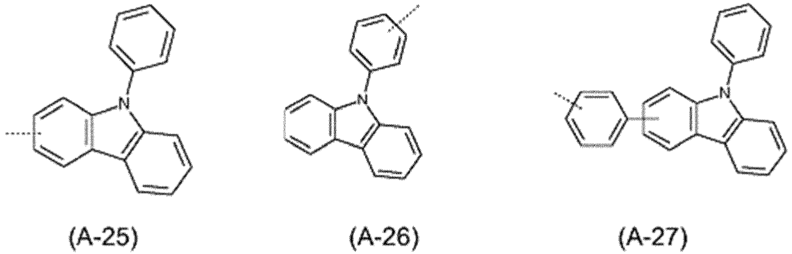 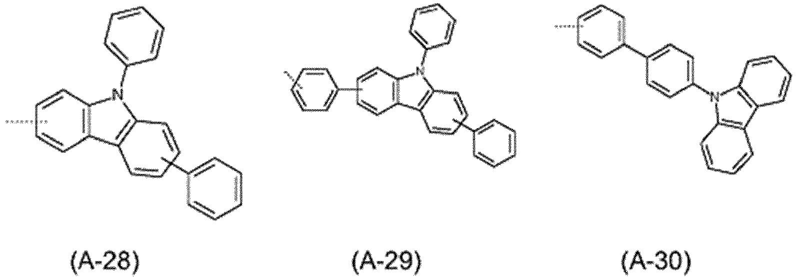 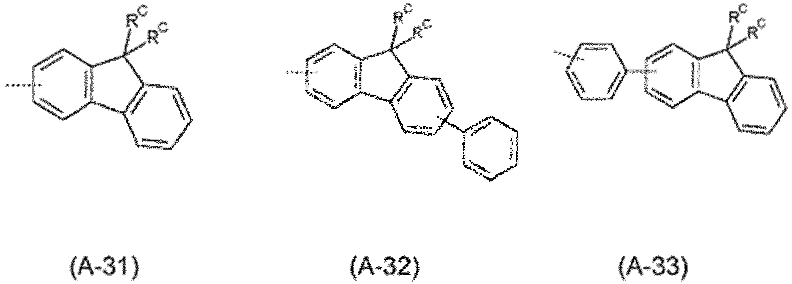 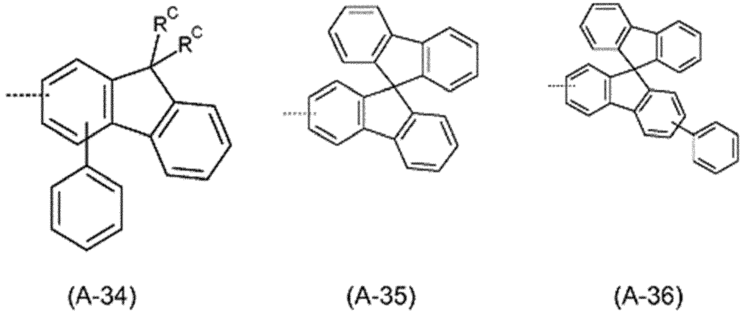 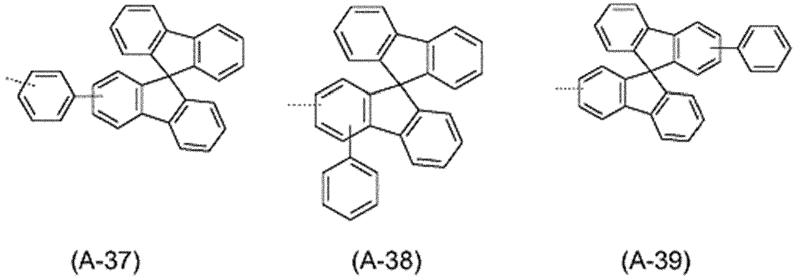 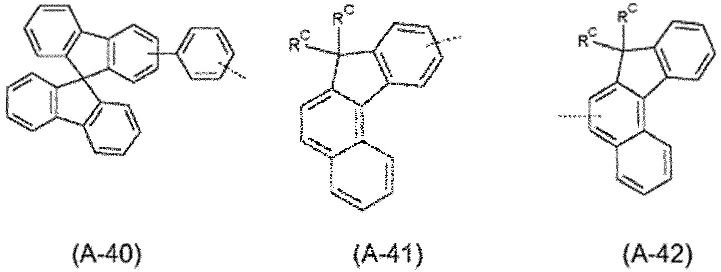 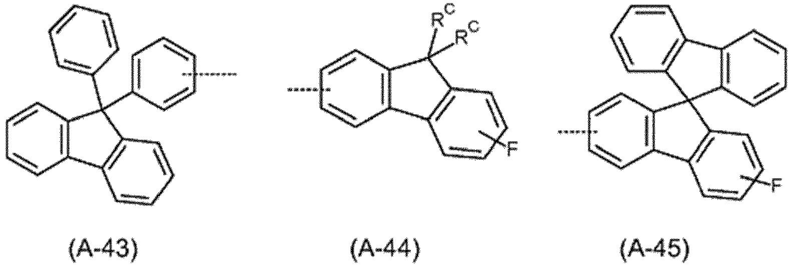 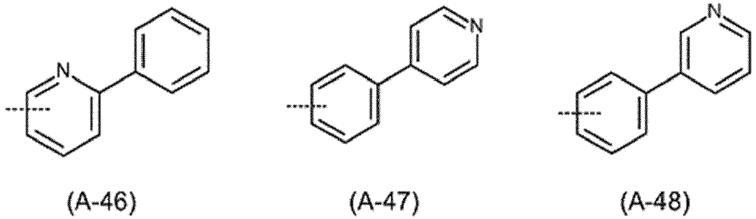
wobei die gestrichelten Bindungen die Bindungen an das Stickstoffatom anzeigen,
wobei die Gruppen der Formeln (A-1) bis (A-48) ferner an jeder freien Position durch eine Gruppe R wie in Anspruch 1 substituiert sein können und
wobei die Gruppen R^{C} in den Formeln (A-31) bis (A-34), (A-41), (A-42) und (A-44) die gleiche Bedeutung wie in Anspruch 5 haben.

9. Verbindung nach Anspruch 7, **dadurch gekennzeichnet, dass** G für eine Gruppe -N(Ar³)₂ steht, wobei die beiden Gruppen Ar³ über eine Einfachbindung oder eine zweiwertige Brücke verbunden sind und eine Gruppe bilden, die aus den Formeln (E-1) bis (E-24) ausgewählt ist, 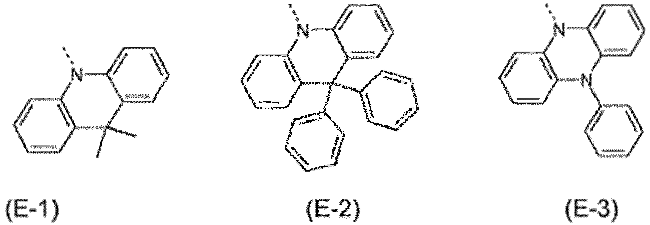 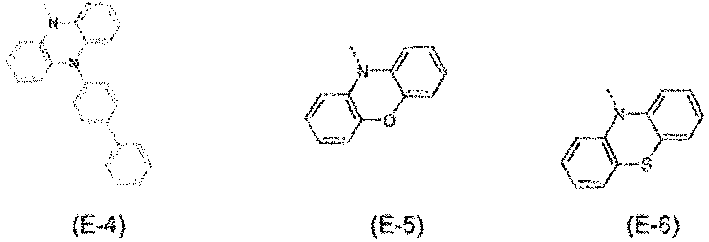 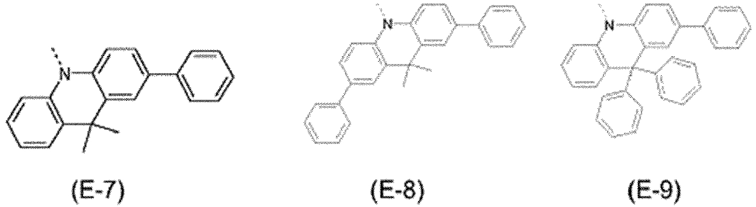 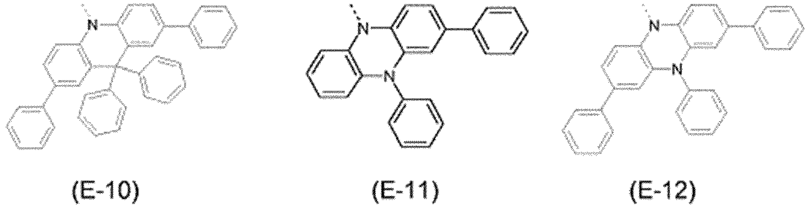 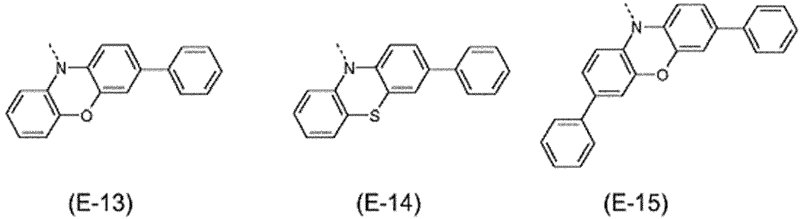 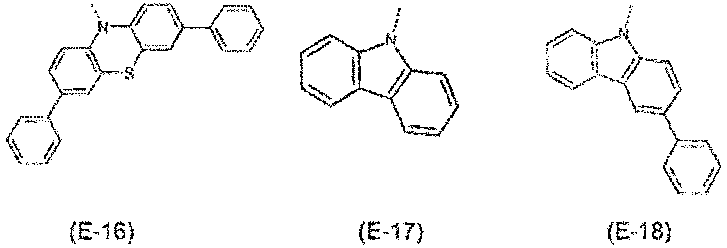 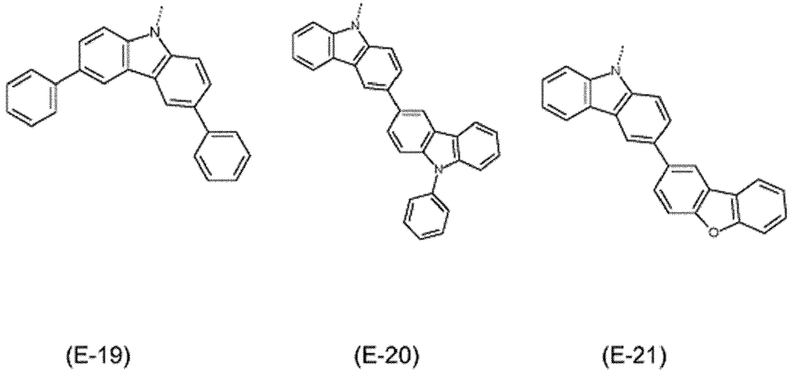 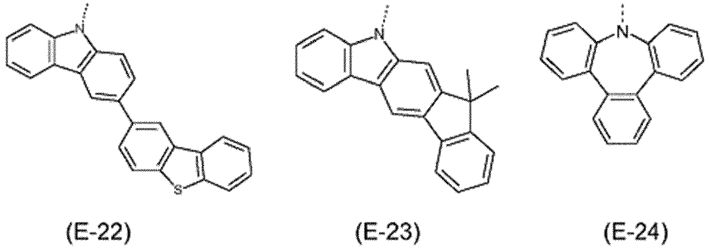
wobei die gestrichelte Bindung die Anbindung an die Gruppe L oder dann, wenn L eine Einfachbindung ist, an die in Formel (1) dargestellte Diazaphospholgruppierung anzeigt
und wobei die Gruppen (E-1) bis (E-24) an jeder freien Position durch eine Gruppe R gemäß Anspruch 1 substituiert sein können.

10. Verbindung nach einem oder mehreren der vorhergehenden Ansprüche, **dadurch gekennzeichnet, dass** die Verbindungen der Formel (1) mindestens eine Gruppe Ar, Ar², R oder R^{N} umfassen, die aus substituiertem oder unsubstituiertem Triazin, Pyrimidin, Pyrazin, Pyridazin, Pyridin, Imidazol, Pyrazol, Oxazol, Oxadiazol, Triazol, Thiazol, Thiadiazol, Benzimidazol, Chinolon, Isochinolin und Chinoxalin ausgewählt ist.

11. Verbindung nach einem oder mehreren der vorhergehenden Ansprüche, **dadurch gekennzeichnet, dass** die Verbindungen der Formel (1) mindestens eine Gruppe Ar, Ar², R oder R^{N} umfassen, die aus substituiertem oder unsubstituiertem Pyrrol, Furan, Thiophen, Benzothiophen, Benzofuran, Indol, Carbazol, Dibenzothiophen, Dibenzofuran und Azacarbazol ausgewählt ist.

12. Verfahren zur Herstellung einer Verbindung nach einem oder mehreren der Ansprüche 1 bis 11, bei dem eine aus einem aromatischen oder heteroaromatischen Ringsystem, einer Alkylaminogruppe oder einem Carbazol Derivat ausgewählte Gruppe über eine C-N- bzw. eine C-C-Kupplung mit dem an die Diazaphospholgruppierung eines Diazaphospholderivats ankondensierten Phenylring verknüpft wird.

13. Formulierung, umfassend mindestens eine Verbindung nach einem oder mehreren der Ansprüche 1 bis 11 und mindestens ein Lösungsmittel.

14. Elektronische Vorrichtung, umfassend mindestens eine Verbindung nach einem oder mehreren der Ansprüche 1 bis 11, ausgewählt aus der Gruppe bestehend aus organischen Elektrolumineszenzvorrichtungen, organischen integrierten Schaltungen, organischen Feldeffekttransistoren, organischen Dünnfilmtransistoren, organischen lichtemittierenden Transistoren, organischen Solarzellen, farbstoffsensibilisierten organischen Solarzellen, organischen optischen Detektoren, organischen Photorezeptoren, organischen Feld-Quench-Devices, lichtemittierenden elektrochemischen Zellen, organischen Laserdioden und "Organic Plasmon Emitting Devices".

15. Organische Elektrolumineszenzvorrichtung, **dadurch gekennzeichnet, dass** die Verbindung nach einem oder mehreren der Ansprüche 1 bis 11 als Matrixmaterial für phosphoreszierende oder fluoreszierende Emitter und/oder Elektronenblockiermaterial und/oder Exzitonenblockiermaterial und/oder Lochblockiermaterial und/oder Elektronentransportmaterial eingesetzt wird.

## Revendications

1. Composé selon la formule (1), 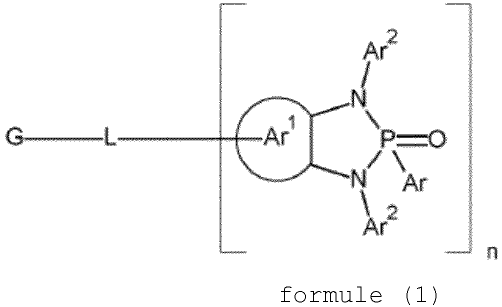 dans laquelle :
L est une simple liaison ou un système cyclique aromatique ou hétéroaromatique possédant 5 à 30 atomes de cycle aromatique, qui peut être substitué par un ou plusieurs radicaux R ;
G est un système cyclique aromatique ou hétéroaromatique possédant 5 à 60 atomes de cycle aromatique, qui peut être substitué par un ou plusieurs radicaux R ; ou G est un groupe -N(Ar³)₂ ;
Ar, Ar² sont, en chaque occurrence, de manière identique ou différente, un système cyclique aromatique ou hétéroaromatique possédant 5 à 60 atomes de cycle aromatique, qui peut être substitué par un ou plusieurs radicaux R ;
Ar¹ est un groupe aryle ou hétéroaryle possédant 6 à 10 atomes de cycle aromatique, qui peut être substitué par un ou plusieurs radicaux R ;
Ar³ est, en chaque occurrence, de manière identique ou différente, un système cyclique aromatique ou hétéroaromatique possédant 5 à 60 atomes de cycle aromatique, qui peut être substitué par un ou plusieurs radicaux R ; dans lequel deux groupes Ar³ présents dans un groupe -N(Ar³)₂ peuvent être reliés via une simple liaison ou un pont divalent ;
R est en chaque occurrence, de manière identique ou différente, H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, un groupe alkyle, alcoxy ou thioalcoxy à chaîne droite possédant 1 à 40 atomes de C ou un groupe alcényle ou alcynyle à chaîne droite possédant 2 à 40 atomes de C ou un groupe alkyle, alcényle, alcynyle, alcoxy ou thioalcoxy ramifié ou cyclique possédant 3 à 40 atomes de C, chacun desquels pouvant être substitué par un ou plusieurs radicaux R¹, dans lesquels un ou plusieurs groupes CH₂ préférablement non adjacents peuvent être remplacés par (R¹)C=C(R¹), C≡C, Si(R¹)₂, Ge(R¹)₂, Sn(R¹)₂, C=O, C=S, C=Se, P(=O)(R¹), SO, SO₂, N(R¹), O, S ou CON(R¹) et dans lesquels un ou plusieurs atomes de H peuvent être remplacés par D, F, Cl, Br, I, CN ou NO₂, ou un système cyclique aromatique ou hétéroaromatique possédant 5 à 60 atomes de cycle aromatique, qui peut en chaque cas être substitué par un ou plusieurs radicaux R¹, ou un groupe aryloxy ou hétéroaryloxy possédant 5 à 60 atomes de cycle aromatique, qui peut être substitué par un ou plusieurs radicaux R¹, dans lesquels éventuellement deux substituants adjacents R peuvent former un système cyclique monocyclique ou polycyclique, aliphatique, aromatique ou hétéroaromatique l'un avec l'autre ;
Ar⁴ est un système cyclique aromatique ou hétéroaromatique possédant 5 à 60 atomes de cycle aromatique, qui peut être substitué par un ou plusieurs radicaux R¹ ;
R¹ est en chaque occurrence, de manière identique ou différente, H, D, F, Cl, Br, I, CHO, N(R²)₂, C(=O)R², P(=O)(R²)₂, S(=O)R², S(=O)₂R², (R²)C=C(R²)₂, CN, NO₂, Si(R²)₃, B(OR²)₂, B(R²)₂, B(N(R²)₂)₂, OSO₂R², un groupe alkyle, alcoxy ou thioalcoxy à chaîne droite possédant 1 à 40 atomes de C ou un groupe alcényle ou alcynyle à chaîne droite possédant 2 à 40 atomes de C ou un groupe alkyle, alcényle, alcynyle, alcoxy ou thioalcoxy ramifié ou cyclique possédant 3 à 40 atomes de C, chacun desquels pouvant être substitué par un ou plusieurs radicaux R², dans lesquels un ou plusieurs groupes CH₂ préférablement non adjacents peuvent être remplacés par (R²)C=C(R²), C=C, Si(R²)₂, Ge(R²)₂, Sn(R²)₂, C=O, C=S, C=Se, P(=O)(R²), SO, SO₂, N(R²), O, S ou CON(R²) et dans lesquels un ou plusieurs atomes de H peuvent être remplacés par D, F, Cl, Br, I, CN ou NO₂, ou un système cyclique aromatique ou hétéroaromatique possédant 5 à 60 atomes de cycle aromatique, qui peut en chaque cas être substitué par un ou plusieurs radicaux R², ou un groupe aryloxy ou hétéroaryloxy possédant 5 à 60 atomes de cycle aromatique, qui peut être substitué par un ou plusieurs radicaux R², dans lesquels éventuellement deux substituants adjacents R¹ peuvent former un système cyclique monocyclique ou polycyclique, aliphatique, aromatique ou hétéroaromatique l'un avec l'autre ;
R² est en chaque occurrence, de manière identique ou différente, H, D, F, Cl, Br, I, CHO, CN, NO₂, un groupe alkyle, alcoxy ou thioalcoxy à chaîne droite possédant 1 à 20 atomes de C ou un groupe alcényle ou alcynyle à chaîne droite possédant 2 à 20 atomes de C ou un groupe alkyle, alcényle, alcynyle, alcoxy ou thioalcoxy ramifié ou cyclique possédant 3 à 20 atomes de C, ou un système cyclique aromatique ou hétéroaromatique possédant 5 à 30 atomes de cycle aromatique, ou un groupe aryloxy ou hétéroaryloxy possédant 5 à 30 atomes de cycle aromatique ; dans lesquels éventuellement deux substituants adjacents R² peuvent former un système cyclique monocyclique ou polycyclique, aliphatique, aromatique ou hétéroaromatique l'un avec l'autre ;
n est 1, 2 ou 3 ;
étant entendu que, si L est une simple liaison, alors G ne représente pas benzène.

2. Composé selon la revendication 1 choisi parmi les composés de formule (1-1), 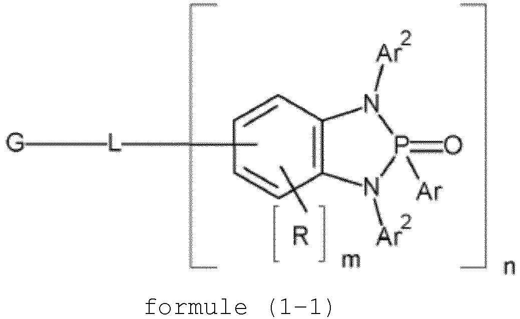 dans laquelle m est 0, 1, 2 ou 3 et dans laquelle les autres symboles et indices utilisés possèdent les mêmes significations que données dans la revendication 1.

3. Composé selon la revendication 1 ou 2, **caractérisé en ce que** L est une simple liaison ou un système cyclique aromatique ou hétéroaromatique choisi parmi benzène, naphtalène, biphényle, terphényle, fluorène, spirobifluorène, dibenzofuranne, dibenzothiophène, carbazole ou benzocarbazole, chacun desquels pouvant être substitué par un ou plusieurs radicaux R.

4. Composé selon l'une ou plusieurs des revendications précédentes, **caractérisé en ce que** G est un système cyclique aromatique ou hétéroaromatique choisi parmi naphtalène, anthracène, fluoranthène, biphényle, terphényle, fluorène, furanne, benzofuranne, dibenzofuranne, thiophène, benzothiophène, dibenzothiophène, carbazole, benzocarbazole, indolocarbazole, indénocarbazole, pyridine, quinoléine, isoquinoléine, pyridazine, benzopyridazine, benzimidazole, pyrimidine, benzopyrimidine, quinoxaline, pyrazine, azacarbazole, benzocarboline, phénanthroline, 1,3,5-triazine, 1,2,4-triazine et 1,2,3-triazine, chacun desquels pouvant être substitué par un ou plusieurs radicaux R.

5. Composé selon l'une ou plusieurs des revendications précédentes, **caractérisé en ce que** G et un système cyclique aromatique ou hétéroaromatique choisi parmi les groupes de formules (G-1) à (G-10), 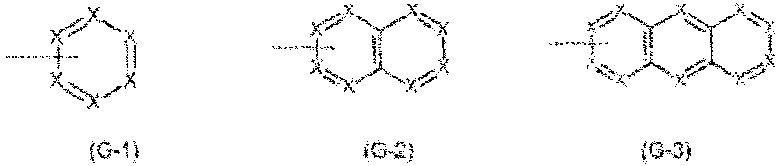 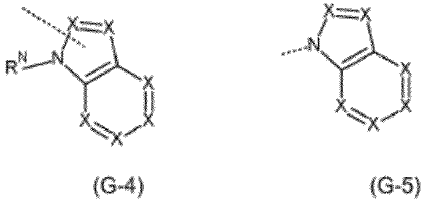 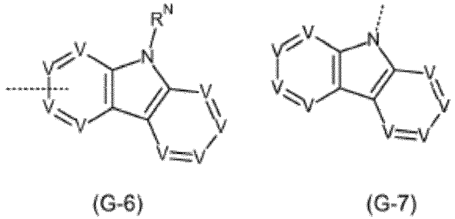 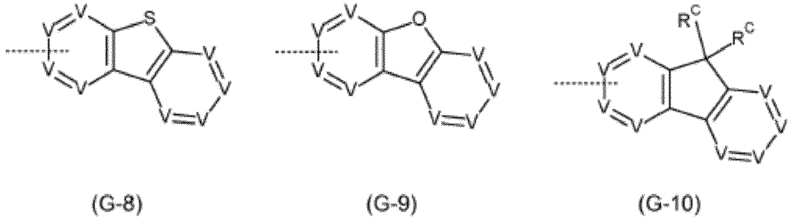
dans lesquelles la liaison en pointillés indique la liaison au groupe L ou, si L est une simple liaison, au groupe Ar¹ tel que représenté dans la formule (1) ; et dans lesquelles
X est en chaque occurrence, de manière identique ou différente, CR ou N ; dans lesquelles X est un atome de C lorsqu'un groupe L ou Ar¹ est lié à X, dans lesquelles il y a au maximum trois groupes X par cycle à 6 chaînons, qui représentent N, et deux groupes X par cycle à 5 chaînons, qui représentent N ; étant entendu que dans la formule (G-1), au moins un X représente N ;
V est en chaque occurrence, de manière identique ou différente, CR ou N ; V est un atome de C lorsqu'un groupe L ou Ar¹ est lié à V ; ou deux groupes V adjacents formant ensemble un groupe de formule (V-1) ou (V-2), 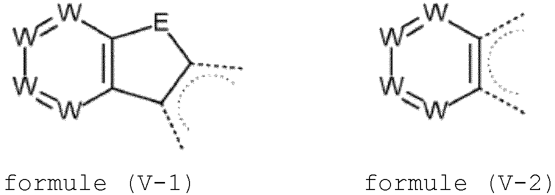
dans lesquelles les liaisons en pointillés dans les formules (V-1) et (V-2) indiquent la liaison aux structures représentées dans les formules (G-5) à (G-10) ;
W est en chaque occurrence, de manière identique ou différente, CR ou N ; dans lesquelles il y a au maximum trois groupes X par cycle à 6 chaînons, qui représentent N ;
E est O, S, N(R^{N}), C(R^{C})₂ ;
R^{N}, R^{C} sont en chaque occurrence, de manière identique ou différente, H, D, F, Cl, Br, I, CHO, N(Ar⁴)₂, C(=O)Ar⁴, P(=O)(Ar⁴)₂, S(=O)Ar⁴, S(=O)₂Ar⁴, (R)C=C(R)Ar⁴, CN, NO₂, Si(R¹)₃, B(OR¹)₂, B(R¹)₂, B(N(R¹)₂)₂, OSO₂R¹, un groupe alkyle, alcoxy ou thioalcoxy à chaîne droite possédant 1 à 40 atomes de C ou un groupe alcényle ou alcynyle à chaîne droite possédant 2 à 40 atomes de C ou un groupe alkyle, alcényle, alcynyle, alcoxy ou thioalcoxy ramifié ou cyclique possédant 3 à 40 atomes de C, chacun desquels pouvant être substitué par un ou plusieurs radicaux R¹, dans lesquels un ou plusieurs groupes CH₂ préférablement non adjacents peuvent être remplacés par (R¹)C=C(R¹), C≡C, Si(R¹)₂, Ge(R¹)₂, Sn(R¹)₂, C=O, C=S, C=Se, P(=O)(R¹), SO, SO₂, N(R¹), O, S ou CON(R¹) et dans lesquels un ou plusieurs atomes de H peuvent être remplacés par D, F, Cl, Br, I, CN ou NO₂, ou un système cyclique aromatique ou hétéroaromatique possédant 5 à 60 atomes de cycle aromatique, qui peut en chaque cas être substitué par un ou plusieurs radicaux R¹, ou un groupe aryloxy ou hétéroaryloxy possédant 5 à 60 atomes de cycle aromatique, qui peut être substitué par un ou plusieurs radicaux R¹, dans lesquels éventuellement deux substituants adjacents R^{C} peuvent former un système cyclique monocyclique ou polycyclique, aliphatique, aromatique ou hétéroaromatique l'un avec l'autre.

6. Composé selon l'une ou plusieurs des revendications précédentes, **caractérisé en ce que** G est un système cyclique aromatique ou hétéroaromatique choisi parmi les groupes de formules (G-11) à (G-64), 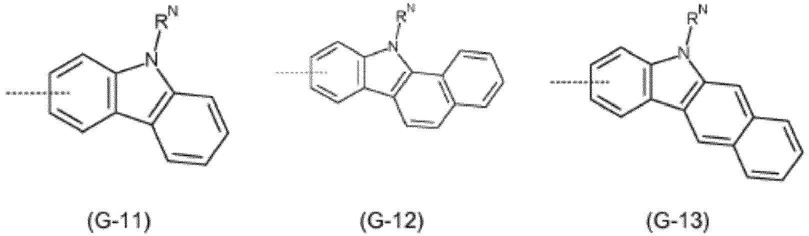 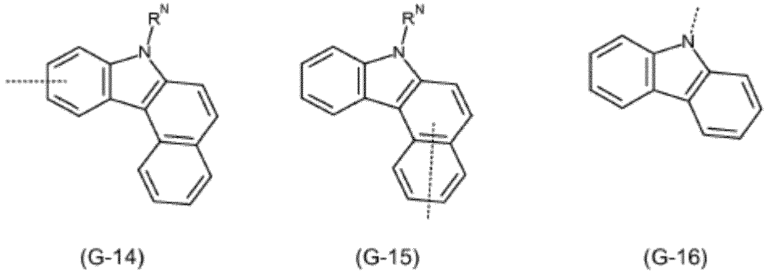 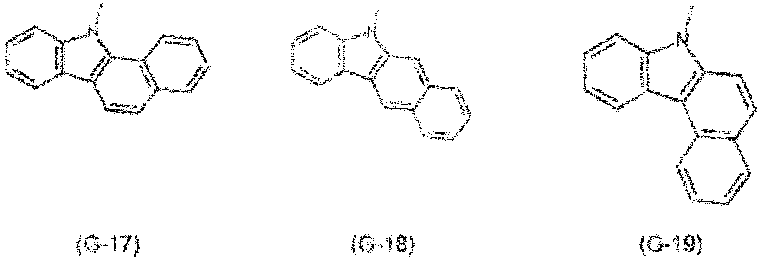 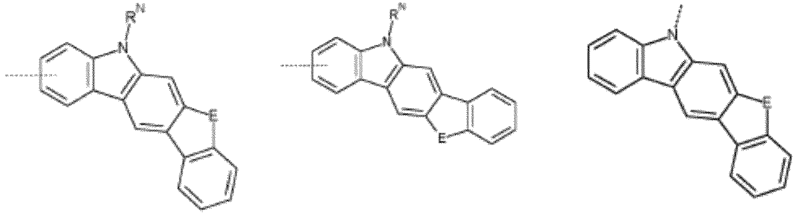 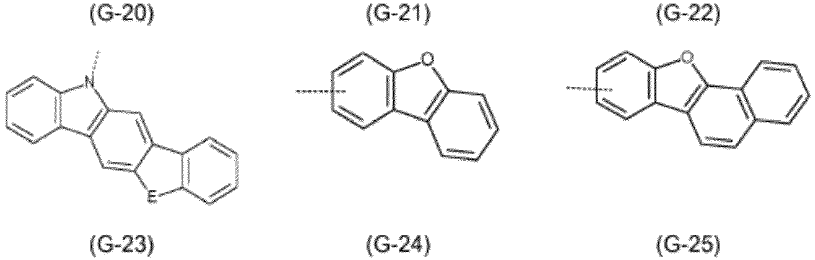 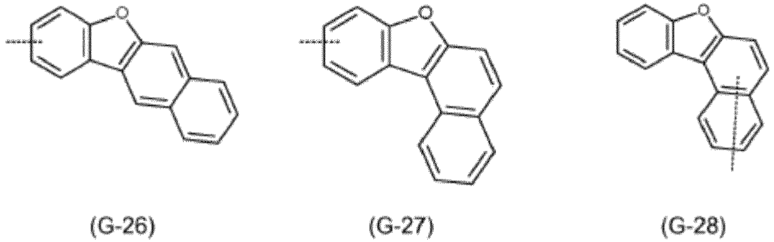 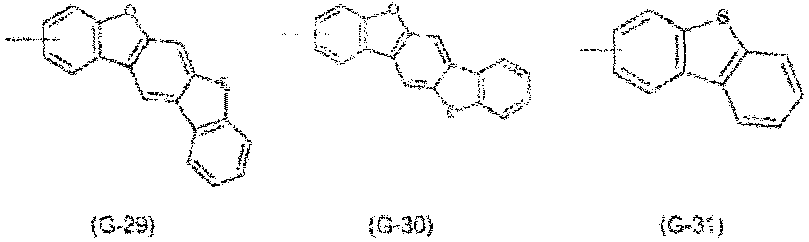 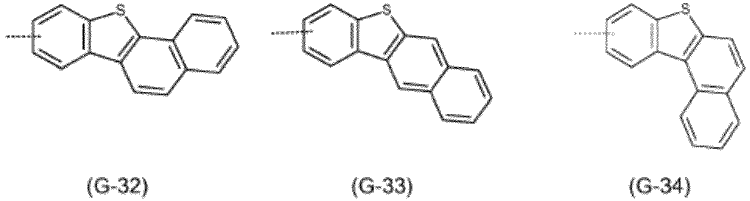 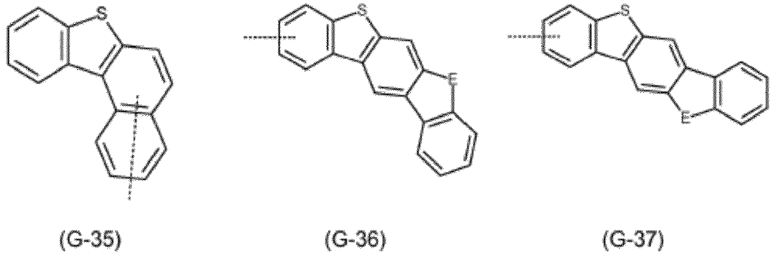 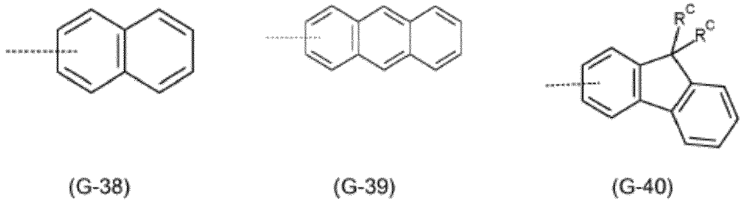 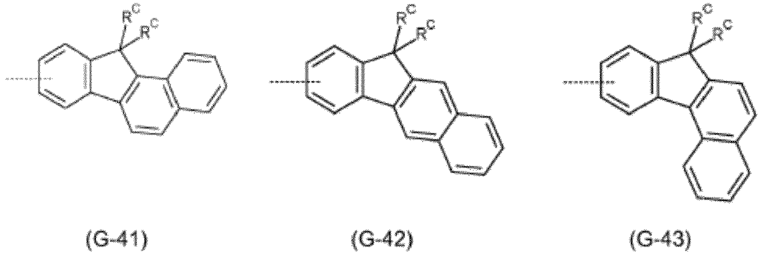 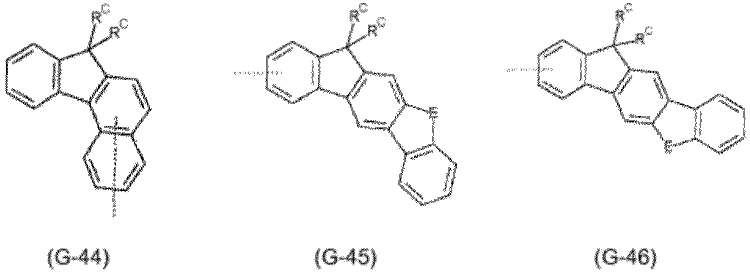 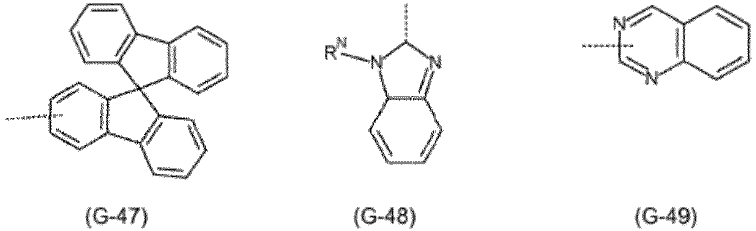 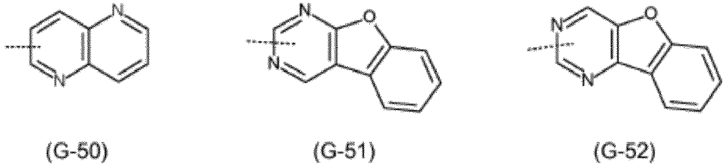 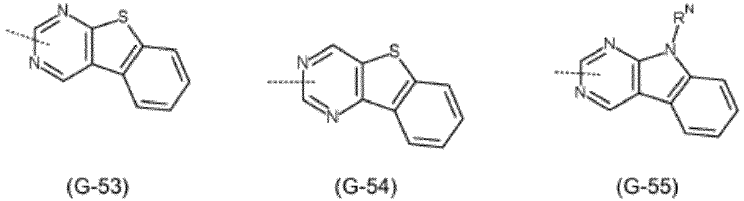 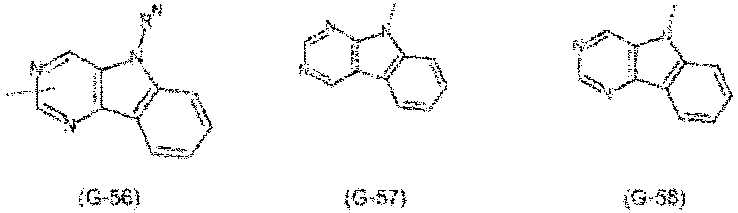 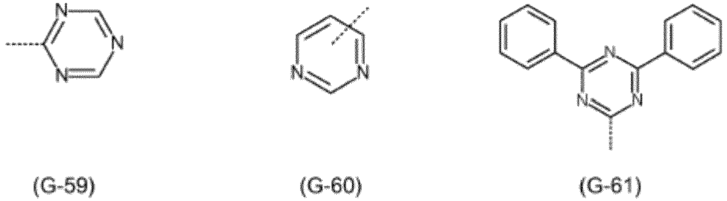 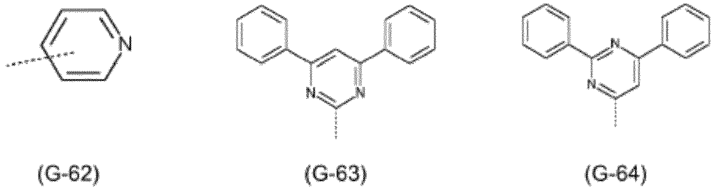 dans lesquelles la liaison en pointillés indique la liaison au groupe L, si L est une simple liaison, au fragment diazaphosphole représentée dans la formule (1) ; les symboles R^{C}, R^{N} et E possèdent la même signification que dans la revendication 5 ; et les groupes de formules (G-11) à (G-64) sont éventuellement substitués par un ou plusieurs radicaux R au niveau de quelconques positions libres, dans lesquelles R possède la même signification que dans la revendication 1.

7. Composé selon l'une ou plusieurs des revendications 1 à 3, **caractérisé en ce que** G représente un groupe -N(Ar³)₂, dans lequel Ar³ est choisi en chaque occurrence, de manière identique ou différente, parmi benzène, naphtalène, fluoranthène, biphényle, terphényle, fluorène, spirobifluorène, 6-indénofluorène ou trans-indénofluorène, furanne, benzofuranne, isobenzofuranne, dibenzofuranne, thiophène, benzothiophène, isobenzothiophène, dibenzothiophène, carbazole, benzocarbazole, indolocarbazole et indénocarbazole, qui peut être substitué par un ou plusieurs radicaux R, et deux groupes Ar³ présents dans un groupe -N(Ar³)₂ pouvant être reliés via une simple liaison ou un pont divalent.

8. Composé selon la revendication 7, **caractérisé en ce que** G représente un groupe -N(Ar³)₂, dans lequel Ar³ est choisi en chaque occurrence, de manière identique ou différente, parmi les groupes des formules suivantes (A-1) à (A-48), 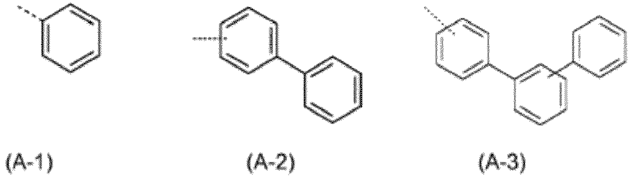 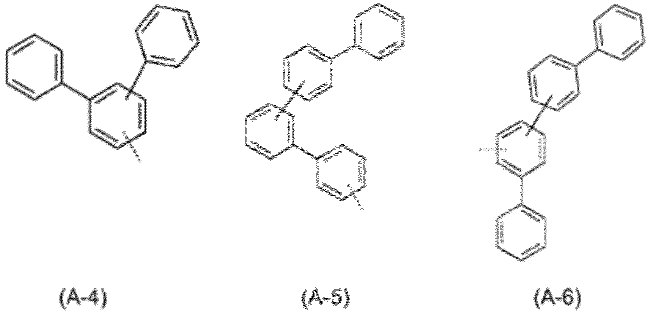 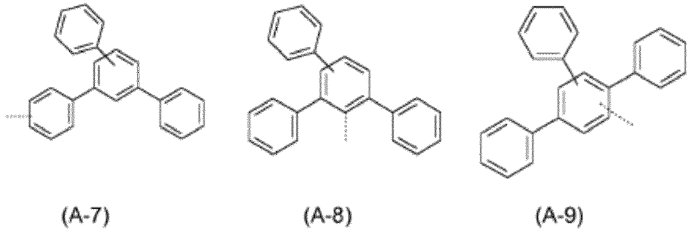 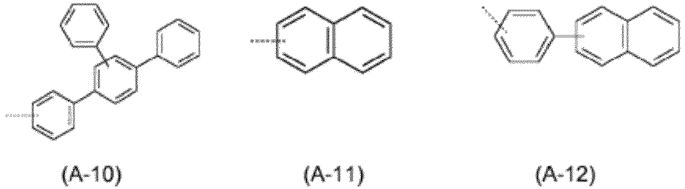 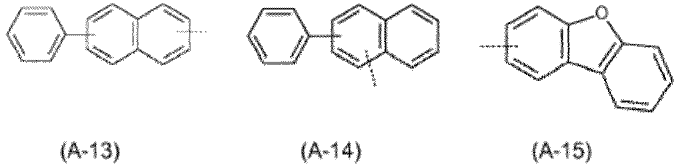 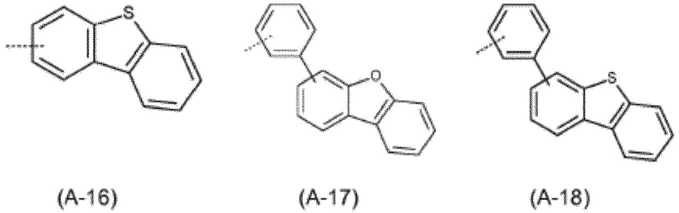 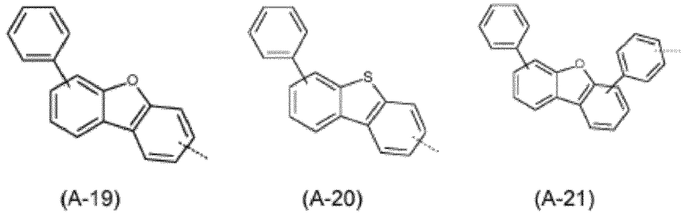 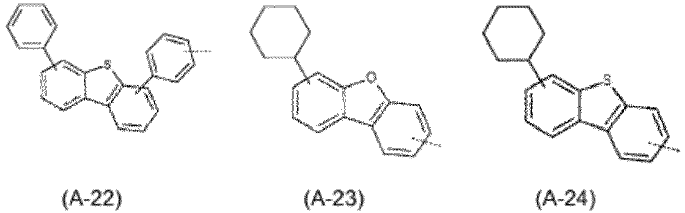 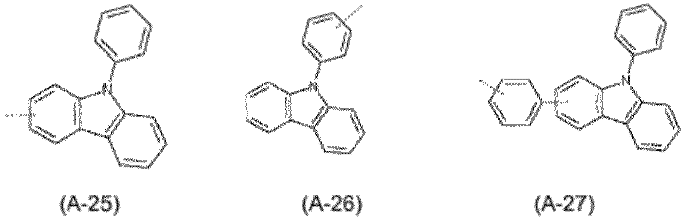 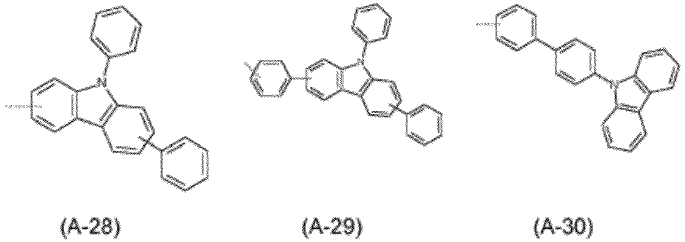 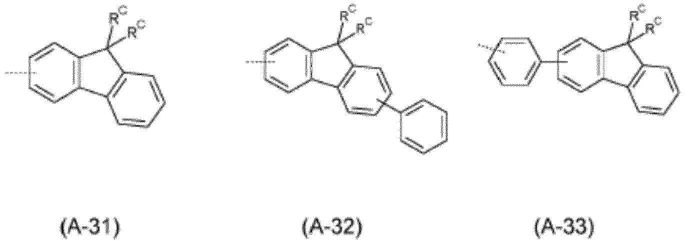 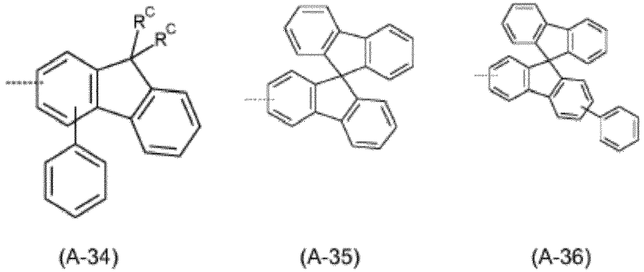 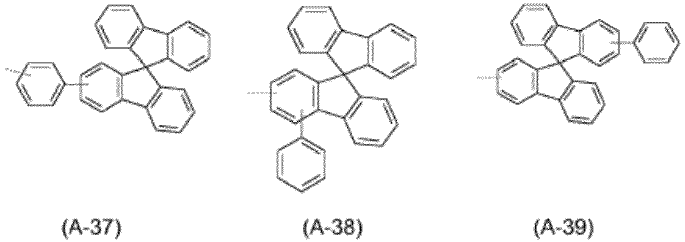 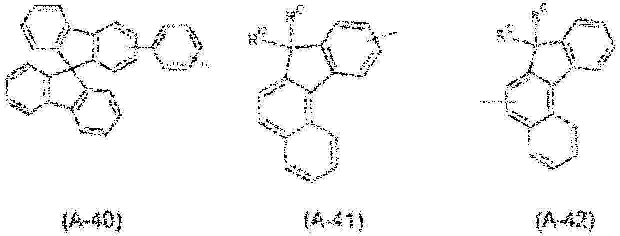 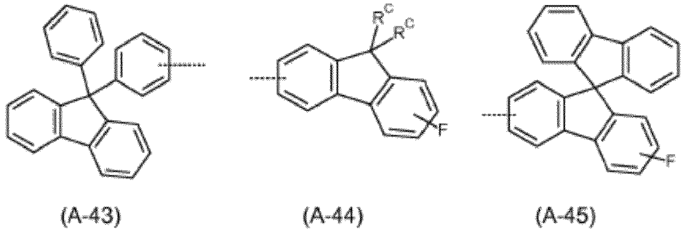 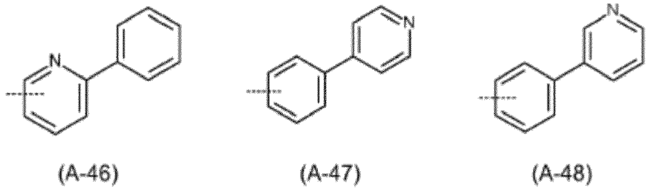
dans lesquelles les liaisons en pointillés indiquent les liaisons à l'atome d'azote,
dans lesquelles les groupes de formules (A-1) à (A-48) peuvent être substitués davantage au niveau de chaque position libre par un groupe R tel que dans la revendication 1 et
dans lesquelles les groupes R^{C}, dans les formules (A-31) à (A-34), (A-41), (A-42) et (A-44) possèdent la même signification que dans la revendication 5.

9. Composé selon la revendication 7, **caractérisé en ce que** G représente un groupe -N(Ar³)₂, dans lequel les deux groupes Ar³ sont reliés via une simple liaison ou un pont divalent et forment un groupe choisi parmi les formules (E-1) à (E-24), 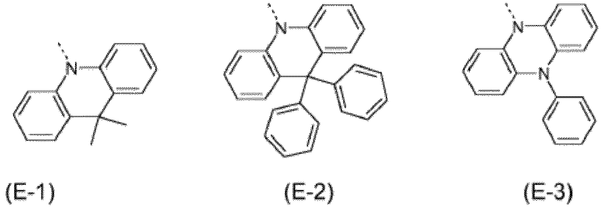 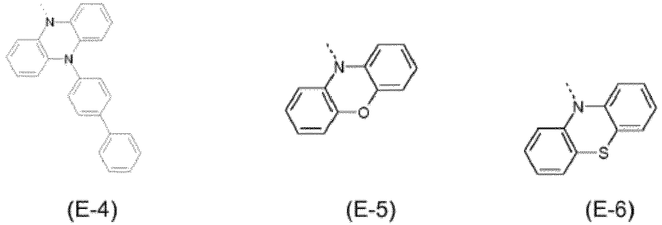 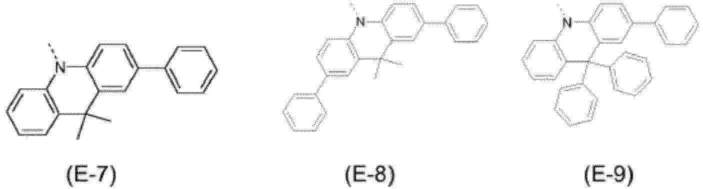 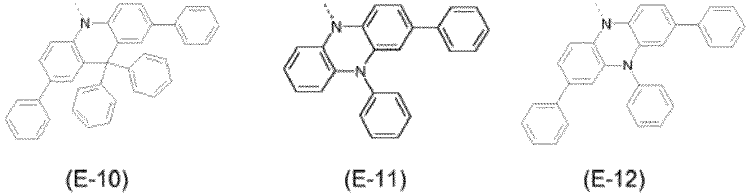 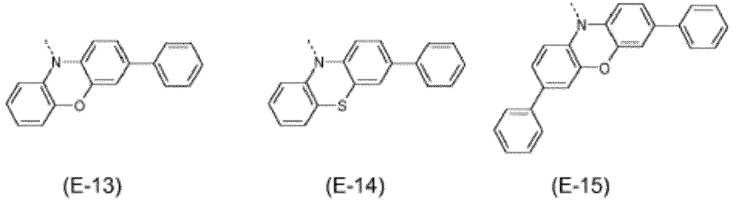 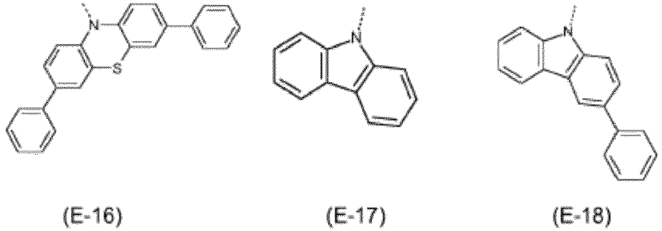 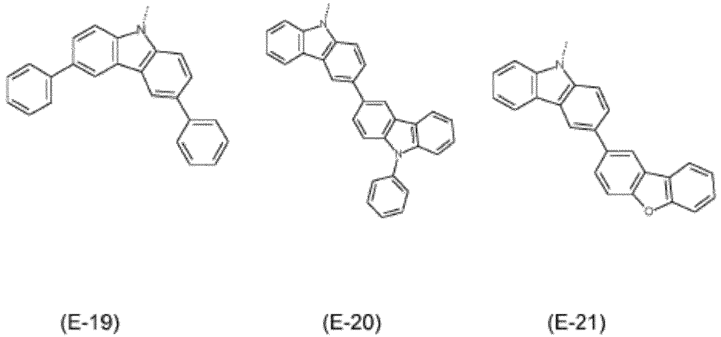 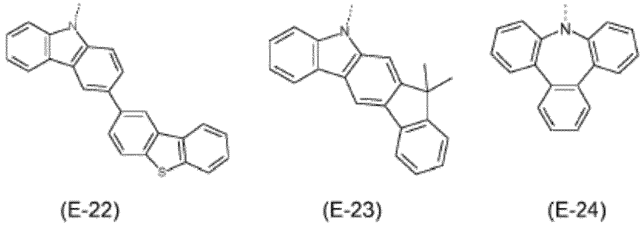 dans lesquelles la liaison en pointillés indique la liaison au groupe L ou, si L est une simple liaison, au fragment diazaphosphole représenté dans la formule (1) ;
et dans lesquelles les groupes (E-1) à (E-24) peuvent être substitués au niveau de chaque position libre par un groupe R tel que défini dans la revendication 1.

10. Composé selon l'une ou plusieurs des revendications précédentes, **caractérisé en ce que** les composés de formule (1) comprennent au moins un groupe Ar, Ar², R ou R^{N}, qui est choisi parmi triazine, pyrimidine, pyrazine, pyridazine, pyridine, imidazole, pyrazole, oxazole, oxadiazole, triazole, thiazole, thiadiazole, benzimidazole, quinolone, isoquinoléine et quinoxaline substitué(e)s ou non substitué(e)s.

11. Composé selon l'une ou plusieurs des revendications 1 à 9, **caractérisé en ce que** les composés de formule (1) comprennent au moins un groupe Ar, Ar², R ou R^{N}, qui est choisi parmi pyrrole, furanne, thiophène, benzothiophène, benzofuranne, indole, carbazole, dibenzothiophène, dibenzofuranne et azacarbazole substitués ou non substitués.

12. Procédé pour la préparation d'un composé selon l'une ou plusieurs des revendications 1 à 11, dans lequel un groupe choisi parmi un système cyclique aromatique ou hétéroaromatique, un groupe arylamino et un dérivé de carbazole, est relié au cycle phényle condensé sur le fragment diazaphosphole d'un dérivé de diazaphosphole via un couplage C-N ou un couplage C-C.

13. Formulation comprenant au moins un composé selon l'une ou plusieurs des revendications 1 à 11, et au moins un solvant.

14. Dispositif électronique comprenant au moins un composé selon l'une ou plusieurs des revendications 1 à 11, choisi dans le groupe constitué par des dispositifs organiques électroluminescents, des circuits intégrés organiques, des transistors organiques à effet de champ, des transistors organiques à film mince, des transistors organiques luminescents, des cellules solaires organiques, des cellules solaires organiques sensibilisées par un colorant, des détecteurs optiques organiques, des photorécepteurs organiques, des dispositifs organiques d'extinction de champ, des cellules électrochimiques luminescentes, des diodes laser organiques et des dispositifs organiques d'émission de plasmon.

15. Dispositif organique électroluminescent, **caractérisé en ce que** le composé selon l'une ou plusieurs des revendications 1 à 11 est employé en tant que l'un ou plusieurs parmi un matériau de matrice pour des émetteurs phosphorescents ou fluorescents, un matériau de blocage d'électrons ou de blocage d'excitons, un matériau de blocage de trous, et un matériau de transport d'électrons.
